# EUROPEAN PATENT APPLICATION

(11) **EP 4 835 739 A2**
(43) Date of publication of application: **04.11.2026**
(21) Application number: 26204976.0
(22) Date of filing: 14.04.2022
(51) Int. Cl.: G06N 3/08

(54) **DECODER, ENCODER, CONTROLLER, METHOD AND COMPUTER PROGRAM FOR UPDATING NEURAL NETWORK PARAMETERS USING NODE INFORMATION**

(30) Priority: 16.04.2021 EP 21169029
(62) Document number(s) of the earlier application(s) in accordance with Art. 76 EPC: 22723377.2 / 4 324 097
(71) Applicant: Fraunhofer-Gesellschaft zur Förderung der angewandten Forschung e.V., 80686 München (DE)
(72) Inventor: KIRCHHOFFER, Heiner, 10587 Berlin (DE); MULLER, Karsten, 10587 Berlin (DE); HAASE, Paul, 10587 Berlin (DE); BECKING, Daniel, 10587 Berlin (DE); TECH, Gerhard, 10587 Berlin (DE); SAMEK, Wojciech, 10587 Berlin (DE); SCHWARZ, Heiko, 10587 Berlin (DE); MARPE, Detlev, 10587 Berlin (DE); WIEGAND, Thomas, 10587 Berlin (DE)
(74) Representative: Creutz, Andreas

(57) **Abstract**

Embodiments according to the invention comprise a decoder for decoding parameters of a neural network, wherein the decoder is configured to obtain a plurality of neural network parameters of the neural network on the basis of an encoded bitstream. Furthermore, the decoder is configured to obtain, e.g. to receive; e.g. to extract from an encoded bitstream, a node information describing a node of a parameter update tree, wherein the node information comprises a parent node identifier, which is, for example, a unique parent node identifier, for example an integer number, a string, and/or a cryptographic hash, and wherein the node information comprises a parameter update information, e.g. one or more update instructions, for example a difference signal between initial neural network parameters and a newer version thereof, e.g. corresponding to a child node of the update tree.

Moreover, the decoder is configured to derive one or more neural network parameters using parameter information of a parent node (the parameter information comprising, for example a node information of the parent node, the node information for example comprising a parameter update information and a parent node identifier of the parent node, e.g. for a recursive reconstruction or recursive determination or recursive calculation or recursive derivation of the one or more neural network parameters and/or for example comprising a node parameter of the parent node, e.g. neural network parameters associated with the parent node, e.g. neural network parameters implicitly defined by the node information of the parent node) identified by the parent node identifier and using the parameter update information, which may, for example, be included in the node information.

## Description

### Technical Field

Embodiments according to the invention are related to decoders, encoders, controllers, methods and computer programs for updating neural network parameters using node information.

Further embodiments according to the invention are related to efficient signaling of neural network updates in distributed scenarios.

### Background of the Invention

Neural networks, NN, e.g. neural nets, are used in a wide variety of application areas. In order to provide a good performance, for example complex and computationally expensive, training techniques have been developed. In order to carry out such a training process on a dedicated training device neural network parameters may have to be transmitted, for example, from an end user device to the training device and vice versa. Furthermore, efficient neural network parameter representation and parameter transmission techniques may be even more important in distributed learning scenarios in which a plurality of devices may train a neural network and updated parameters of respective training processes may be aggregated using a central server.

Therefore, it is desired to get a concept which allows an efficient representation and transmission of neural network parameters for learning or updating processes.

This is achieved by the subject matter of the independent claims of the present application.

Further embodiments according to the invention are defined by the subject matter of the dependent claims of the present application.

### Summary of the Invention

Embodiments according to the invention comprise a decoder for decoding parameters of a neural network, wherein the decoder is configured to obtain a plurality of neural network parameters of the neural network on the basis of an encoded bitstream. Furthermore, the decoder is configured to obtain, e.g. to receive; e.g. to extract from an encoded bitstream, a node information describing a node of a parameter update tree, wherein the node information comprises a parent node identifier, which is, for example, a unique parent node identifier, for example an integer number, a string, and/or a cryptographic hash, and wherein the node information comprises a parameter update information, e.g. one or more update instructions, for example a difference signal between initial neural network parameters and a newer version thereof, e.g. corresponding to a child node of the update tree.

Moreover, the decoder is configured to derive one or more neural network parameters using parameter information of a parent node (the parameter information comprising, for example, a node information of the parent node, the node information for example comprising a parameter update information and a parent node identifier of the parent node, e.g. for a recursive reconstruction or recursive determination or recursive calculation or recursive derivation of the one or more neural network parameters and/or for example comprising a node parameter of the parent node, e.g. neural network parameters associated with the parent node, e.g. neural network parameters implicitly defined by the node information of the parent node) identified by the parent node identifier and using the parameter update information, which may, for example, be included in the node information.

Embodiments according to the invention are based on the main idea to provide an efficient representation of neural network parameters based on a parameter update tree.

The inventors recognized that for updating or alternating neural networks, it may not be necessary to transmit/receive all parameters of a neural network. Instead, only an update information, or in other words a (neural network) parameter update information may be encoded/decoded and transmitted/received. In order to make use of such a for example differential information or for example difference information, an information about a set of reference parameters to be adapted using the update information, e.g. comprising change values, may be provided. The inventors recognized that such an information may be represented using a node information, the node information comprising the parameter update information and a parent node identifier, which may, for example, act as a pointer to the set of reference parameters to be adjusted.

As an example, an inventive decoder may comprise an information about a parameter update tree, the parameter update tree comprising one or more nodes that are in a, for example, hierarchical, order.

In order to determine one or more neural network parameters of an updated or trained neural network the decoder may hence receive the beforementioned node information or may extract the node information from an encoded bitstream, provided to the decoder.

Using the parent node identifier, the decoder may select a specific node in the parameter update tree.

As an example, neural network parameters associated with the selected node, e.g. associated with a specific version of the neural network represented by the node, may be stored within the node. Hence, the decoder may adapt or adjust or update these stored neural network parameters using the parameter update information in order to determine updated neural network parameters, and for example hence an updated version of the neural network represented by the selected node. As an example, a new node may be added to the update tree, using the parent node identifier and the parameter update information of the received or extracted node information. The new node may, for example, comprise or represent the updated neural network parameters.

As another example, the selected node may comprise an own parent node identifier and an own parameter update information. Hence, the decoder may recursively derive predecessor nodes of the selected node, for example until a node, e.g. a root node or a source node, is reached for which neural network parameters are available (e.g. instead of a pointer to a reference information and update values). Hence, these neural network parameters may be updated based on the parameter update information of the derived nodes, the selected node and finally the parameter update information of the received or extracted node information.

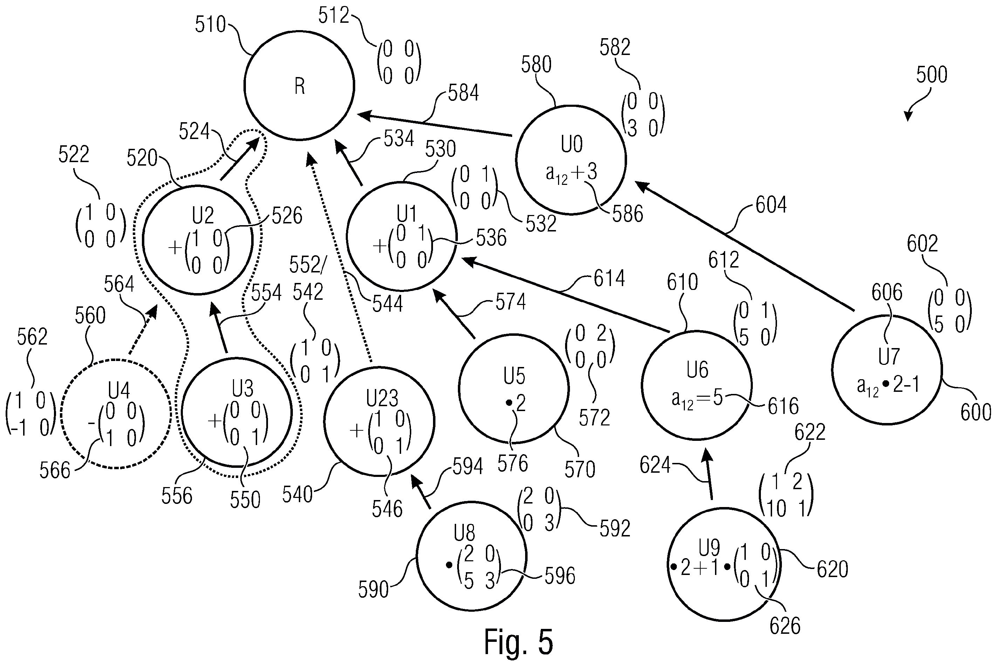

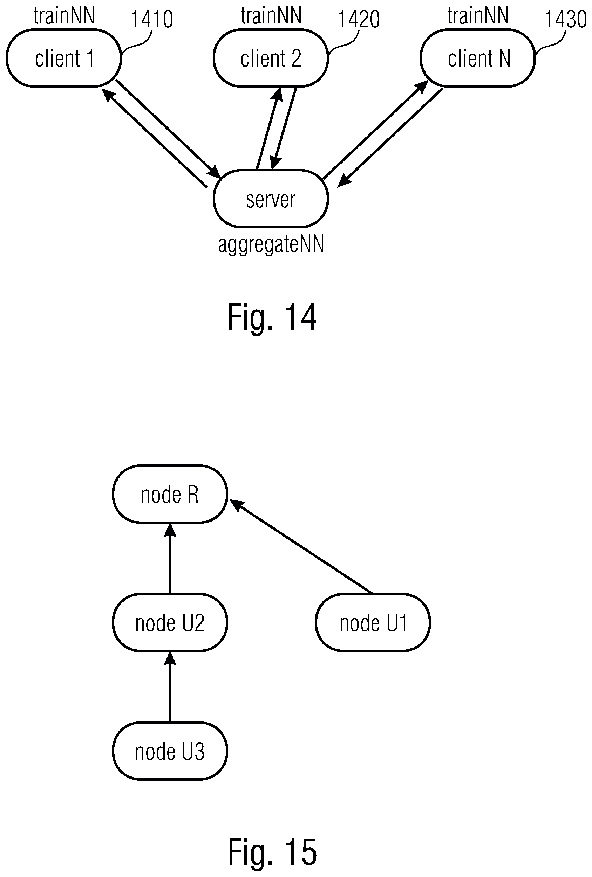

In the following further embodiments according to the invention are discussed. Optional examples and explanations with regard to specific nodes may be related to two arbitrary nodes, e.g. nodes U2 and U3, or to the nodes as shown in Fig. 5 and/or Fig. 15, which will be explained in detail later.

According to further embodiments of the invention, the decoder is configured to modify one or more neural network parameters, e.g. node parameters, defined by the parent node, (e.g. implicitly or recursively defined by an parameter update information and a parent node information of the parent node) which is identified by the parent node identifier, using the parameter update information, which may comprise instructions on how to update a parameter associated with the parent node.

One or more neural network parameters, determined by the parent node identifier, e.g. recursively, may, for example, be modified using a differential information provided in the parameter update information. Therefore, the parameter update information may, for example, comprise update values, e.g. delta-values and update instructions, in simple words instructions on what to do with the update values, e.g. add, subtract, multiply, divide by etc.. The inventors recognized that such an inventive modification may allow an efficient determination of updated neural network parameters.

According to further embodiments of the invention, the decoder is configured to set up a parameter update tree, wherein a plurality of child nodes comprising different parameter update information (and optionally comprising an identical parent node identifier) are associated with a common parent node, e.g. a root node R, wherein, for example each node of the tree may represent a version of the neural network parameters associated with a root node of the tree.

As an example, the decoder may not only be configured to obtain the node information describing a node of a parameter update tree, but as well to set up a respective update tree. Hence, the decoder may manipulate or update, e.g. adjust the update tree based on received node information. As an example, a plurality of decoders in a plurality of different devices may update respective parameter update trees, such that only the node information, e.g. a differential information and a reference information, may have to be transmitted in between them in order to update their respective, e.g. common, update trees in order to obtain updated neural network parameters.

According to further embodiments of the invention, the decoder is configured to obtain one or more neural network parameters associated with a currently considered node using the parameter update information associated with the currently considered node, e.g. node U3, using a parameter information, e.g. a tree parameter, for example neural network parameters of a base model, e.g. default or pre-trained or initial neural network parameters of a neural network, associated with a root node, e.g. node R, and using parameter update information, e.g. update rules, associated with one or more intermediated nodes (for example, intermediate nodes), e.g. node U2, which are between the root node, e.g. node R, and the currently considered node, e.g. node U3, in the update tree.

Hence, a parameter update may be performed recursively, via intermediate nodes, the intermediate nodes for example associated with intermediate neural network parameters, for example, from preceding training sessions based on which the updated neural network parameters are obtained. The intermediate nodes may, for example, be arranged along one path in a parameter update tree from a root node to a currently considered node.

According to further embodiments of the invention, the decoder is configured to traverse the parameter update tree from a root node, e.g. node R, to a currently considered node, e.g. node U3, and the decoder is configured to apply update instructions of visited nodes (e.g. update parameters of nodes U2 and U3; e.g. of nodes between the root node and the currently considered node and of the currently considered node; e.g. of all visited nodes) to one or more initial neural network parameters (e.g. one or more "tree parameters", which may, for example, be associated with a root node, or with may, for example, be defined by a root node, or which may, for example, be defined by a base mode (wherein the base mode, may, for example, be associated with the parameter update tree)), in order to obtain one or more neural network parameters associated with the currently considered node.

The inventors recognized that based on a set of neural network parameters of a root node, starting from said root node, an updated version of the neural network parameters may be provided by applying respective child node parameter update information of a path of the parameter update tree leading to the currently considered node. The inventors recognized that this may allow for an efficient coding of neural network parameters, since in some cases many neural network parameters may not change in between different updated versions of a neural network, hence only storing and applying a limited amount of differential information in order to modify a reference set, e.g. a basic set or an initial set of neural network parameters, e.g. of the root node.

According to further embodiments of the invention, the decoder is configured to aggregate a plurality of consecutive nodes of the parameter update tree (e.g. aggregating nodes U2 and U3 to a new single node U23, wherein, for example, aggregating the plurality of consecutive nodes may comprise determining an update rule or update instruction that is equivalent, or at least approximately equivalent, to the consecutively performed update rules or update instructions of the aggregated nodes). Alternatively or in addition, the decoder is configured to aggregate one or more consecutive nodes of the parameter update tree and the parameter update information.

The inventors recognized that this way, in simple words, a shortcut, to a specific set of neural network parameters represented by the aggregated node may be provided. Hence, it may not be necessary to modify neural network parameters of a parent node with a plurality of parameter update information of consecutive child nodes, but just one aggregated parameter update information.

According to further embodiments of the invention, the decoder is configured to update the parameter update tree based on the node information, e.g. by adding a child node associated with the parameter update information of the node information to a node of the parameter update tree that is associated with the parent node identifier of the node information.

The inventors recognized that this way, information from a plurality of neural network trainings may be incorporated in a respective parameter update tree, and furthermore, as another example, this way, a plurality of parameter update trees can be kept up to date in order to allow for an efficient communication in between devices comprising the update trees, in order to prevent situations, in which parent node identifiers may reference a node that is not known to a respective update tree.

According to further embodiments of the invention, the decoder is configured to decide to choose neural network parameters, e.g. a tree tensor, associated with a root node or to choose neural network parameters, e.g. a node tensor, associated with one of the descendent nodes, e.g. child nodes, of the root node.

The decoder may hence choose which version of a neural network, parameters of which are represented in the parameter update tree, is executed or provided for further processing. The inventors recognized that, as an example, based in the information received in a bitstream, e.g. the node information, the decoder may be able to choose neural network parameters best suited for a specific task. E.g. in a simple implementation, the decoder may always choose the newest node with the corresponding neural network parameters.

According to further embodiments of the invention, the parameter update information comprises, or is, an update instruction defining a scaling of one or more parameter values associated with a parent node of a currently considered node. In addition, the decoder is configured to apply a scaling defined by the update instruction, e.g. to one or more parameter values associated with a parent node of the currently considered node, in order to obtain one or more neural network parameters associated with the currently considered node. The inventors recognized that neural network parameters may be updated efficiently using the scaling information.

According to further embodiments of the invention, a plurality of neural network parameters associated with a currently considered node are represented by a parameter tensor, and the decoder is configured to apply a product tensor to a parameter tensor, in order to obtain the parameter tensor associated with the currently considered node, e.g. by formation of element wise products between input parameter tensor elements and product tensor elements. The inventors recognized that NN parameters may be represented and coded efficiently using tensors. Furthermore, product tensors may allow a computationally efficient manipulation of parameter tensors, in order to represent multiplicative modifications between NN parameters.

According to further embodiments of the invention, a plurality of neural network parameters associated with a parent node are represented by a parameter tensor (e.g. a parent node tensor, e.g. a multi-dimensional arrays of values, for example of the neural network parameter values) and the parameter update information comprises, or is, a product tensor, e.g. in same shape as the parent node tensor, and the decoder is configured to apply the product tensor to the parameter tensor of the parent node, in order to obtain a parameter tensor associated with the currently considered node, e.g. by formation of element wise products between parent node tensor elements and product tensor elements.

The inventors recognized that neural network parameters may be represented efficiently using parameter tensors and that neural network parameter updates may be represented efficiently using product tensors.

According to further embodiments of the invention, the parameter update information comprises, or is, an update instruction defining an addition of one or more change values to one or more parameter values associated with a parent node of a currently considered node and/or a subtraction of one or more change values from one or more parameter values associated with a parent node of a currently considered node. Furthermore, the decoder is configured to apply an addition or subtraction of the change values defined by the update instruction, e.g. an addition to or a subtraction from one or more parameter values associated with a parent node of the currently considered node, in order to obtain one or more neural network parameters associated with the currently considered node.

The inventors recognized that using an addition or a subtraction, neural network parameter updates may be performed with low computational effort.

According to further embodiments of the invention, the parameter update information comprises, or is, an update instruction defining a weighted combination of one or more parameter values associated with a parent node of the currently considered node with one or more change values, e.g. in the form of a sum tensor, a scalar node tensor weight value, and a scalar sum tensor weight value.

Furthermore, the decoder is configured to apply a weighted combination of one or more parameter values associated with a parent node of the currently considered node, e.g. elements of a "node tensor" associated with the parent node of the currently considered node, with one or more change values, e.g. elements of a "sum tensor", in order to obtain one or more neural network parameters associated with the currently considered node, e.g. elements of a "node tensor" associated with the currently considered node, wherein the weighted combination may, for example, comprise a element-wise weighted summation of parameter values associated with a parent node of the currently considered node and of respective change values.

The parameter values may, for example, be neural network parameter values of a certain version of a neural network associated with the parent node. The inventors recognized that using the weighted combination neural network parameters associated with the currently considered node may be provided efficiently.

According to further embodiments of the invention, a plurality of neural network parameters associated with a parent node of the currently considered node are represented by a parameter tensor and a plurality of neural network parameters associated with a currently considered node are represented by a parameter tensor.

Furthermore, a plurality of change values are represented by a sum tensor, e.g. of the same shape as a node tensor of the parent node, e.g. a parent node tensor, and the decoder is configured to multiply elements of the parameter tensor associated with the parent node of the currently considered node with a node tensor weight value, to obtain a scaled parameter tensor, to multiply elements of the sum tensor with a sum tensor weight value, to obtain a scaled sum tensor, and form an element-wise sum of the scaled parameter tensor and of the scaled sum tensor, in order to obtain the parameter tensor, e.g. node tensor, associated with the currently considered node, wherein, for example, the parameter update information may comprise at least one of the node tensor weight value, the sum tensor weight value, the sum tensor and/or the change values.

Optionally, both weights, e.g. the node tensor weight value and the sum tensor weight value may also be set to 1, which corresponds to a non-weighted sum as a special case of the weighted sum. Alternatively, both weights may also be set to 0.5, which corresponds to an averaging as a special case of the weighted sum.

The inventors recognized that an individual scaling of the parent node information in the form of the parameter tensor and of the update information in the form of the sum tensor may allow an efficient determination of the parameter tensor of the currently considered node. Furthermore, scaling and summation may be performed with low computational costs.

According to further embodiments of the invention, the parameter update information comprises, or is, an update instruction defining a replacement of one or more parameter values associated with a parent node of the currently considered node with one or more change values, e.g. in the form of a replace tensor. Furthermore, the decoder is configured to replace one or more parameter values associated with a parent node of the currently considered node, e.g. elements of a "node tensor" associated with the parent node of the currently considered node, with one or more replacement values, e.g. elements of a "replace tensor", in order to obtain one or more neural network parameters associated with the currently considered node, e.g. elements of a "node tensor" associated with the currently considered node. The inventors recognized that a replacement of values may in some cases be performed with less computational costs than using differential update information and arithmetic operations.

According to further embodiments of the invention, a plurality of neural network parameters associated with a parent node of the currently considered node are represented by a parameter tensor and the parameter update information comprises, or is, an update instruction in the form of an update tensor, for example a replace tensor, a sum tensor, and/or a product tensor, which may for example be represented by a compressed data unit (NDU). Furthermore, the decoder is configured to, e.g. implicitly, convert the shape of the update tensor according to the shape of the parameter tensor of the parent node, e.g. such that for a parameter tensor, e.g. a node tensor of the parent note, being a 2D tensor [[a, b, c], [d, e, f]] (dimensions are [2, 3]), an update tensor given as [[x],[y]] (dimensions are [2, 1]) would be, e.g. implicitly, extended to [[x, x, x], [y, y, y]] (dimensions are [2, 3]). The inventors recognized that this way, neural network parameters may, for example, be updated in an approximative manner, e.g. although a shape of a tensor representing base or initial neural network parameters, e.g. the parameters of the parent node, may not match with a shape of the update tensor.

Furthermore, a change of tensor shape may be associated with a topology change of an updated neural network or a layer thereof. Hence, embodiments according to the invention may allow to incorporate topology changes of neural networks in training and/or updating processes. Therefore, communication and, for example, decentralized training may be provided with high flexibility.

According to further embodiments of the invention, tensor elements of the parameter tensor arranged along a first direction (e.g. along a row of the tensor) are associated with contributions of output signals of a plurality of neurons of a previous layer of the neural network to an input signal of a given neuron of a currently considered layer of the neural network, and tensor elements of the parameter tensor arranged along a second direction (e.g. along a column of the tensor) are associated with contributions of an output signal of a given neuron of a previous layer of the neural network to input signals of a plurality of neurons of a currently considered layer of the neural network.

Furthermore, the decoder is configured to extend a dimension of the update tensor in the first direction, if the extension or e.g. dimension of the update tensor in the first direction (e.g. a row direction) is smaller than a dimension of the parameter tensor in the first direction and/or the decoder is configured to extend a dimension of the update tensor in the second direction, if the extension or e.g. dimension of the update tensor in the second direction (e.g. a column direction) is smaller than a dimension of the parameter tensor in the second direction.

According to further embodiments of the invention, the decoder is configured to copy entries of a row of the update tensor, to obtain entries of one or more extension rows of a shape-converted update tensor, if a number or rows of the update tensor is smaller than a number of rows of the parameter tensor. Alternatively or in addition, the decoder is configured to copy entries of a column of the update tensor, to obtain entries of one or more extension columns of a shape-converted update tensor, if a number or columns of the update tensor is smaller than a number of columns of the parameter tensor.

The inventors recognized that a copying or duplicating of rows or columns may be a computationally inexpensive way to extend or to extrapolate information. Furthermore, a copying of related parameters may be a good approximation for neural network parameters associated with the extended rows or columns.

According to further embodiments of the invention, the decoder is configured to copy one or more entries of an update tensor, e.g. a single entry of a update tensor having dimensions of 1 in all directions, or a group of two or more entries of the update tensor, in a row direction and in a column direction, to obtain entries of a shape-converted, e.g. enlarged, update tensor. The inventors recognized that such a reproduction of parameters may be performed in a computationally inexpensive manner.

According to further embodiments of the invention, the decoder is configured to determine a need to convert the shape of the update tensor, and/or an extent of a conversion of the shape of the update tensor, in dependence on an information about an extension of the update tensor, and, for example, preferably also in dependence on an information about an extension of the parameter tensor to which the shape-converted update tensor is to be applied.

The node information, e.g. the parameter update information of the node information, may, for example, comprise the information about the extension of the update tensor. The inventors recognized that this way, such an extension information may be transmitted or received requiring only limited resources.

According to further embodiments of the invention, the decoder is configured to determine whether a parent node identifier is present, e.g. in a currently considered data block, e.g. by evaluating whether there is a signaling indicating that a parent node identifier is present, or by parsing a syntax for a parent node identifier. Furthermore, the decoder is configured to derive one or more neural network parameters according to any of the embodiments disclosed herein, e.g using a parameter update information, if the parent node identifier is present, for example, wherein in addition, depending on the value of signaling, e.g. the "parent_node_id_present_flag", the parent node identifier, for example in the form of a further new syntax element "parent_node_id" is transmitted that uniquely identifies another NDU that contains the parent node of the current PUT node.

Moreover, the decoder is configured to make the currently considered node the root node if the parent node identifier is not present, wherein, in this case, the decoder may apply an independent decoding of neural network parameters which does not rely on the a parameter update information.

Hence, the decoder may be able to adjust a parameter update tree structure, e.g. in case some tree sections are removed, for example when respective neural network parameters are outdated. A new root tree may be chosen, for example, with corresponding neural network parameters instead of parameter update information, in simple words, in order to establish a new "starting point" in the tree.

According to further embodiments of the invention, the decoder is configured to compare the parent node identifier, e.g. parent_node_id, e.g. being an, optionally cryptographic, hash value, with, e.g. cryptographic, hash values associated with one or more nodes, e.g. previously determined node, to identify the parent node of the currently considered node.

This may allow an efficient and fast iteration through the parameter update tree, e.g. in order to find even a large number of predecessor nodes for modifying neural network parameters. Furthermore, this may allow a safe transmission of update information, such that the parent node identifier may only be usable with the correct hash values.

According to further embodiments of the invention, the hash values are hash values of a full compressed data unit NDU, e.g. comprising a data size information, a header information and a payload information, wherein the payload information may, for example, comprise arithmetically coded neural network parameters, associated with one or more previously decoded nodes. The inventors recognized that the hash values may, for example, be transmitted and/or received efficiently within NDUs.

According to further embodiments of the invention, the hash values are hash values of a payload portion of a compressed data unit NDU (e.g. comprising a data size information, a header information and a payload information, wherein the payload information may, for example, comprise arithmetically coded neural network parameters), associated with one or more previously decoded nodes, while leaving a data size information and a header information unconsidered. The inventors recognized that the hash values may be extracted efficiently from a payload portion of a NDU.

According to further embodiments of the invention, the parent node identifier is a combined value representing a device identifier and a serial number of which both are associated with the parent node, e.g. the parent node represented as an NDU. The inventors recognized that using such a device identifier and serial number, the parent node and hence neural network parameters to be modified may be identified robustly.

According to further embodiments of the invention, the parent node identifier identifies an update tree, e.g. comprising an explicit update tree identifier or implicitly identifying an update tree, and/or a layer of the neural net, e.g. using an explicit layer identifier or implicitly identifying a layer, wherein, for example, the decoder may be configured to evaluate the parent node identifier in order to allocate the node information to an appropriate update tree, and/or wherein, for example, the decoder may be configured to evaluate the parent node identifier in order to allocate the node information to an appropriate layer of the neural net.

In general, according to embodiments of the invention, multiple update trees, for example for parameters of different neural networks, or for example for parameters, e.g. weights, of different layers of a same neural network may be used in order to store respective different versions, e.g. update versions, of said parameters.

The inventors recognized that parent node identifiers according to embodiments of the invention may allow to select and/or organize and/or administer such a plurality of update trees and hence parameters.

According to further embodiments of the invention, the node information comprises a node identifier, e.g. a syntax element "node_id, which may, for example identify an node. The inventors recognized that such a node identifier may allow a robust identification of a respective node of an update tree.

According to further embodiments of the invention, the decoder is configured to store the node identifier, e.g. together with the other node information, or in a manner linked or referenced to the other node information. The inventors recognized that a storing of the node identifier may allow a time delayed processing of corresponding node information.

According to further embodiments of the invention, the decoder is configured to compare one or more stored node identifiers with a parent node identifier in a node information of a new node when adding the new node, in order to identify a parent node of the new node, e.g. when extending an update tree structure in response to a detection of the new node, or when identifying a path through the update tree structure up to the root node. Hence, an update tree may be extended efficiently.

According to further embodiments of the invention, node identifier identifies an update tree (e.g. comprises an explicit update tree identifier or implicitly identifies an update tree) to which the node information is associated; and/or the node identifier identifies a layer of the neural net, e.g. using an explicit layer identifier or implicitly identifying a layer, to which the node information relates.

Optionally, the decoder may, for example, be configured to identify an update tree (or an update tree structure), to which the node is associated, or a layer of the neural net to which the node is associated, on the basis of the node identifier.

The inventors recognized that this way, an efficient neural network parameter update organization may be provided with low computational effort and good information compression.

According to further embodiments of the invention, the node identifier, e.g. a syntax element node_id in a bitstream encoding the node information, comprises, or is composed of, a device identifier and/or a parameter update tree depth information, e.g. an information about a number of nodes visited when walking the tree from a current node to a root node, and/or a parameter update tree identifier.

Optionally, the decoder may, for example, be configured to identify an update tree (or update tree structure) to which the node is associated, or position within the update tree (or update tree structure) to which the node is associated, in dependence on the node identifier.

The inventors recognized that based on or using such a node identifier, neural network parameters to be modified or addressed or provided may be selected efficiently, for example even withing organizing structures, such as parameter update trees, with many nodes or for different devices, for example, comprising a plurality of update trees. The depth information may allow to quickly find a tree level or tree layer in which a node to be selected is arranged.

According to further embodiments of the invention, the node information comprises a signaling, e.g. a flag, indicating whether a node identifier is present or not.

Optionally, the decoder is configured to selectively evaluate a node identifier information (e.g. by parsing the bit stream) in dependence on the signaling indicating whether the node identifier is present or not.

Hence, a bitstream may be provided, for example comprising a node information with a flag, indicating or showing that no node identifier in the bitstream is present, such that transmission resources may be provided for a different information.

According to further embodiments of the invention, the decoder is configured to obtain a signaling, e.g. a signaling encoded in the encoded bitstream, for example in a header of the encoded bitstream, comprising an information about the type of the parent node identifier, e.g. parent_node_id_type. Furthermore, the decoder is configured to evaluate the signaling in order to consider the respective type of the parent node identifier.

This may allow to efficiently extract an information on the type of the identifier, e.g. whether the parent node identifier is, for example, a cryptographic hash or a combined value representing a device identifier and a serial number or another information representation as disclosed herein.

According to further embodiments of the invention, the decoder is configured to selectively evaluate a syntax element, e.g. parent_node_id_type, which indicates a type of the parent node identifier, in dependence on a syntax element, e.g. parent_node_id_present_flag, indicating the presence of the parent node identifier. Hence, when a parent node identifier is not present an indication and evaluation of a type of parent node identifier may be saved.

According to further embodiments of the invention, the decoder is configured, to obtain a topology change signaling within the node information, e.g. within a node information in the form of a compressed data unit (NDU), comprising an information about a topology change of the neural network, and the decoder is configured to modify the parameter information, e.g. the parameter tensor, of the parent node according to the topology change in order to derive one or more neural network parameters of the neural network with modified topology.

It is to be noted that the decoder may be configured to change the network topology implicitly, e.g. upon receiving update tensors, e.g. product or sum tensors, with shapes not matching the tensors of a parameter tensor of a corresponding parent node. It is to be noted that optionally, a dedicated topology change signaling may be received (or transmitted e.g. by a corresponding encoder) for adapting a neural network structure robustly.

According to further embodiments of the invention, the decoder is configured to change a shape of one or two tensors (which may, for example, describe a derivation of input signals of neurons of a given layer of the neural net on the basis of output signals of neurons of a neural net layer preceding the given layer, and which may, for example, describe a derivation of input signals of a neural net layer following the given layer on the basis of output signals of neurons of the given layer) in response to a topology change information, wherein, for example, sizes of a tensor describing the derivation of input signals of neurons of the given layer and of a tensor describing a derivation of input signals of the neural net layer following the given layer may be changed in a coordinated manner, wherein, for example, typically, dimensions of two tensors may change in the same manner, or in coordinated manner.

The inventors recognized that by adjusting tensors, e.g. associated with an update version of the neural network, a topology change of said neural network may be represented efficiently.

According to further embodiments of the invention, the decoder is configured to change a number of neurons of the given layer in response to the topology change information. Hence, embodiments according to the invention may, for example, allow to incorporate a reshape or topological adaption of a neural network structure.

According to further embodiments of the invention, the decoder is configured to replace one or more tensor values of one or more tensors, a shape of which is to be changed, associated with a parent node of the currently considered node, e.g. elements of a "node tensor" associated with the parent node of the currently considered node, with one or more replacement values, e.g. elements of a "replace tensor", in order to obtain one or more tensors having a modified size.

Alternatively the decoder is configured to replace one or more tensors, a shape of which is to be changed, associated with a parent node of the currently considered node, e.g. elements of a "node tensor" associated with the parent node of the currently considered node, with one or more replacement tensors, e.g. elements of a "replace tensor", wherein the entries of the one or more replacement tensors may be defined in the node information, e.g. using a replace instruction, in order to obtain one or more tensors having a modified size.

The inventors recognized that a replacement, exchange and/or swapping of values or of whole tensors or a combination thereof, may allow an efficient updating of neural network parameters, e.g. in particular in case a shape of a respective tensor is to be changed or alternated.

According to further embodiments of the invention, the decoder is configured to change shapes, e.g. sizes, of two tensors in two update trees associated with neighboring layers of the neural net in a synchronized manner, in response to the topology change signaling, e.g. in such a manner that a number of input signals of a given layer of the neural net, a computation of which is defined in a first update tree, is changed in the same manner as a number of output signals of the given layer, a usage of which for a computation of input signals of a subsequent layer is defined in a second update tree.

A topology change in one layer of the neural network may effect a preceding and/or a following layer (e.g. with respect to an information flow through neuron layers of the neural network). Hence, the inventors recognized that, e.g. directly, intercorrelated layers, or for example parameters, e.g. weight parameters, thereof may be adapted together, e.g. in a synchronous manner.

Further embodiments according to the invention comprise an encoder for encoding parameters of a neural network in order to obtain an encoded bitstream, wherein the encoder is configured to provide, e.g.in the form of an encoded bitstream, a node information describing a node of a parameter update tree and wherein the node information comprises a parent node identifier, which is, for example, a unique parent node identifier, for example an integer number, a string, and/ or a cryptographic hash.

Furthermore, the node information comprises a parameter update information (e.g. one or more update instructions; for example a difference signal between initial neural network parameters (e.g. associated with the parent node) and a newer (current) version thereof; e.g. corresponding to a child node of the update tree), and the parameter update information describes differences between neural network parameters associated with a parent node defined by the parent node identifier and current neural network parameters.

The encoder as described above may be based on the same considerations as the above-described decoder. The encoder can, by the way, be completed with all (e.g. with all corresponding or all analogous) features and functionalities, which are also described with regard to the decoder.

According to further embodiments of the invention, the encoder is configured determine differences between one more neural network parameters, e.g. node parameters, defined by the parent node, which is identified by the parent node identifier, and one or more current neural network parameters, in order to obtain the parameter update information, which may comprise instructions on how to update a parameter associated with the parent node.

According to further embodiments of the invention, the encoder is configured to set up a parameter update tree, wherein a plurality of child nodes comprising different parameter update information, and optionally comprising an identical parent node identifier, are associated with a common parent node, e.g. a root node R, wherein, for example each node of the tree may represent a version of the neural network parameters associated with a root node of the tree.

According to further embodiments of the invention, the encoder is configured to provide the node information such that it is possible to obtain one or more neural network parameters associated with a currently considered node using the parameter update information associated with the currently considered node, e.g. node U3, using a parameter information, e.g. a tree parameter, for example neural network parameters of a base model, e.g. default or pre-trained or initial neural network parameters of a neural network, associated with a root node, e.g. node R, and using parameter update information, e.g. update rules, associated with one or more intermediated nodes, e.g. node U2, which are between the root node, e.g. node R, and the currently considered node, e.g. node U3, in the update tree.

According to further embodiments of the invention, the encoder is configured to provide a plurality of node information blocks, wherein a parent node identifier of a first node information block refers to a root node and wherein a parameter update information of the first node describes differences between neural network parameters associated with the root node defined by the parent node identifier of the first node information block, and neural network parameters of the first node. Furthermore, a parent node identifier of a N-th node information block refers to a N-1-th node and wherein a parameter update information of the N-th node describes differences between neural network parameters associated with the N-1-th node defined by the parent node identifier of the N-th node information block, and neural network parameters of the N-th node.

The inventors recognized that this way, a recursively usable parameter update tree may be provided, such that update or differential information may be encoded and transmitted and hence evaluated efficiently.

According to further embodiments of the invention, the encoder is configured to provide a signaling to a decoder, to selectively choose neural network parameters, e.g. a tree tensor, associated with a root node or neural network parameters, e.g. a node tensor, associated with one of the descendent nodes, e.g. child nodes, of the root node.

According to further embodiments of the invention, the parameter update information comprises, or is, an update instruction defining a scaling of one or more parameter values associated with a parent node of a currently considered node and the encoder is configured to determine the scaling on the basis of one or more parameter values associated with a parent node of the currently considered node and parameter values of a currently considered node.

According to further embodiments of the invention, a plurality of neural network parameters associated with a currently considered node are represented by a parameter tensor. Furthermore, the encoder is configured to provide a product tensor to for application to a parameter tensor, in order to obtain a parameter tensor associated with the currently considered node, e.g. by formation of element wise products between input parameter tensor elements and product tensor elements.

According to further embodiments of the invention, a plurality of neural network parameters associated with a parent node are represented by a parameter tensor, e.g. a parent node tensor, e.g. a multi-dimensional arrays of values, for example of the neural network parameter values. Furthermore, the parameter update information comprises, or is, a product tensor, e.g. in same shape as the parent node tensor. Moreover, the encoder is configured to provide the product tensor in such a manner, that an application of the product tensor to the parameter tensor of the parent node, results in a parameter tensor associated with the currently considered node, e.g. by formation of element wise products between parent node tensor elements and product tensor elements.

According to further embodiments of the invention, the parameter update information comprises, or is, an update instruction defining an addition of one or more change values to one or more parameter values associated with a parent node of a currently considered node and/or a subtraction of one or more change values from one or more parameter values associated with a parent node of a currently considered node. Optionally, as an example, the encoder is configured to provide the change values such that applying an addition or subtraction of the change values defined by the update instruction, e.g. an addition to or a subtraction from one or more parameter values associated with a parent node of the currently considered node, results in one or more neural network parameters associated with the currently considered node.

According to further embodiments of the invention, the parameter update information comprises, or is, an update instruction defining a weighted combination of one or more parameter values associated with a parent node of the currently considered node with one or more change values, e.g. in the form of a sum tensor, a scalar node tensor weight value, and a scalar sum tensor weight value.

Optionally, as an example, the encoder is configured to provide the update instruction such that an application of a weighted combination of one or more parameter values associated with a parent node of the currently considered node, e.g. elements of a "node tensor" associated with the parent node of the currently considered node, with one or more change values, e.g. elements of a "sum tensor", results in one or more neural network parameters associated with the currently considered node, e.g. elements of a "node tensor" associated with the currently considered node, wherein the weighted combination may, for example, comprise a element-wise weighted summation of parameter values associated with a parent node of the currently considered node and of respective change values.

According to further embodiments of the invention, a plurality of neural network parameters associated with a parent node of the currently considered node are represented by a parameter tensor and a plurality of neural network parameters associated with a currently considered node are represented by a parameter tensor and a plurality of change values are represented by a sum tensor, e.g. of the same shape as a node tensor of the parent node, e.g. a parent node tensor.

Optionally, as an example, the encoder is configured to provide the change values such that a multiplication of elements of the parameter tensor associated with the parent node of the currently considered node with a node tensor weight value, to obtain a scaled parameter tensor, a multiplication of elements of the sum tensor with a sum tensor weight value, to obtain a scaled sum tensor, and a formation of an element-wise sum of the scaled parameter tensor and of the scaled sum tensor, results in a parameter tensor, e.g. node tensor, associated with the currently considered node. Optionally, as an example, the parameter update information may comprise at least one of the node tensor weight value, the sum tensor weight value, the sum tensor and/or the change values. Optionally, both weights, e.g. the node tensor weight value and the sum tensor weight value may also be set to 1, which corresponds to a non-weighted sum as a special case of the weighted sum.

According to further embodiments of the invention, the parameter update information comprises, or is, an update instruction defining a replacement of one or more parameter values associated with a parent node of the currently considered node with one or more change values, e.g. in the form of a replace tensor.

Optionally, as an example, the encoder is configured to the update instructions such that a replacement of one or more parameter values associated with a parent node of the currently considered node, e.g. elements of a "node tensor" associated with the parent node of the currently considered node, with one or more replacement values, e.g. elements of a "replace tensor", results in one or more neural network parameters associated with the currently considered node, e.g. elements of a "node tensor" associated with the currently considered node.

According to further embodiments of the invention, a plurality of neural network parameters associated with a parent node of the currently considered node are represented by a parameter tensor and the parameter update information comprises, or is, an update instruction in the form of an update tensor, for example a replace tensor, a sum tensor, and/or a product tensor, which may for example be represented by a compressed data unit (NDU). Furthermore, the encoder is configured to provide the update tensor such that a shape of the update tensor is different from a shape of the parameter tensor of the parent node, e.g. such that for a parameter tensor, e.g. a node tensor of the parent note, being a 2D tensor [[a, b, c], [d, e, f]] (dimensions are [2, 3]), an update tensor given as [[x],[y]] (dimensions are [2, 1]) would be, e.g. implicitly, extended to [[x, x, x], [y, y, y]] (dimensions are [2, 3]).

According to further embodiments of the invention, tensor elements of the parameter tensor arranged along a first direction (e.g. along a row of the tensor) are associated with contributions of output signals of a plurality of neurons of a previous layer of the neural network to an input signal of a given neuron of a currently considered layer of the neural network. Furthermore, tensor elements of the parameter tensor arranged along a second direction (e.g. along a column of the tensor) are associated with contributions of an output signal of a given neuron of a previous layer of the neural network to input signals of a plurality of neurons of a currently considered layer of the neural network, and the encoder is configured to provide the update tensor such that the extension of the update tensor in the first direction (e.g. a row direction) is smaller than a dimension of the parameter tensor in the first direction. Alternatively or in addition, the encoder is configured to provide the update tensor such that the extension of the update tensor in the second direction (e.g. a column direction) is smaller than a dimension of the parameter tensor in the second direction.

According to further embodiments of the invention, the encoder is configured to provide the update tensor such that a number of rows of the update tensor is smaller than a number of rows of the parameter tensor and/or the encoder is configured to provide the update tensor such that a number of columns of the update tensor is smaller than a number of columns of the parameter tensor.

According to further embodiments of the invention, the encoder is configured to provide an information about an extension of the update tensor.

According to further embodiments of the invention, the encoder is configured to provide a signaling, e.g. a signaling encoded in the encoded bitstream, for example in a header of the encoded bitstream, e.g. a flag, for example a "parent_node_id_present_flag", comprising an information whether a parent node identifier is present or not.

Optionally, the encoder is, for example, configured to omit a signaling that a parent node present when encoding neural network parameters of a root node, or, as another optional feature, the encoder is, for example, configured to provide a signaling indicating that a parent node is not present when encoding neural network parameters of a root node.

According to further embodiments of the invention, the encoder is configured provide a, e.g. cryptographic, hash value associated with a node, e.g. previously determined node, as the parent node identifier, to identify the parent node of the currently considered node.

According to further embodiments of the invention, the hash value is a hash values of a full compressed data unit (e.g. NDU, e.g. comprising a data size information, a header information and a payload information, wherein the payload information may, for example, comprise arithmetically coded neural network parameters), associated with one or more previously encoded nodes.

According to further embodiments of the invention, the hash value is a hash value of a payload portion of a compressed data unit (e.g. NDU, e.g. comprising a data size information, a header information and a payload information, wherein the payload information may, for example, comprise arithmetically coded neural network parameters), associated with one or more previously encoded nodes, while leaving a data size information, e.g. of the compressed data unit, and a header information, e.g. of the compressed data unit, unconsidered.

According to further embodiments of the invention, the parent node identifier is a combined value representing a device identifier and a serial number of which both are associated with the parent node, e.g. the parent node represented as an NDU.

According to further embodiments of the invention, parent node identifier identifies an update tree (e.g. comprises an explicit update tree identifier or implicitly identifies an update tree) and/or a layer of the neural net, e.g. using an explicit layer identifier or implicitly identifying a layer, wherein, for example, the encoder is configured to provide the parent node identifier in order to allocate the node information to an appropriate update tree, and/or wherein, for example, the encoder is configured to provide the parent node identifier in order to allocate the node information to an appropriate layer of the neural net.

According to further embodiments of the invention, the node information comprises a node identifier, e.g. a syntax element "node_id, which may, for example identify a node.

According to further embodiments of the invention, the encoder is configured to store the node identifier, e.g. together with the other node information, or in a manner linked or referenced to the other node information.

According to further embodiments of the invention, the encoder is configured to compare one or more stored node identifiers with a parent node identifier in a node information of a new node when adding the new node, in order to identify a parent node of the new node, e.g. when extending an update tree structure in response to a detection of the new node, or when identifying a path through the update tree structure up to the root node.

According to further embodiments of the invention, node identifier identifies an update tree, e.g. comprises an explicit update tree identifier or implicitly identifies an update tree, to which the node information is associated; and/or the node identifier identifies a layer of the neural net, e.g. using an explicit layer identifier or implicitly identifying a layer, to which the node information relates.

Optionally, the encoder may, for example, be configured to identify an update tree (or an update tree structure), to which the node is associated, or a layer of the neural net to which the node is associated, using the node identifier.

According to further embodiments of the invention, the node identifier, e.g. a syntax element node_id in a bitstream encoding the node information, comprises, or is composed of, a device identifier and/or a parameter update tree depth information, e.g. an information about a number of nodes visited when walking the tree from a current node to a root node, and/or a parameter update tree identifier.

Optionally, the encoder may, for example, be configured to identify an update tree (or update tree structure) to which the node is associated, or position within the update tree (or update tree structure) to which the node is associated, using the node identifier.

According to further embodiments of the invention, the node information comprises a signaling, e.g. a flag, indicating whether a node identifier is present or not.

Optionally, the encoder is configured to provide the signaling indicating whether the node identifier is present or not, and/or wherein the encoder is configured to selectively encode a node identifier information (e.g. by parsing the bit stream) in dependence on the signaling indicating whether the node identifier is present or not.

According to further embodiments of the invention, the parent node identifier is a combined value representing a device identifier and a serial number which both are associated with the parent node, e.g. the parent node represented as an NDU.

According to further embodiments of the invention, the encoder is configured to provide a signaling, e.g. a syntax element, e.g. a signaling encoded in the encoded bitstream, for example in a header of the encoded bitstream, comprising an information about the type of the parent node identifier.

According to further embodiments of the invention, the encoder is configured to selectively provide a syntax element, e.g. parent_node_id_type, which indicates a type of the parent node identifier, if a syntax element describing the parent node identifier is present, e.g. in a bitstream block.

According to further embodiments of the invention, the encoder is configured, to provide a topology change signaling within the node information, e.g. within a node information in the form of a compressed data unit (NDU), comprising an information about a topology change of the neural network.

According to further embodiments of the invention, the encoder is configured to signal a change a shape of one or two tensors, (which may, for example, describe a derivation of input signals of neurons of a given layer of the neural net on the basis of output signals of neurons of a neural net layer preceding the given layer, and which may, for example, describe a derivation of input signals of a neural net layer following the given layer on the basis of output signals of neurons of the given layer) together with a signaling of a topology change, wherein, for example, sizes of a tensor describing the derivation of input signals of neurons of the given layer and of a tensor describing a derivation of input signals of the neural net layer following the given layer may be changed in a coordinated manner, wherein, typically, dimensions of two tensors change in the same manner, or in coordinated manner.

According to further embodiments of the invention, the encoder is configured to signal a change of a number, (or change a number) of neurons of the given layer using the topology change information.

According to further embodiments of the invention, the encoder is configured to signal a replacement of one or more tensor values of one or more tensors, a shape of which is to be changed, associated with a parent node of the currently considered node, e.g. elements of a "node tensor" associated with the parent node of the currently considered node, with one or more replacement values, e.g. elements of a "replace tensor", e.g. in order to allow a decoder to obtain one or more tensors having a modified size.

Alternatively, the encoder is configured to signal a replacement of one or more tensors, a shape of which is to be changed, associated with a parent node of the currently considered node, e.g. elements of a "node tensor" associated with the parent node of the currently considered node, with one or more replacement tensors, e.g. elements of a "replace tensor", wherein the entries of the one or more replacement tensors may, for example, be defined in the node information, e.g. using a replace instruction, e.g. in order to allow a decoder to obtain one or more tensors having a modified size.

According to further embodiments of the invention, the encoder is configured to signal a change of shapes, e.g. sizes, of two tensors in two update trees associated with neighboring layers of the neural net in a synchronized manner, using the topology change signaling, e.g. in such a manner that a number of input signals of a given layer of the neural net, a computation of which is defined in a first update tree, is changed in the same manner as a number of output signals of the given layer, a usage of which for a computation of input signals of a subsequent layer is defined in a second update tree.

Further embodiments according to the invention comprise a neural network controller, wherein the neural network controller is configured to train a neural network, to obtain updated, e.g. improved, neural network parameters on the basis of initial neural network parameters, e.g. by performing a training.

Furthermore, the neural network controller is configured to determine a parameter update information on the basis of reference neural network parameters, which may, for example, be equal to the initial neural network parameters, and the updated, e.g. improved, neural network parameters, wherein the parameter update information comprises one or more update instructions describing how to derive the updated neural network parameters, at least approximately, from the initial neural network parameters, or for example, from the reference neural network parameters.

Moreover, the neural network controller is configured to provide a node information comprising a parent node identifier, which is, for example, a unique parent node identifier, for example an integer number, a string, and/ or a cryptographic hash, and the parameter update information, wherein the parent node identifier defines a parent note, parameter information of which serves as, or shall be used as, a starting point for the application of the parameter update information, for example, such that the parent node identifier may, for example, designate a parent node whose parameter information was used as the reference neural network parameters for the determination of the parameter update information.

This way, a neural network may not only be trained, but the training or learning procedure may as well be represented or organized efficiently. The inventive neural network controller may provide incremental or differential training update information, in the form of the parameter update information, in order to provide different neural network parameter versions of the training process. Hence, results of different learning stages may be combined or a return to a previous parameter set may be simply possible. In addition, the neural network controller may be configured to set up or to update a parameter update tree, e.g. by providing the node information, which may allow an efficient neural network parameter version management even between different devices.

Moreover, the provision of the node information may only require a small amount of bits in a bitstream in contrast to a full transmission of the neural network parameters.

In addition, it is to be noted, that the neural network controller as described above may be based on the same considerations as the above-described decoder and/or encoder. The neural network controller can, by the way, be completed with all (e.g. with all corresponding or all analogous) features and functionalities, which are also described with regard to the decoder and/or the encoder.

According to further embodiments of the invention, the neural network controller comprises an encoder according to any embodiment as disclosed herein, or the neural network controller comprises any functionality, or combination of functionalities, of the encoder according to any embodiment as disclosed herein.

Further embodiments according to the invention comprise a neural network federated learning controller, wherein the neural network federated learning controller is configured to receive node information of a plurality of neural networks (e.g. of a plurality of neural networks having equal structure but somewhat different parameters; e.g. of a plurality of neural networks which are trained using different training data and/or using different training algorithms, e.g. on the basis of identical initial neural network parameters), wherein the node information comprises a parent node identifier, which is, for example, a unique parent node identifier, for example an integer number, a string, and/ or a cryptographic hash.

Furthermore, the node information comprises a parameter update information, e.g. one or more update instructions; for example a difference signal between initial neural network parameters and a newer version thereof; e.g. corresponding to a child node of the update tree, and the neural network federated learning controller is configured to combine parameter update information of several corresponding nodes, e.g. nodes having equal parent node identifiers, of different neural networks, to obtain a combined parameter update information.

Moreover, the neural network federated learning controller is configured to distribute the combined parameter update information, e.g. in an encoded form; e.g. to a plurality of decoders as defined above.

Hence, a decentralized learning and updating structure may be provided, wherein the neural network federated learning controller may be a central junction in a learning or updating information exchange. The inventors recognized that this may allow to train structurally equal or even structurally different (e.g. using implicit or explicit shape adaption e.g. via corresponding tensors) neural networks on a plurality of devices, or to evaluate parameter sets of these neural networks, wherein the neural network federated learning controller may process the training results, e.g. by updating and/or distributing a parameter update tree representing different versions of sets of parameters of neural networks. This may comprise combining or discarding or evaluating parameters or corresponding parameter nodes and/or the making of a decision which parameter update information associated with a set of neural network parameters is provided to which device, e.g. for further training or usage or evaluation.

In addition, it is to be noted, that the neural network federated learning controller as described above may be based on the same considerations as the above-described decoder, encoder and/or neural network controller. The neural network federated learning controller can, by the way, be completed with all (e.g. with all corresponding or all analogous) features and functionalities, which are also described with regard to the decoder, encoder and/or neural network controller.

According to further embodiments of the invention, the neural network federated learning controller is configured to combine parameter update information of several corresponding nodes having equal parent node identifiers of different neural networks, to obtain a combined parameter update information.

Hence, update or training results (or for example rather corresponding update information) may be arithmetically combined. As a simple example, a mean of parameter updates may be provided as combined parameter update information. However, e.g. based on performance evaluation of neural network parameters associated with the corresponding nodes, more complex combinations, e.g. comprising a weighting of parameters according to a performance index, may be performed.

According to further embodiments of the invention, the neural network federated learning controller is configured to distribute parameter information of a parent node, to which the parent node identifier is associated, to a plurality of decoders, e.g. as defined above, and the neural network federated learning controller is configured to receive from the decoders node information (e.g. of a plurality of neural networks; e.g. of a plurality of neural networks having equal structure but somewhat different parameters; e.g. of a plurality of neural networks which are trained using different training data and/or using different training algorithms, e.g. on the basis of identical initial neural network parameters) comprising the parent node identifier, which is, for example, a unique parent node identifier, for example an integer number, a string, and/ or a cryptographic hash. Furthermore, the neural network federated learning controller is configured to combine parameter update information of several corresponding nodes having the parent node identifier.

Hence, the neural network federated learning controller may provide the reference or initial NN parameters e.g. of the parent node, for modification in respective decoders. Receiving the node information from the decoders, the neural network federated learning controller may combine different training results, in order to improve NN training progress and/or to provide common parameters that may be more robust (e.g. because of their origin in training in different devices, comprising the different decoders, with different data sets or in different, e.g. real, applications).

According to further embodiments of the invention, the neural network federated learning controller is configured to provide, e.g. in the form of an encoded bitstream, a node information describing a combined node information of a parameter update tree, wherein the combined node information comprises the parent node identifier, which is, for example, a unique parent node identifier, for example an integer number, a string, and/ or a cryptographic hash. Furthermore, the combined node information comprises the combined parameter update information, e.g. one or more update instructions; for example a difference signal between initial neural network parameters and a combined version thereof obtained by combining parameter update information obtained from a plurality of neural network controllers; e.g. corresponding to a child node of the update tree.

According to further embodiments of the invention, the neural network federated learning controller comprises an encoder according to any of the embodiments as disclosed herein or the neural network federated learning controller comprises any functionality, or combination of functionalities, of an encoder according to any of the embodiments as disclosed herein.

Further embodiments according to the invention comprise a method for decoding parameters of a neural network, the method comprising obtaining a plurality of neural network parameters of the neural network on the basis of an encoded bitstream, obtaining, e.g. receiving; e.g. extracting from an encoded bitstream, a node information describing a node of a parameter update tree, wherein the node information comprises a parent node identifier, which is, for example, a unique parent node identifier, for example an integer number, a string, and/ or a cryptographic hash, and wherein the node information comprises a parameter update information, e.g. one or more update instructions; for example a difference signal between initial neural network parameters and a newer version thereof; e.g. corresponding to a child node of the update tree.

Furthermore, the method comprises deriving one or more neural network parameters using parameter information of a parent node (the parameter information comprising, for example a node information of the parent node, the node information for example comprising a parameter update information and a parent node identifier of the parent node, e.g. for a recursive reconstruction or recursive determination or recursive calculation or recursive derivation of the one or more neural network parameters and/or for example comprising a node parameter of the parent node, e.g. neural network parameters associated with the parent node, e.g. neural network parameters implicitly defined by the node information of the parent node) identified by the parent node identifier and using the parameter update information, which may, for example, be included in the node information.

Further embodiments according to the invention comprise a method for encoding parameters of a neural network in order to obtain an encoded bitstream, the method comprising providing, e.g. in the form of an encoded bitstream, a node information describing a node of a parameter update tree, wherein the node information comprises a parent node identifier, which is, for example, a unique parent node identifier, for example an integer number, a string, and/ or a cryptographic hash, and wherein the node information comprises a parameter update information, e.g. one or more update instructions, for example a difference signal between initial neural network parameters (e.g. associated with the parent node) and a newer (current) version thereof; e.g. corresponding to a child node of the update tree.

Furthermore, the parameter update information describes differences between neural network parameters associated with a parent node defined by the parent node identifier and current neural network parameters.

Further embodiments according to the invention comprise a method for controlling a neural network, the method comprising training a neural network, to obtain updated, e.g. improved, neural network parameters on the basis of initial neural network parameters, e.g. by performing a training, and determining a parameter update information on the basis of reference neural network parameters, which may, for example, be equal to the initial neural network parameters, and the updated, e.g. improved, neural network parameters, wherein the parameter update information comprises one or more update instructions describing how to derive the updated neural network parameters, at least approximately, from the initial neural network parameters.

Furthermore, the method comprises providing a node information comprising a parent node identifier, which is, for example, a unique parent node identifier, for example an integer number, a string, and/ or a cryptographic hash, and the parameter update information, wherein the parent node identifier defines a parent note, parameter information of which serves as, or shall be used as, a starting point for the application of the parameter update information, for example, such that the parent node identifier may, for example, designate a parent node whose parameter information was used as the reference neural network parameters for the determination of the parameter update information.

Further embodiments according to the invention comprise a method for controlling neural network federated learning, the method comprising receiving node information of a plurality of neural networks (e.g. of a plurality of neural networks having equal structure but somewhat different parameters; e.g. of a plurality of neural networks which are trained using different training data and/or using different training algorithms, e.g. on the basis of identical initial neural network parameters), wherein the node information comprises a parent node identifier, which is, for example, a unique parent node identifier, for example an integer number, a string, and/ or a cryptographic hash, and wherein the node information comprises a parameter update information, e.g. one or more update instructions; for example a difference signal between initial neural network parameters and a newer version thereof; e.g. corresponding to a child node of the update tree.

Furthermore, the method comprises combining parameter update information of several corresponding nodes, e.g. nodes having equal parent node identifiers, of different neural networks, to obtain a combined parameter update information, and distributing the combined parameter update information, e.g. in an encoded form; e.g. to a plurality of decoders as defined above.

It is to be noted, that the methods as described above may be based on the same considerations as the above-described decoder, encoder, neural network controller and/or neural network federated learning controller. The methods can, by the way, be completed with all (e.g. with all corresponding or all analogous) features and functionalities, which are also described with regard to decoder, encoder, neural network controller and/or neural network federated learning controller.

Further embodiments according to the invention comprise a computer program for performing a method according to any of the embodiments as disclosed herein, when the computer program runs on a computer.

Further embodiments according to the invention comprise an encoded representation of neural network parameters, wherein the encoded representation comprises a node information describing a node of a parameter update tree and wherein the node information comprises a parent node identifier and a parameter update information.

### Brief Description of the Drawings

The drawings are not necessarily to scale, emphasis instead generally being placed upon illustrating the principles of the invention. In the following description, various embodiments of the invention are described with reference to the following drawings, in which:
- Fig. 1a: shows a schematic view of a decoder according to an embodiment of the present invention;
- Fig. 1b: shows a schematic view of a decoder with a generalized node information according to an embodiment of the present invention;
- Fig. 2: shows a schematic view of an encoder according to an embodiment of the present invention;
- Fig. 3a: shows a schematic view of another encoder according to an embodiment of the present invention;
- Fig. 3b: shows a schematic view of an encoder with a generalized node information according to an embodiment of the present invention;
- Fig. 4: shows a schematic view of a further encoder according to an embodiment of the present invention.
- Fig. 5: shows an example, of a parameter update tree, PUT, according to embodiments of the invention;
- Fig. 6: shows a schematic example of a tensor shape conversion according to embodiments of the invention;
- Fig. 7: shows an example for a topology change of a neural network according to embodiments of the invention;
- Fig. 8: shows a schematic view of a neural network controller according to embodiments of the invention;
- Fig. 9: shows a schematic view of a neural network federated learning controller according to embodiments of the invention;
- Fig. 10: shows a schematic block diagram of a method for decoding parameters of a neural network according to embodiments of the invention;
- Fig. 11: shows a schematic block diagram of a method for encoding parameters of a neural network in order to obtain an encoded bitstream according to embodiments of the invention;
- Fig. 12: shows a schematic block diagram of a method for controlling a neural network according to embodiments of the invention;
- Fig. 13: shows a schematic block diagram of a method for controlling neural network federated learning according to embodiments of the invention;
- Fig. 14: shows a schematic view of an example of federated learning scenario according to embodiments of the invention; and
- Fig. 15: shows a schematic view of an example of parameter update tree, for example exemplary parameter update tree, according to embodiments of the invention.

### Detailed Description of the Embodiments

Equal or equivalent elements or elements with equal or equivalent functionality are denoted in the following description by equal or equivalent reference numerals even if occurring in different figures.

In the following description, a plurality of details is set forth to provide a more throughout explanation of embodiments of the present invention. However, it will be apparent to those skilled in the art that embodiments of the present invention may be practiced without these specific details. In other instances, well-known structures and devices are shown in block diagram form rather than in detail in order to avoid obscuring embodiments of the present invention. In addition, features of the different embodiments described herein after may be combined with each other, unless specifically noted otherwise.

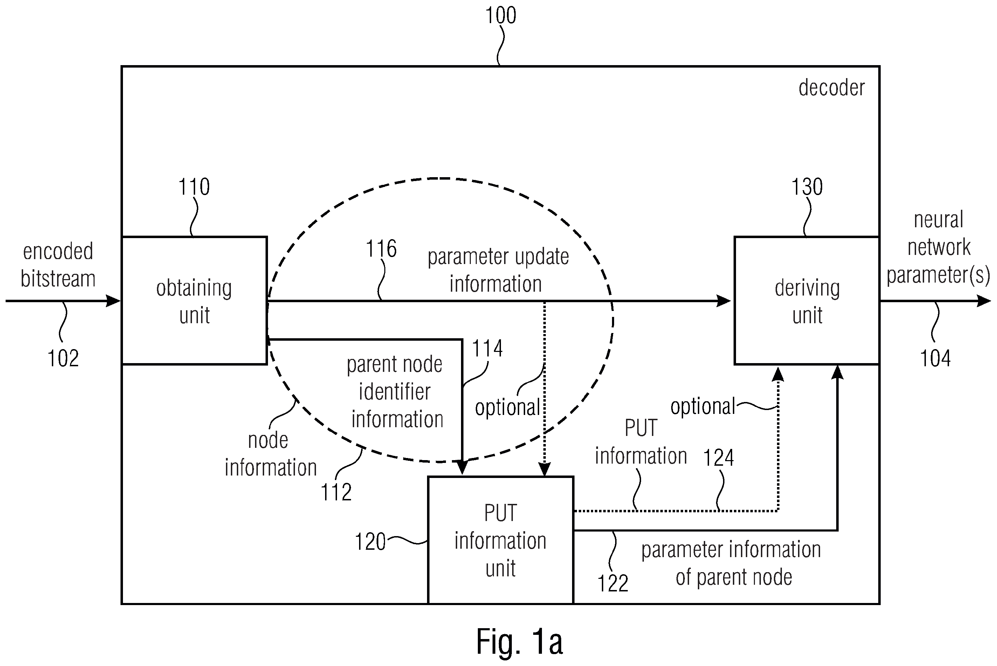

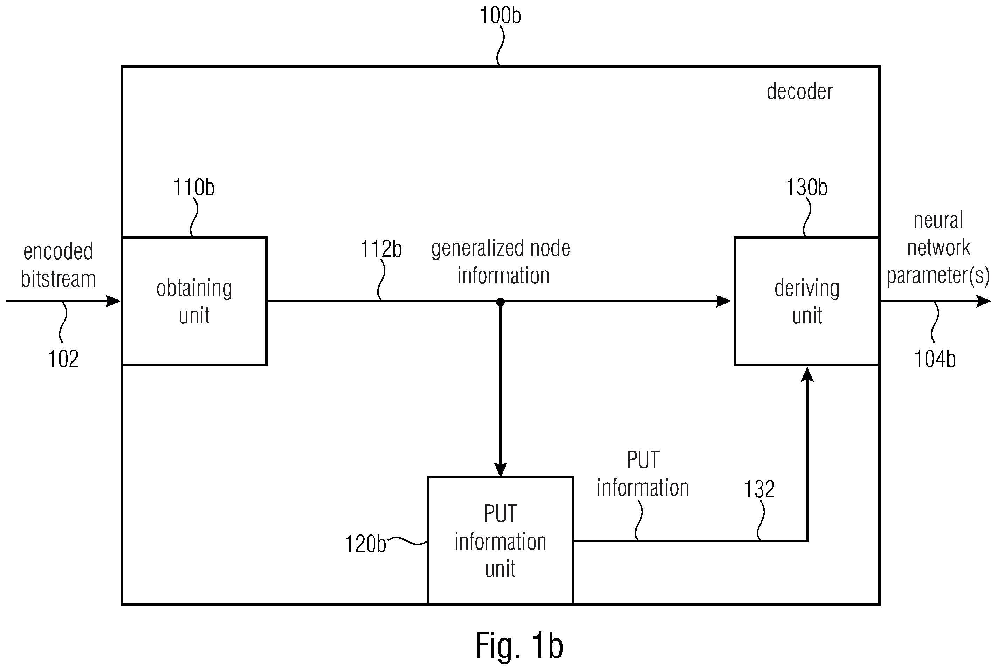

Fig. 1a shows a schematic view of a decoder according to an embodiment of the present invention. Fig. 1 shows decoder 100 comprising an obtaining unit 110, a parameter update tree, PUT, information unit 120 and a deriving unit 130.

The decoder 100 may receive an encoded bitstream 102, based on which, as an example, obtaining unit 110 may determine a node information 112. The node information 112 may describe a node of a parameter update tree, PUT. The node information 112 comprises a parent node identifier information 114, optionally comprising or for example being a parent node identifier, and a parameter update information 116.

Using the parent node identifier information 114, the PUT information unit 120 may be configured to determine a parameter information 122 of a parent node, identified by the parent node identifier information 114.

Using the parameter update information 116 and the parameter information 122, the deriving unit 130 may derive one or more neural network parameters 104.

In simple words, an information about neural network parameters may be provided using node information 112, comprising parent node identifier information 114 and parameter update information 116, encoded in the encoded bitstream 102. Hence, a parent node identifier and the parameter update information 116 may be extracted by obtaining unit 110. For example, instead of encoding the neural network parameters themselves, a reference information in the form of the parent node identifier information 114 and an update information in the form of the parameter update information 116 may be provided.

The reference information may be identified and/or extracted using PUT information unit 120, e.g. based on a parameter update tree. The idea according to embodiments may now be to extract neural network parameters of the parent node in the form of the parameter information 122 and to update this information using the parameter update information 116 in deriving unit 130.

In other words, neural network parameter(s) 104 of a current node may be derived using neural network parameters of a parent node of the current node that are modified by the parameter update information 116 using deriving unit 130.

As an optional feature, the parameter update information 116 may, for example, be provided to the PUT information unit 120.

As another optional feature, the PUT information unit 120 may be configured to provide a PUT information 124 to the deriving unit 130. The PUT information 124 may optionally comprise an information about the parameter update tree.

Fig. 1b. shows decoder 100b comprising an obtaining unit 110b, a PUT information unit 120b and a deriving unit 130b. The obtaining unit 110b may, for example, be configured to obtain a generalized node information 112b. Information 112b may optionally be equal or similar to node information 112, e.g. comprising a parent node identifier information and a parameter update information. However, generalized node information 112b may optionally comprise additional information, for example, such as a node identifier and/or a signaling whether a node identifier is present or not and/or a signaling comprising an information about a type of a parent node identifier, for example, in the form of a syntax element, a topology change information and/or a topology change signaling, as will be explained in detail henceforth.

Furthermore, PUT information unit 120b may provide a PUT information 132 to deriving unit 130b. PUT information 132 may, for example, be the parameter information of the parent node 122 as shown in Fig. 1. Optionally, update tree information 132 may comprise optional PUT information, e.g. 124 (referring to Fig. 1).

Accordingly, obtaining unit 110b may be configured to obtain or provide such a generalized node information 112b from an encoded bitstream 102, and the PUT information unit 120b may be configured to provide or determine the update tree information 132, e.g. based on a PUT, using the generalized node information 112b.

The deriving unit 130b, may hence be configured to derive one or more neural network parameters 104b using the generalized node information 112b and the PUT information 132.

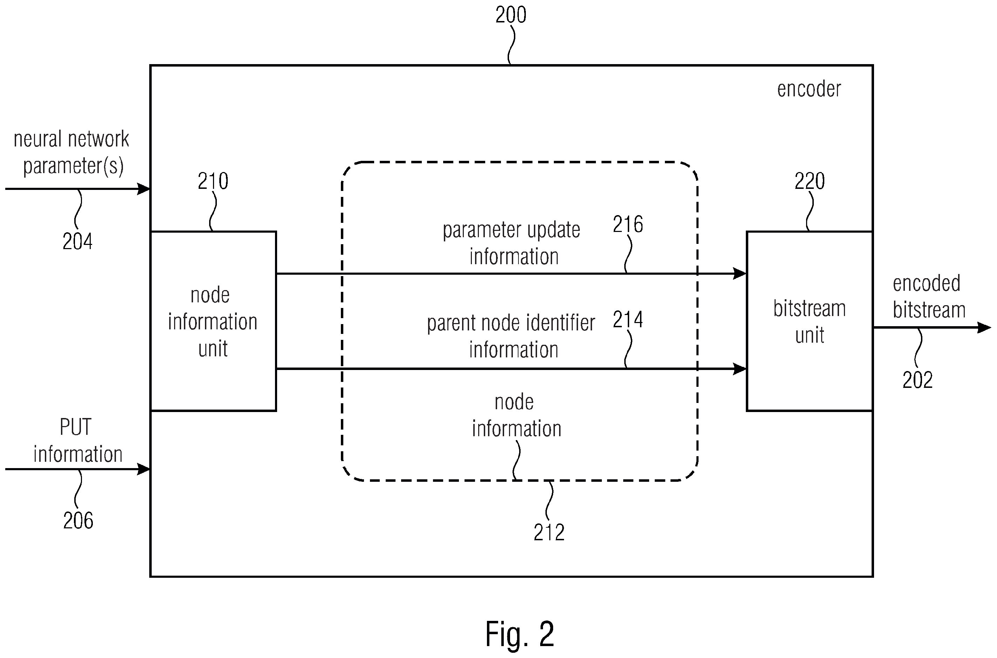

Fig. 2 shows a schematic view of an encoder according to an embodiment of the present invention. Fig. 2 shows encoder 200 comprising a node information unit 210 and a bitstream unit 220.

As shown in Fig. 2 the encoder 200 may optionally receive neural network parameter(s) 204 and/or a parameter update tree, PUT, information 206. Based on the neural network parameter(s) 204 and the PUT information 206, node information unit 210 may provide a node information 212 describing a node of a parameter update tree. Node information 212 comprises a parent node identifier information 214, optionally comprising a parent node identifier, and a parameter update information 216, wherein the parameter update information 216 describes differences between neural network parameters associated with a parent node defined by the parent node identifier information 214 and current neural network parameters 204.

Using the node information 212 the bitstream unit 220 may provide an encoded bitstream 202, the bitstream comprising encoded neural network parameters 204.

As an example, as shown in Fig. 2, the idea of encoder 200 may be to encode neural network parameters(s) 204 not simply with their respective values, but using a reference and a differential or difference information with regard to the reference. The reference may be a set of neural network parameters identified by a parent node of a parameter update tree, indicated by parent node identifier information 214. The differential or difference information of the neural network parameters 204 with respect to neural network parameters of the parent node may be the parameter update information 216.

Therefore, encoded bitstream 202 may allow a corresponding decoder that may have an information about the parameter update tree available to identify a corresponding parent node, and hence neural network parameters thereof, to adapt or to modify those in order to determine neural network parameter(s) 204.

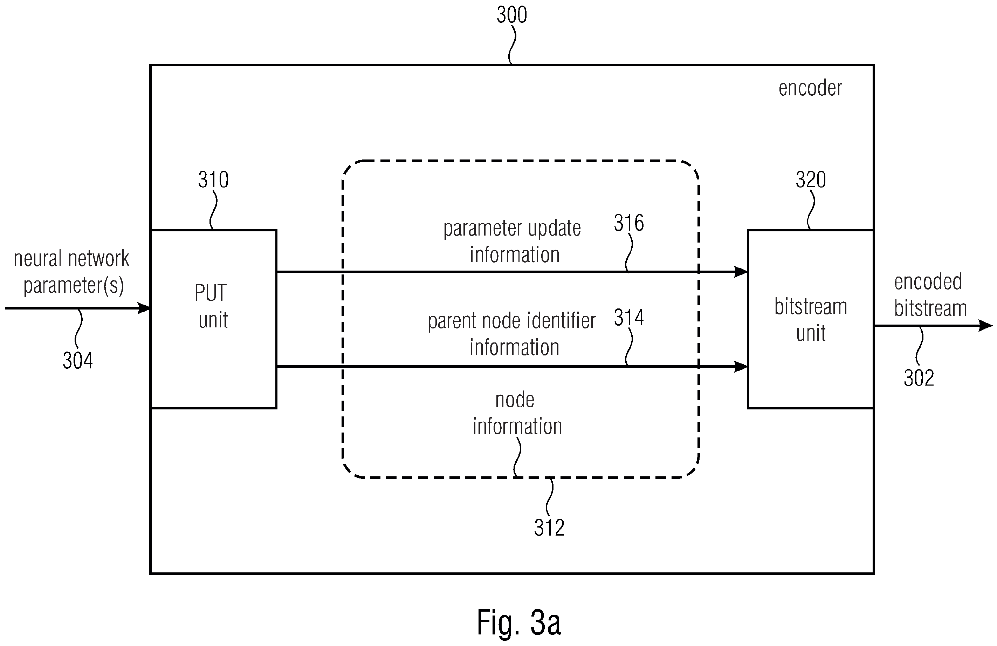

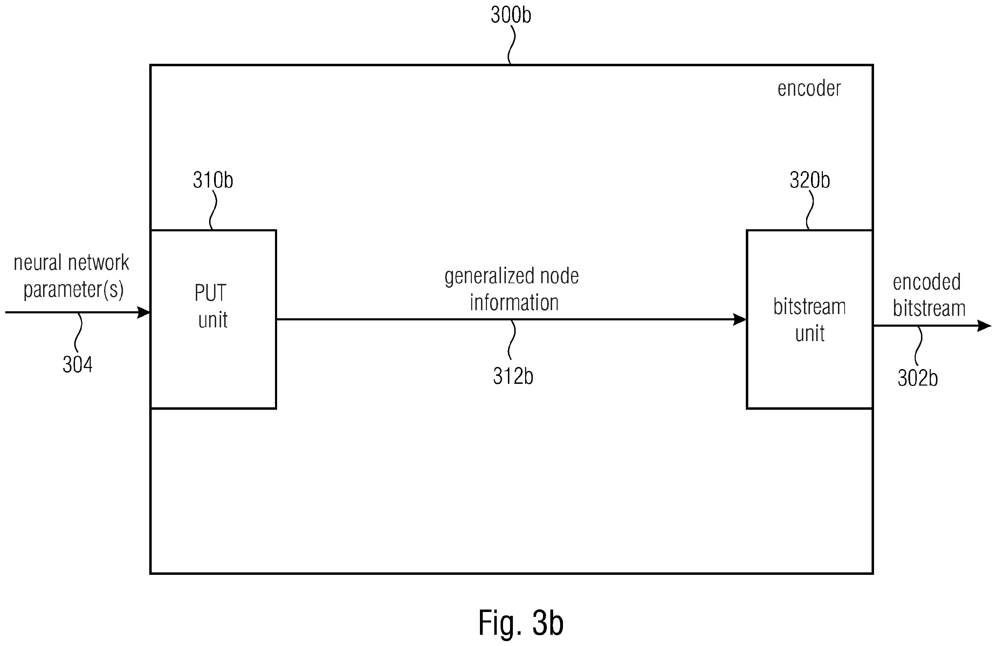

Fig. 3a shows a schematic view of another encoder according to an embodiment of the present invention. Fig. 3 shows encoder 300 comprising a parameter update tree, PUT, unit 310 and a bitstream unit 320.

In this example, encoder 300 may receive neural network parameter(s) 304. In order to encode the parameter(s) 304 encoder 300 may determine node information 312 comprising parent node identifier information 314, optionally. comprising a parent node identifier, and parameter update information 316, using PUT unit 310, for example, such that parameter(s) 304 may be represented as neural network parameters of a parent node (represented as the parent node identifier information 314) of a parameter update tree and a modification or update information (represented as the parameters update information 316).

As explained in the context of Fig. 2 bitstream unit 320 may encode the node information 312 in an encoded bitstream 302. As an example, encoder 300, e.g. in contrast to encoder 200 may be configured to provide node information 312 based on the parameters 304 as, for example only, input signal. Therefore, the PUT unit 310 may comprise a parameter update tree information in order to provide an alternative representation of the parameters 304 in the form of the update information 316 and an identifier.

Fig. 3b shows a schematic view of an encoder with a generalized node information according to an embodiment of the present invention. Fig. 3b shows encoder 300b comprising a parameter update tree, PUT, unit 310b and a bitstream unit 320b. PUT unit 310b may be configured to provide the generalized node information 312b based on or using neural network parameter(s) 304, wherein information 312b may optionally be equal or similar to node information 312, e.g. comprising a parent node identifier information and a parameter update information.

However, generalized node information 312b may optionally comprise additional information, for example, such as a node identifier and/or a signaling whether a node identifier is present or not and/or a signaling comprising an information about a type of a parent node identifier, for example, in the form of a syntax element, a topology change information and/or a topology change signaling, as will be explained in detail henceforth.

Using the generalized node information 312b the bitstream unit 320b may provide an encoded bitstream 302b.

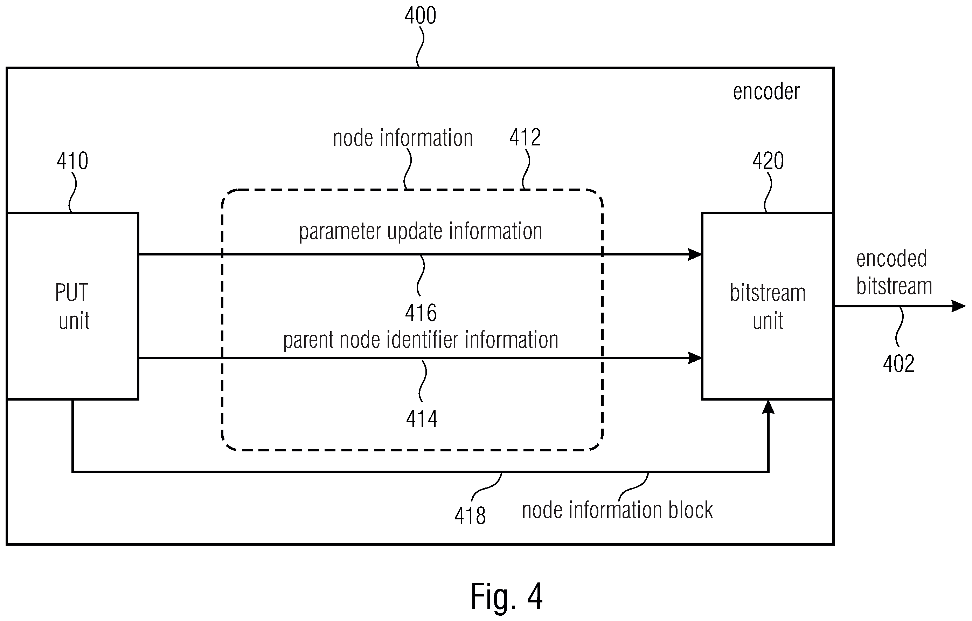

Fig. 4 shows a schematic view of a further encoder according to an embodiment of the present invention. Fig. 4 shows encoder 400 comprising a PUT unit 410 and a bitstream unit 420.

As an optional example, PUT unit 410 may comprise a parameter update tree, e.g. as explained in the context of Fig. 5. The PUT unit 410 may provide a node information 412, comprising a parent node identifier information 414, optionally comprising a parent node identifier, and a parameter update information 416, that is provided to the bitstream unit 420 to obtain an encoded bitstream 402. Current neural network parameters e.g. associated with a specific node of the parameter update tree may hence be encoded in the form of the parent node identifier information 414, providing an information about reference parameters and of the parameter update information 416 providing an information on how to modify the reference parameters, in order represent the current neural network parameters associated with the node. Accordingly, the parameter update information 416 may describe differences between neural network parameters associated with a parent node defined by the parent node identifier and the current neural network parameters.

As an optional feature, encoder 400, e.g. PUT unit 410, may be configured to provide a plurality of node information blocks 418, wherein a parent node identifier of a first node information block refers to a root node and wherein a parameter update information of the first node describes differences between neural network parameters associated with the root node defined by the parent node identifier of the first node information block, and neural network parameters of the first node, and wherein a parent node identifier of a N-th node information block refers to a N-1-th node and wherein a parameter update information of the N-th node describes differences between neural network parameters associated with the N-1-th node defined by the parent node identifier of the N-th node information block, and neural network parameters of the N-th node.

In simple words, encoder 400 may be configured to provide, e.g. via encoded bitstream 402 an information about a respective parameter update tree.

Fig. 5 shows an example, of a parameter update tree, PUT, according to embodiments of the invention. Fig. 5 shows PUT 500 comprising a root node R 510 and a plurality of child nodes, to name some as examples 520, 530 ,540, 550, 560.

As a simplified example, root node R, 510, may correspond to a set of four neural network parameters a₁₁=a₁₂=a₂₁=a₂₂=0, as an example, represented by a tensor 512. a₁₁, a₁₂, a₂₁, a₂₂ may, for example, be parameter values associated with the node R.

Hence, accordingly, a child node U1, 530, may correspond to a set of four neural network parameters, e.g. parameter values, a₁₁=a₁₂= a₂₂=0 and a₂₁=1, as an example, represented by a tensor 532.

The idea according to embodiments may now be the following: Instead of transmitting all four neural network parameters a₁₁=a₁₂= a₂₂=0 and a₂₁=1, only a reference information in the form of a parent node identifier 534 and a parameter update information 536 may be transmitted. In the simplified example of Fig. 5 the parameter update information 536 may be four change values, as an example represented by an additive tensor 536. In many applications, many NN parameters may not change drastically in between training cycles, hence as shown with tensor 536 many change values may be zero or quantized to zero. Hence such an update information may be encoded efficiently (e.g. compression of zeros).

Hence, if an encoder and a corresponding decoder both comprise an information about neural network parameters associated with root node R, 510, for example initial neural network parameters or default neural network parameters, then it may not be necessary to fully encode neural network parameters 532 associated with node U1, 530, e.g. neural network parameters after a first training step of a neural network, but only a reference information 534 and a difference information 536.

Hence, an encoder may transmit a node information in an encoded bitstream comprising parameter update information 536 and parent node identifier 534, such that a corresponding decoder may determine neural network parameters 532 as a sum, e.g. an elementwise-sum, of the neural network parameters 512 associated with the root node R, 510, identified by the parent node identifier 534, and the parameter update information 536, for example, such that tensor 512 + tensor 536 = tensor 532.

Accordingly, node U2, 520, may be associated with neural network parameters 522, wherein a parent node of U2 is node R, 510, such that parent node identifier 524 may be a pointer towards root node R, 510.

Node 540, associated with neural network parameters 542, may as well be a child node of node R, 510, such that parent node identifier 544 may as well be a pointer towards root node R, 510.

In contrast, nodes 550, 560 may be child nodes of node U2, 520, hence their parent node identifiers 554, 564 may identify U2, 520. U3, 550, may be associated with neural network parameters 552, and comprise parameter update information 556, with respect to its parent node U2, 520. Vice versa, U4, 560 may be associated with neural network parameters 562, and may comprise parameter update information 566, with respect to its parent node U2, 520.

The further elements of Fig. 5 will be explained in more detail step by step with regard to further embodiments of the invention. In the following further embodiments according to the invention are explained in the context of Figs. 1 to 5.

Accordingly to the above explanation, as an optional feature, an encoder, e.g. 200, 300, 300b and/or 400, may be configured determine differences, e.g. using node information unit 210 or PUT unit 310, 310b, 410, between one more neural network parameters, e.g. 512, defined by the parent node, e.g. R, 510, which is identified by the parent node identifier, e.g. 534, and one or more current neural network parameters, e.g. 532, in order to obtain the parameter update information, e.g. 536.

As another optional feature, an inventive decoder, e.g. 100, 100b, e.g. PUT information unit 120, 120b, and/or an inventive encoder, e.g. 200, 300, 300b and/or 400 for example node information unit 210 and/or PUT unit 310, 310b, 410, may optionally be configured to set up a parameter update tree 500, wherein a plurality of child nodes (to name only some, for example 520, 530 ,540, 550, 560) comprising different parameter update information (e.g. 526, 536, 546, 556, 566) are associated with a common parent node, e.g. R, 510. Hence, as shown in Fig. 5 some nodes, e.g. U3, 550 and U4, 560, may be associated with the common parent node R via different, e.g. intermediate nodes, e.g. U2, 520.

As an example, an inventive PUT information unit, e.g. 120, 120b, may comprise the parameter update tree and/or may, for example, be configured to set the parameter update tree up. Therefore, the PUT information unit may, as explained before, optionally receive the parameter update information 116, in order to set up or to update a corresponding PUT.

An inventive encoder, e.g. 200, 300, 300b and/or 400, may, for example, be configured to set up a PUT using the node information unit 210 or a PUT unit 310, 310b and/or 410 respectively. These units may be configured to set up, store and/or update a PUT.

As another optional feature, an inventive encoder, e.g. 200, 300, 300b and/or 400 for example node information unit 210 and/or PUT unit 310, 310b, 410, may optionally be configured to provide the node information 212, 312, 312b and/or 412 (for example a node information comprising a parameter update information 556 and a parent node identifier 554), such that it is possible to obtain one or more neural network parameters, e.g. 552 associated with a currently considered node, e.g. U3, 550, using the parameter update information, e.g. 556, associated with the currently considered node, using a parameter information, e.g. 512, associated with a root node, e.g. R, 510, and using parameter update information, e.g. 526, associated with one or more intermediate nodes, e.g. U2, 520, which are between the root node and the currently considered node in the update tree.

Hence, as an example, in order to obtain neural network parameter associated with node U3, 550, the neural network parameters 512 of the root node R, 510 may be modified according to the tree path R-U2-U3 using parameter update information 526 and 556, such that tensor 512 + tensor 526 + tensor 556 = tensor 552 (as an example, with an elementwise summation) representing the neural network parameters of node U3.

Accordingly, as an optional feature, an inventive decoder, e.g. 100, 100b, e.g. deriving unit 130, 130b, may be configured to obtain one or more neural network parameters, e.g. 104, 104b, for example corresponding to 552, associated with a currently considered node, e.g. U3, 550, using the parameter update information, e.g. 556, associated with the currently considered node, using a parameter information, e.g. 512, associated with a root node, e.g. R, 510, and using parameter update information, e.g. 526, associated with one or more intermediated nodes, e.g. U2, 520, which are between the root node and the currently considered node in the update tree.

Therefore, for example when the PUT information unit 120, 120b comprises an information about the PUT, PUT information unit 120, 120b may provide the PUT information 132 (or the optional information 124) comprising parameter update information, e.g. 526, and optionally parent node identifiers, e.g. 524, of intermediate nodes, e.g. U2, 520, to the deriving unit, e.g. 130, 130b, to obtain the one or more neural network parameters, e.g. 104, 104b for example corresponding to 552. In this case, as an example, encoded bitstream 102 may only comprise a parameter update information, e.g. 556, and a parent node identifier, e.g. 554, of the currently considered node (which may be used in conjunction with a PUT to determine a path through the PUT to determine the neural network parameters, e.g. 552, of the currently considered node, e.g. U3, 550).

As another, e.g. alternative, optional feature, the encoded bitstream 102 may comprise an information about the PUT, e.g. 500, and/or for example information about a path of the PUT, e.g. R-U2-U3, such that the parameter update information, e.g. 116, provided by obtaining unit, e.g. 110, 110b, may comprise the parameter update information, e.g. 556 and 526, of the currently considered node, e.g. U3, 560, and an intermediate node, e.g. U2, 520. Accordingly, parent node identifiers, e.g. 554 and 524, may be provided.

Accordingly, an inventive encoder, e.g. 200, 300, 300b and/or 400, may be configured to provide such an encoded bitstream 202, 302, 302b and/or 403 comprising a parameter update information and parent node identifiers of currently considered nodes and intermediate nodes..

Furthermore, as another optional feature, e.g. PUT information unit 120, 120b, comprising a PUT, e.g. 500, may, for example, be configured to traverse the parameter update tree, e.g. 500 (for example using PUT information unit 120, 120b), from a root node, e.g. R, 510, to a currently considered node, e.g. U3, 550, and to apply update instructions, e.g. 526, of visited nodes, e.g. U2, 520, to one or more initial neural network parameters, e.g. 512, in order to obtain one or more neural network parameters, e.g. 552, associated with the currently considered node, e.g. U3, 550.

As another optional feature, an inventive decoder, e.g. 100, 100b, e.g. PUT information unit 120, 120b, comprising a PUT, e.g. 500, may, for example, be configured to aggregate a plurality of consecutive nodes, e.g. nodes U2, 520, and U3, 550, of the parameter update tree, e.g. 500 and/or one or more consecutive nodes, e.g. nodes U2, 520, and U3, 550, of the parameter update tree and the parameter update information, e.g. 526, 556.

Hence, as shown in Fig. 5, nodes U2, 520, and U3, 550 may be aggregated or merged together to a new node U23, 540. Therefore, neural network parameters associated with U3, namely parameters 552 may be equal to neural network parameters associated with U23, namely parameters 542. Consequently, parameter update information 546 of node U23 may be a combination (in the simple example of Fig. 5 an elementwise sum) of parameter update information 526 and 556. Accordingly, parent node identifier 544 may point to the same node or may be equal to parent node identifier 524.

As another optional feature, an inventive decoder, e.g. 100, 100b, e.g. PUT information unit 120, 120b, may optionally be configured to update the parameter update tree, e.g. 500, based on the node information, e.g. 112, 112b. As an example, PUT information unit 120, 120b may optionally comprise the information about the parameter update tree, e.g. 500. The parameter update tree may be adapted by, for example, adding a new node, for example a node U4, 560, to the parameter update tree. This may comprise adding a corresponding parent node identifier, e.g. 564. Optionally, parameter update information 116 may be proved to PUT information unit 120, 120b as well, such that parameter update information 116, e.g. corresponding to tensor 566, may be added to the PUT as well. Hence, information about the new node, e.g. U4, 560, namely the parameter update information, e.g. 566, and the parent node identifier, e.g. 564, may be provided in the bitstream, e.g. 102, optionally, with a signaling to indicate that a new node is to be added. Alternatively, an inventive decoder, e.g. 100, may be configured to add such a node autonomously.

As another optional feature, an inventive decoder 100, 100b may be configured to decide to choose neural network parameters associated with a root node, e.g. R, 510, or to choose neural network parameters associated with one of the descendent nodes of the root node.

Accordingly, an inventive encoder, e.g. 200, 300, 300b and/or 400 for example bitstream unit 220, 320, 320b, 420, may optionally be configured to provide a signaling, e.g. the encoded bitstream 202, 302, 302b, and/or 402, or a signal encoded in the encoded bitstream, to a decoder, e.g. 100, 100b, to selectively choose neural network parameters associated with a root node, e.g. R, 510, or neural network parameters associated with one of the descendent nodes of the root node.

As mentioned before, the elementwise sums of tensors, as explained above, may only be one e.g. simple example for the handling of parameter update information according to embodiments of the invention.

Parameter update tree 500 further comprises a node U5, 570, associated with parameter values, e.g. neural network parameters, 572, optionally in the form of a tensor, as shown in Fig. 5. Node U5, 570, is a child node of node U1, 530, as indicated by parent node information 574. As another optional feature, parameter update information 576 of node U5 comprises a scaling.

Hence, as another optional feature, the parameter update information 116, 216, 316 and/or 416 may, for example, comprise an update instruction defining a scaling of one or more parameter values associated with a parent node of a currently considered node.

Furthermore, an inventive decoder, e.g. 100, 100b, e.g. deriving unit 130, 130b, may optionally be configured to apply a scaling defined by the update instruction, e.g. 576, in order to obtain one or more neural network parameters, e.g. 104, 104b, for example corresponding to tensor 572, associated with the currently considered node, e.g. U5, 570, and correspondingly, an inventive encoder, e.g. 200, 300, 300b and/or 400 for example node information unit 210 or PUT unit 310, 310b, 410, may be configured to determine the scaling on the basis of one or more parameter values associated with a parent node, e.g. U1, 530 of the currently considered node and parameter values, e.g. 572, of a currently considered node, e.g. U5.

For explanatory purposes, in simple words, scaling 576 may indicate to double the parameter values 532 of parent node U1 in order to obtain the parameter values 572 of node U5.

Parameter update tree 500 further comprises a node U0, 580, associated with parameter values, e.g. neural network parameters, 582, optionally in the form of a tensor, as shown in Fig. 5. Node U0, 580, is a child node of node R, 510, as indicated by parent node information 584. As another optional feature, parameter update information 586 of node U0 comprises an additive change value, e.g. +3.

Hence, as an optional feature, the parameter update information116, 216, 316 and/or 416 (and accordingly generalized node information 112b, 312b) may comprise an update instruction defining an addition of one or more change values, e.g. a change value 3, to one or more parameter values, e.g. a₁₂ of tensor 512, associated with a parent node, e.g. R, 510, of a currently considered node, e.g. U0, 580, and/or a subtraction of one or more change values from one or more parameter values associated with a parent node of a currently considered node.

Therefore, an inventive decoder, e.g. 100, 100b, e.g. deriving unit 130, 130b, may optionally be configured to apply an addition or subtraction of the change values defined by the update instruction, in order to obtain one or more neural network parameters associated with the currently considered node.

As an optional example, a tensor subtraction is shown in Fig. 5 with parameter update information 566 of node U4, 560. Hence, embodiments may comprise additions or subtractions, e.g. elementwise additions or subtractions, e.g. in tensor or matrix form.

Parameter update tree 500 further comprises a node U8, 590, associated with parameter values, e.g. neural network parameters, 592, optionally in the form of a tensor, as shown in Fig. 5. Node U8, 590, is a child node of node U23, 540, as indicated by parent node information 594. As another optional feature, parameter update information 596 of node U8 is a product tensor.

In other words, optionally, a plurality of neural network parameters, e.g. 592, associated with a currently considered node, e.g. U8, may be represented by a parameter tensor and an inventive decoder, e.g. 100, e.g. deriving unit 130, 130b may optionally, be configured to apply a product tensor, e.g. 596, to a parameter tensor, e.g. 542, in order to obtain the parameter tensor, e.g. 592, associated with the currently considered node, e.g. 590, for example, as shown as a simple variant, using or performing or based on an elementwise multiplication of tensor elements.

Accordingly, an inventive encoder, e.g. 200, 300, 300b and/or 400 for example node information unit 210 or PUT unit 310, 310b, 410, may be configured to provide a product tensor, e.g. 596, for application to a parameter tensor, e.g. 542, in order to obtain a parameter tensor, e.g. 592, associated with the currently considered node, e.g. U8, 590.

Furthermore, as another optional feature, a plurality of neural network parameters associated with a parent node may be represented by a parameter tensor, and the parameter update information 116, 216, 316 and/or 416 (and accordingly generalized node information 112b, 312b) may optionally, comprise a product tensor, e.g. 596.

Moreover, an inventive decoder, e.g. 100, 100b, e.g. deriving unit 130, 130b, may optionally be configured to apply the product tensor, e.g. 596, to the parameter tensor, e.g. 542, of the parent node, e.g. 540, in order to obtain a parameter tensor, e.g. 592, associated with the currently considered node, e.g. U8, 590.

Accordingly, an inventive encoder, e.g. 200, 300, 300b and/or 400, for example node information unit 210 and/or PUT unit 310, 310b, 410, may be configured to provide the product tensor, e.g. 596, in such a manner, that an application of the product tensor to the parameter tensor, e.g. 542, of the parent node, e.g. 540, results in a parameter tensor, e.g. 592, associated with the currently considered node, e.g. U8, 590.

Parameter update tree 500 further comprises a node U7, 600, associated with parameter values, e.g. neural network parameters, 602, optionally in the form of a tensor, as shown in Fig. 5. Node U7, 600, is a child node of node U0, 580, as indicated by parent node information 604. As another optional feature, parameter update information 606 of node U8 is an update instruction defining a weighted combination of one or more parameter values, e.g. a₁₂ of 582, associated with a parent node, e.g. U0, 580, of the currently considered node, e.g. U7, 600, with one or more change values.

Hence, optionally, the parameter update information, e.g. 116, 216, 316 and/or 416 (and accordingly generalized node information 112b, 312b), may comprise an update instruction, e.g. 606, defining a weighted combination of one or more parameter values, e.g. a₁₂ of 582, associated with a parent node, e.g. U0, 580, of the currently considered node, e.g. U7, 600, with one or more change values.

Accordingly, an inventive decoder, e.g. 100, 100b, e.g. deriving unit 130, 130b, may optionally be configured to apply a weighted combination of one or more parameter values associated with a parent node of the currently considered node with one or more change values, in order to obtain one or more neural network parameters associated with the currently considered node.

Again, it is to be noted that any additional information required for a processing, an optional PUT information 124 may be provided by PUT information unit 120 to the deriving unit 130. Accordingly PUI information 132 may comprise such an additional information.

Parameter update tree 500 further comprises a node U6, 610, associated with parameter values, e.g. neural network parameters, 612, optionally in the form of a tensor, as shown in Fig. 5. Node U6, 610, is a child node of node U1, 530, as indicated by parent node information 614. As another optional feature, parameter update information 616 of node U6 is an update instruction defining a replacement of one or more parameter values, in this case the parameter value a₁₂ of tensor 532, associated with the parent node of U6 with one or more change values, in this case the one change value 5.

Hence, an inventive parameter update information 116, 216, 316 and/or 416 (and accordingly generalized node information 112b, 312b) may optionally comprise an update instruction, e.g. 616, defining a replacement of one or more parameter values associated with a parent node, e.g. U1, 530, of the currently considered node, e.g. U6, 610, with one or more change values.

Therefore, an inventive decoder, e.g. 100, 100b, e.g. deriving unit 130, 130b, may optionally be configured to replace one or more parameter values associated with a parent node of the currently considered node with one or more replacement values, in order to obtain one or more neural network parameters associated with the currently considered node.

Parameter update tree 500 further comprises a node U9, 620, associated with parameter values, e.g. neural network parameters, 612, optionally in the form of a tensor, as shown in Fig. 5. Node U9, 620, is a child node of node U6, 610, as indicated by parent node information 624.

As an optional feature, as shown with the example of U9, 620, a plurality of neural network parameters associated with a parent node of the currently considered node, e.g. U9, may be represented by a parameter tensor, e.g. 612, and a plurality of neural network parameters associated with a currently considered node may be represented by a parameter tensor, e.g. 622, and a plurality of change values may be represented by a sum tensor, e.g. sum tensor $\left(\begin{matrix}1 & 0 \\ 0 & 1\end{matrix}\right)$ of parameter update information 626.

Furthermore, as an example, an inventive encoder, e.g. 200, 300, 300b and/or 400 for example node information unit 210 and/or PUT unit 310, 310b, 410, may be configured to multiply elements of the parameter tensor, e.g. 612, associated with the parent node, e.g. U6, 610, of the currently considered node, e.g. U9, 620, with a node tensor weight value, e.g. as shown with factor •2 of parameter update information 626, to obtain a scaled parameter tensor, to multiply elements of the sum tensor, e.g. sum tensor $\left(\begin{matrix}1 & 0 \\ 0 & 1\end{matrix}\right)$ of parameter update information 626, with a sum tensor weight value, e.g. weight value 1, as shown with parameter update information 626, to obtain a scaled sum tensor, and form an element-wise sum of the scaled parameter tensor and of the scaled sum tensor, in order to obtain the parameter tensor, e.g. 622, associated with the currently considered node, e.g. U9.

It is to be noted that embodiments according to Fig. 5 may be simple embodiments, for explanatory purposes, such that, for example significantly more complex, parameter update information may be used in order to represent a specific version of neural network parameters.

As an optional feature, e.g. as explained before, a plurality of neural network parameters associated with a parent node of a currently considered node may be represented by a parameter tensor, and the parameter update information 116, 216, 316 and/or 416 (and accordingly generalized node information 112b, 312b) may optionally comprise an update instruction in the form of an update tensor.

Furthermore, an inventive decoder, e.g. 100, 100b, e.g. deriving unit 130, 130b, may optionally be configured to convert the shape of the update tensor according to the shape of the parameter tensor of the parent node.

Accordingly, an inventive encoder, e.g. 200, 300, 300b and/or 400 for example node information unit 210 and/or PUT unit 310, 310b, 410, may optionally be configured to provide the update tensor such that a shape of the update tensor is different from a shape of the parameter tensor of the parent node.

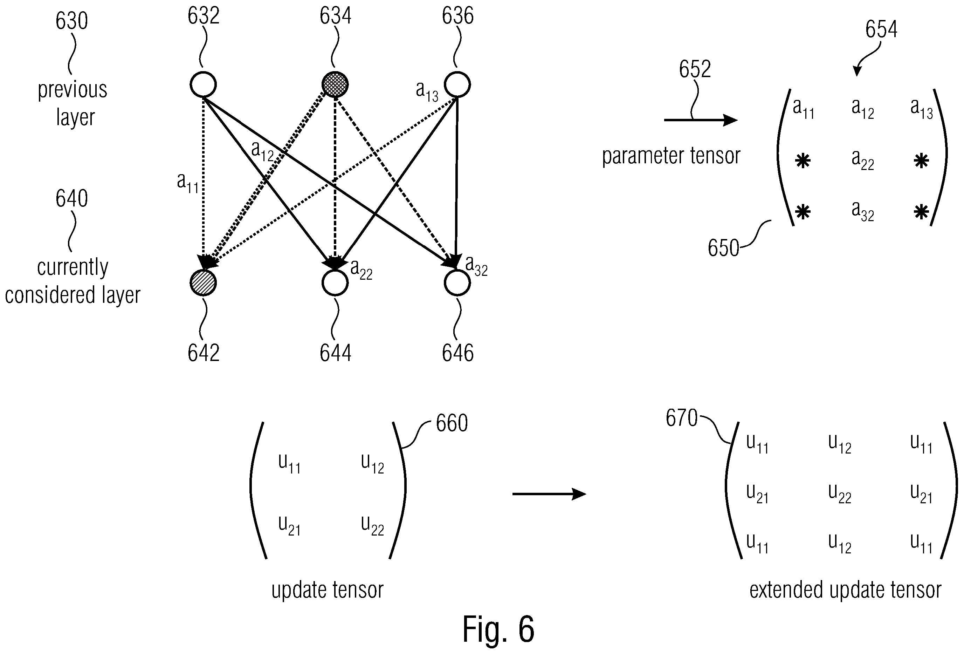

For further explanation, reference is made to Fig. 6. Fig. 6 shows a schematic example of a tensor shape conversion according to embodiments of the invention. Fig. 6 shows an example of a currently considered layer 630 of neurons of a neural network and of a previous layer 640 of the neural network.

As an example, tensor 650, may comprise neural network parameters, e.g. weights, associated with a parent node of the currently considered node, wherein tensor elements, e.g. a₁₁, a₁₂, a₁₃, of the parameter tensor 650 arranged along a first direction (e.g. along a row 652 of the tensor) may be associated with contributions of output signals of a plurality of neurons 632, 634, 636 of a previous layer 630 of the neural network to an input signal of a given neuron, e.g. 642, of a currently considered layer 640 of the neural network, and tensor elements, e.g. a₁₂, a₂₂, a₃₂, of the parameter tensor arranged along a second direction (e.g. along a column 654 of the tensor) are associated with contributions of an output signal of a given neuron, e.g. 634, of a previous layer 630 of the neural network to input signals of a plurality of neurons 642, 644, 646 of a currently considered layer 640 of the neural network. In the example of Fig. 6 for brevity not all weights between layers are shown (placeholders *).

Optionally, an inventive decoder, e.g. 100, 100b, e.g. deriving unit 130, 130b or obtaining unit 110, 110b, may optionally be configured to extend a dimension an update tensor 660 in the first direction 652, if the extension or dimension of the update tensor in the first direction (e.g. a row direction) is smaller than a dimension of the parameter tensor 650 in the first direction. Alternatively or in addition, the decoder may be configured to extend a dimension of the update tensor 660 in the second direction 654, if the extension or dimension of the update tensor in the second direction (e.g. a column direction) is smaller than a dimension of the parameter tensor 650 in the second direction.

Hence, an extended update tensor 670 may be provided, such that extended update tensor 670 may be combined with parameter tensor 650 in order to modify neural network parameters of the parent node to determine neural network parameters of a current node.

In general, it is to be noted that nodes and corresponding tensors may represent neural network parameters of a layer of a neural network, and/or of a whole neural network and hence of multiple layers.

Accordingly, an inventive encoder, e.g. 200, 300, 300b and/or 400 for example node information unit 210 and/or PUT unit 310, 310b, 410, may optionally be configured to provide the update tensor 660, such that the extension or dimension of the update tensor 660 in the first direction 652 (e.g. a row direction) is smaller than a dimension or extension of the parameter tensor 650 in the first direction. Alternatively or in addition, the encoder may be configured to provide the update tensor 660 such that the extension or dimension of the update tensor in the second direction 654 (e.g. a column direction) is smaller than a dimension or extension of the parameter tensor 650 in the second direction.

As shown in Fig 6, an update tensor 660 may, for example, comprise the change values u₁₁, u₁₂, u₂₁ and u₂₂. As shown with extended update tensor 670, optionally, an inventive decoder, e.g. 100, 100b, e.g. deriving unit 130, 130b, may optionally be configured to copy entries of a row of the update tensor 660, to obtain entries of one or more extension rows of a shape-converted update tensor 670, if a number or rows of the update tensor 660 is smaller than a number of rows of the parameter tensor 650.

Alternatively or in addition, the decoder may be configured to copy entries of a column of the update tensor 660, to obtain entries of one or more extension columns of a shape-converted update tensor 670, if a number or columns of the update tensor is smaller than a number of columns of the parameter tensor 650.

As shown in Fig. 6, e.g. as a simplified example, a first row of update tensor 660 may be duplicated to provide a third row of the extended update tensor 670 and a first column of update tensor 660 may be duplicated to provide a third column of the extended update tensor 670.

As optionally, shown an inventive decoder, e.g. 100, e.g. deriving unit 130, 130b, may optionally be configured to copy one or more entries of an update tensor in a row direction and in a column direction, to obtain entries of a shape-converted update tensor 670.

However, it is to be noted that only a row or a column may be copied or that only certain entries of a row and/or a column may be copied.

Accordingly, an inventive encoder, e.g. 200, 300, 300b and/or 400 for example node information unit 210 and/or PUT unit 310, 310b, 410, may optionally be configured to provide the update tensor 660 such that a number of rows of the update tensor is smaller than a number of rows of the parameter tensor 650. Alternatively, or in addition, the encoder may be configured to provide the update tensor 660 such that a number of columns of the update tensor is smaller than a number of columns of the parameter tensor 650.

As another optional feature, an inventive encoder, e.g. 200, 300, 300b and/or 400 for example node information unit 210 and/or PUT unit 310, 310b, 410, may optionally be configured to provide an information about an extension of the update tensor. This information may, for example additionally encoded in a bitstream, e.g. 202, 302 and/or 402. An inventive node information 112, 112b, 212, 312, 312b and/or 412 may optionally comprise such an extension information.

Accordingly, an inventive decoder, e.g. 100, 100b, e.g. deriving unit 130, 130b, may optionally be configured to determine a need to convert the shape of the update tensor, and/or an extent of a conversion of the shape of the update tensor, in dependence on an information about an extension of the update tensor.

As another optional feature, an inventive decoder, e.g. 100, 100b, e.g. obtaining unit 110, 110b, may optionally be configured to determine whether a parent node identifier information, e.g. 114, is present, e.g. in an encoded bitstream 102, and the decoder may be configured to derive one or more neural network parameters, e.g. 104, 104b, according to any embodiment as disclosed herein, if the parent node identifier is present, and furthermore, the decoder may be configured to make the currently considered node the root node if the parent node identifier is not present.

Hence, referring to Fig. 1 and Fig. 1b the parent node identifier information 114 (or respectively the generalized node information 112b) may comprise the information whether a parent node identifier is present or is not present, e.g. instead of or in addition to a parent node identifier (e.g. if present), such that a parameter update tree, for example set up and stored by PUT information unit 120, 120b may be adapted accordingly. This may allow to discard portions of a PUT that may not be needed any more, e.g. because corresponding parameter sets may be outdated or inferior to (e.g. worse than) newer parameter sets. Hence, in simple words, an upper part of a PUT may be discarded, such that the new root node of PUT is the currently considered node. On the other hand, this way a new PUT may be set up, starting from the currently considered node.

Accordingly, an inventive encoder, e.g. 200, 300, 300b and/or 400 for example node information unit 210 and/or PUT unit 310, 310b, 410, may optionally be configured to provide a signaling, comprising an information whether a parent node identifier is present or not. Hence, referring to Figs. 2 to 4, instead of the parent node identifier information 214, 314 and/or 414 may comprise such a signaling, e.g. instead of a parent node identifier, or in addition to a parent node identifier.

As another optional feature, the nodes of a PUT, e.g. nodes R, U0, to U9, 510 to 620, may be associated with a respective hash value. An inventive decoder, e.g. 100, 100b, e.g. PUT information unit 120, 120b, may optionally be configured to compare the parent node identifier (wherein the parent node identifier information 114 (or respectively the generalized node information 112b) may comprise the parent node identifier) with hash values associated with one or more nodes, to identify the parent node of the currently considered node.

Accordingly, an inventive encoder, e.g. 200, 300, 300b and/or 400 for example node information unit 210 and/or PUT unit 310, 310b, 410, may optionally be configured provide a hash value associated with a node as the parent node identifier (e.g. within the parent node identifier information 214, 314 and/or 414 or respectively the generalized node information 112b, 312b, for example encoded in the bitstream 202, 302, 302b and/or 402), to identify the parent node of the currently considered node.

Optionally, the hash values may be hash values of a full compressed data unit NDU associated with one or more previously decoded nodes.

As another optional feature, the hash value may be a hash value of a payload portion of a compressed data unit associated with one or more previously encoded nodes, while leaving a data size information and a header information unconsidered.

As another optional feature, the parent node identifier may be a combined value representing a device identifier and a serial number of which both are associated with the parent node.

As another optional feature, parent node identifier may identify an update tree, e.g. 500, and/or a layer of the neural net. A PUT may, for example, represent a portion of neural network parameters of a neural network. Hence, for a neural network a plurality of update trees may be set up, such that a differentiation in between trees may be advantageous. As an example, a PUT may represent one layer of a neural network.

As another optional feature, the node information, e.g. 112, 112b, 212, 312, 312b and/or 412 may comprise a node identifier. An inventive decoder, e.g. 100, 100b, e.g. PUT information unit 120, 120b, may optionally be configured to store the node identifier. Accordingly, an inventive encoder, e.g. 200, 300, 300b and/or 400 for example node information unit 210 and/or PUT unit 310, 310b, 410, may optionally be configured to store and/or to provide the node identifier.

As another optional feature, an inventive decoder, e.g. 100, 100b, e.g. PUT information unit 120, 120b, may optionally be configured to compare one or more stored node identifiers with a parent node identifier in a node information of a new node when adding the new node, in order to identify a parent node of the new node.

Accordingly, an inventive encoder, e.g. 200, 300, 300b and/or 400 for example node information unit 210 and/or PUT unit 310, 310b, 410, may optionally be configured to compare one or more stored node identifiers with a parent node identifier in a node information of a new node when adding the new node, in order to identify a parent node of the new node.

As another optional feature, the node identifier may identify an update tree, e.g. 500, to which the node information, e.g. 112, 112b, 212, 312, 312b and/or 412 is associated and/or a layer of the neural net to which the node information relates. Neural networks may comprise millions of parameters, hence only a selection of parameters may be organized in one single parameter tree. Furthermore, a searching time for an encoder or decoder may be reduced using an information about with which neural network layer, neural network parameters to be searched for, e.g. as parameters associated with a parent node, are associated.

As another optional feature, the node identifier, e.g. within node identifier information 114, 214, 314, 414 and respectively generalized node information 112b, 312b, may comprise a device identifier and/or a parameter update tree depth information and/or a parameter update tree identifier. One neural network may be trained on different devices, such that different sets of parameters may be available and for example even different iterations of such sets of parameters. Hence, an information about a device identifier, may allow to indicate a specific set of neural network parameters efficiently. A PUT depth information may reduce a time needed, for example, to find a corresponding parent node, in order to determine neural network parameters of a currently considered node, since it may not be necessary to search through all layers of the PUT.

As another optional feature, the node information, e.g. 112, 112b, 212, 312, 312b and/or 412, may comprise a signaling indicating whether a node identifier is present or not.

As another optional feature, the parent node identifier (e.g. within the parent node identifier information 114, 214, 314 and/or 414 and respectively generalized node information 112b, 312b, for example encoded in the bitstream 202, 302 and/or 402) is a combined value representing a device identifier and a serial number which both are associated with the parent node.

As another optional feature, the parent node identifier information 114, 214, 314 and/or 414 and respectively generalized node information 112b, 312b, may optionally comprise an information about the type of the parent node identifier. Hence, an inventive decoder, e.g. 100, 100b, e.g. obtaining unit 110, 110b, may optionally be configured to obtain a signaling, comprising an information about the type of the parent node identifier, and the decoder may be configured to evaluate the signaling in order to consider the respective type of the parent node identifier.

Accordingly, an inventive encoder, e.g. 200, 300, 300b and/or 400 for example node information unit 210 and/or PUT unit 310, 310b, 410, may optionally be configured to provide a signaling, comprising an information about the type of the parent node identifier.

As another optional feature, an inventive decoder, e.g. 100, 100b, e.g. PUT information unit 120, 120b, may optionally be configured to selectively evaluate a syntax element which indicates a type of the parent node identifier, in dependence on a syntax element indicating the presence of the parent node identifier.

Accordingly, an inventive encoder, e.g. 200, 300, 300b and/or 400 for example node information unit 210 and/or PUT unit 310, 310b, 410, may optionally be configured to selectively provide a syntax element which indicates a type of the parent node identifier, if a syntax element describing the parent node identifier is present.

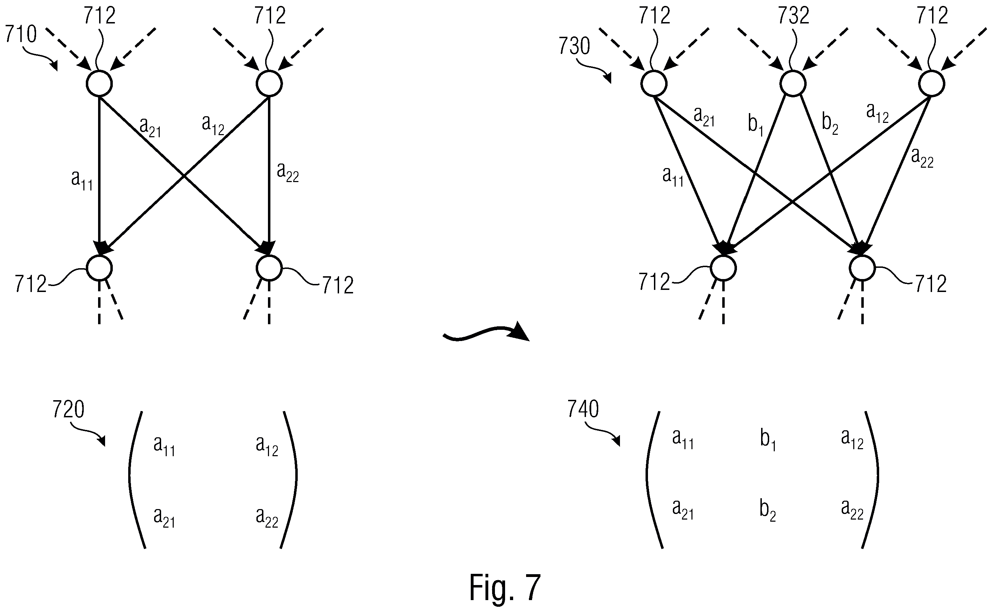

Fig. 7 shows an example for a topology change of a neural network according to embodiments of the invention. Fig. 7 shows a first topology 710 of a neural network section with neurons 712, wherein neural network parameters a₁₁, a₁₂, a₂₁ and a₂₂, e.g. weights, may be represented by a parameter tensor 720. As an example, the topology of the neural network section may change to a second topology 730 with a new node 732 and additional parameters b₁ and b₂. The neural network parameters of the neural network with topology 730 may be represented by tensor 740.

As an optional feature, an inventive decoder, e.g. 100, 100b, e.g. obtaining unit 110, 110b, may optionally be configured, to obtain a topology change signaling within the node information, comprising an information about a topology change of the neural network. As an example, the parent node identifier information, e.g. 114, may optionally, comprise the topology change signaling. Furthermore, the decoder may be configured to modify the parameter information of the parent node according to the topology change in order to derive one or more neural network parameters, e.g. as represented by tensor 740, of the neural network with modified topology.

Accordingly, an inventive encoder, e.g. 200, 300, 300b and/or 400 for example node information unit 210 and/or PUT unit 310, 310b, 410, may optionally be configured, to provide a topology change signaling within the node information, e.g. within the parent node identifier information 214, 314 and/or 414, comprising an information about a topology change of the neural network.

As another optional feature, an inventive decoder, e.g. 100, 100b, e.g. the PUT information unit 120, 120b and/or the e.g. deriving unit 130, 130b, may optionally be configured to change a shape of one or two tensors in response to a topology change information. As an example a tensor comprising change values may be adapted to a new shape of a parent node according to the new neural network topology.

Accordingly, an inventive encoder, e.g. 200, 300, 300b and/or 400 for example node information unit 210 and/or PUT unit 310, 310b, 410, may optionally be configured to signal a change a shape of one or two tensors, together with a signaling of a topology change.

As another optional feature, an inventive decoder, e.g. 100, 100b, e.g. PUT information unit 120, 120b, may optionally be configured to change a number of neurons of the given layer in response to the topology change information. As an example, a decoder on a device running the neural network may receive the topology change information and may hence adapt the structure of the neural network, e.g. in addition to adapting neural network parameters, e.g. weight values.

Accordingly, an inventive encoder, e.g. 200, 300, 300b and/or 400 for example node information unit 210 and/or PUT unit 310, 310b, 410, may optionally be configured to signal a change of a number of neurons of the given layer using the topology change information. Such topology change information may be included in a generalized node information, e.g. 312 b.

As another optional feature, an inventive decoder, e.g. 100, 100b, e.g. PUT information unit 120, 120b and/or e.g. deriving unit 130, 130b, may optionally be configured to replace one or more tensor values of one or more tensors, a shape of which is to be changed, associated with a parent node of the currently considered node with one or more replacement values, in order to obtain one or more tensors having a modified size, or the decoder may be configured to replace one or more tensors, a shape of which is to be changed, associated with a parent node of the currently considered node with one or more replacement tensors, in order to obtain one or more tensors having a modified size.

Accordingly, an inventive encoder, e.g. 200, 300, 300b and/or 400 for example node information unit 210 and/or PUT unit 310, 310b, 410, may optionally be configured to signal a replacement of one or more tensor values of one or more tensors, a shape of which is to be changed, associated with a parent node of the currently considered node with one or more replacement values, or the encoder may be configured to signal a replacement of one or more tensors, a shape of which is to be changed, associated with a parent node of the currently considered node with one or more replacement tensors.

As another optional feature, an inventive decoder, e.g. 100, 100b, e.g. deriving unit 130, 130b, may optionally be configured to change shapes of two tensors in two update trees associated with neighboring layers of the neural net in a synchronized manner, in response to the topology change signaling.

Accordingly, an inventive encoder, e.g. 200, 300, 300b and/or 400 for example node information unit 210 and/or PUT unit 310, 310b, 410, may optionally be configured to signal a change of shapes of two tensors in two update trees associated with neighboring layers of the neural net in a synchronized manner, using the topology change signaling.

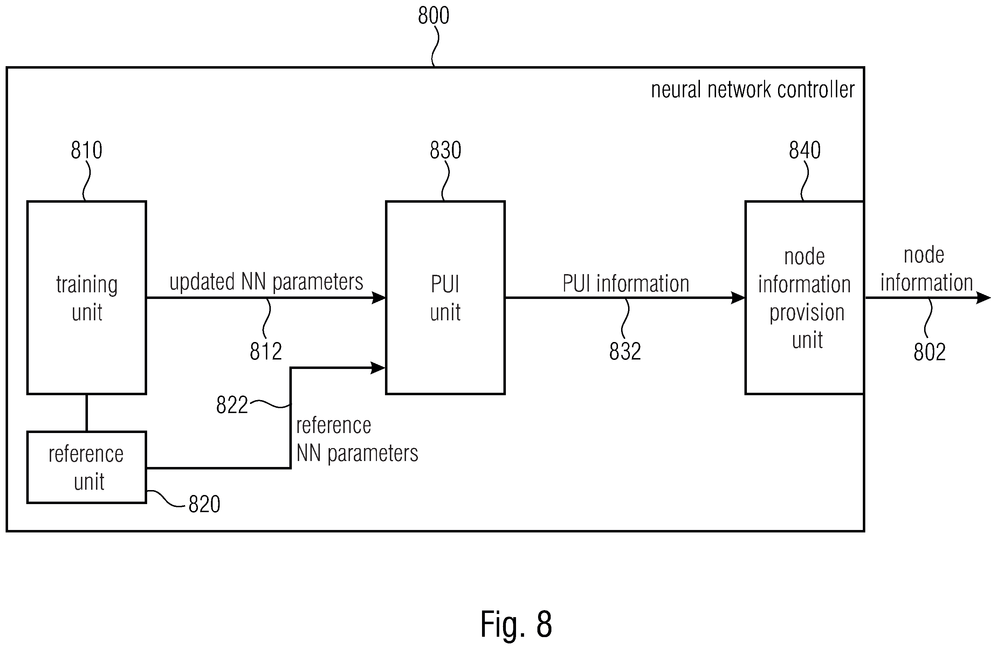

Fig. 8 shows a schematic view of a neural network controller according to embodiments of the invention. Fig. 8 shows a neural network controller 800 comprising a training unit 810, a reference unit 820, a parameter update information, PUI, unit 830 and a node information provision unit 840.

The training unit 810 may be configured to train a neural network, to obtain updated neural network parameters 812 on the basis of initial neural network parameters. As an example, the initial neural network parameters may be default parameters or for example a first set of neural network parameters, starting from which, the neural network may be trained. As an optional feature, the initial neural network parameters may be provided to the training unit 810 using or by the reference unit 820. The initial neural network parameters may be stored in the reference unit 820 or may, for example, initially provided to the neural network controller 800.

As an example, based on the updated neural network parameters a second training may be performed. Hence, the updated neural network parameters may, for example be reference or starting parameters for a second training. Such reference parameters may be stored in the reference unit 820. Therefore, in a first step, reference parameters, e.g. the parameters based on which a training is performed, may be equal to initial neural network parameters.

Furthermore, the PUI unit 830 may be configured to determine a parameter update information, PUI, 832 on the basis of the reference neural network parameters 822 and the updated neural network parameters 812. Therefore, reference unit 820 may provide the reference neural network parameters 822, e.g. the parameters based on which a training was performed in order to obtain the updated neural network, NN, parameters, to the PUI unit 830.

The PUI 832 may, for example, as well comprises one or more update instructions describing how to derive the updated neural network parameters, at least approximately, from the initial neural network parameters.

The reference NN parameters 882 may, for example, be the initial neural network parameters (e.g. even in a second, third, fourth or further training step), such that the parameter update information 832 may comprise an information on how to modify the initial neural network parameters in order to calculate or determine the updated NN parameters 812.

However, such an information may as well be included in the PUI 832, for a recursive reconstruction. Hence, an information on how to modify reference NN parameters 822, e.g. starting parameters for one training cycle, in order to obtain the updated NN parameters 812, that are different form the initial NN parameters, may be included in the PUI.

Referring to Fig. 5, the PUI may hence comprise an information on a whole path from root node R, 510, associated with initial neural network parameters, e.g. 512, to a currently considered node, e.g. U3, 550, associated with the updated NN parameters, e.g. 552, or just about a section of such a path, e.g. via one or more nodes, e.g. from U2, 520, associated with reference parameters, e.g. 522, to node U4, associated with updated NN parameters, e.g. 562. Here it is again to be noted that - in simple words - in between the reference NN parameters 822 and the updated NN parameters one or more trainings and hence one or more parameter updates may be performed.

To put it in other words, the PUI information may optionally comprise an information on how to modify reference NN parameters 822, being an initial or arbitrary or intermediate starting point for a NN training, in order to obtain the updated NN parameters 812.

Furthermore, the node information provision unit 840 may be configured to provide a node information 802 comprising a parent node identifier information(e.g. as explained before) and the parameter update information PUI (e.g. as explained before), wherein the parent node identifier defines a parent note, parameter information of which serves as a starting point for the application of the parameter update information.

Hence, the parent node identifier, may be used to provide a reference information for the PUI information, in order to identify reference NN parameters 822 that are to be modified by the PUI information in order to obtain the updated NN parameters 832

As another optional feature, the neural network controller 800 may comprise an encoder according to any of the embodiments as disclosed herein and/or any functionality, or combination of functionalities, of any inventive encoder as disclosed herein.

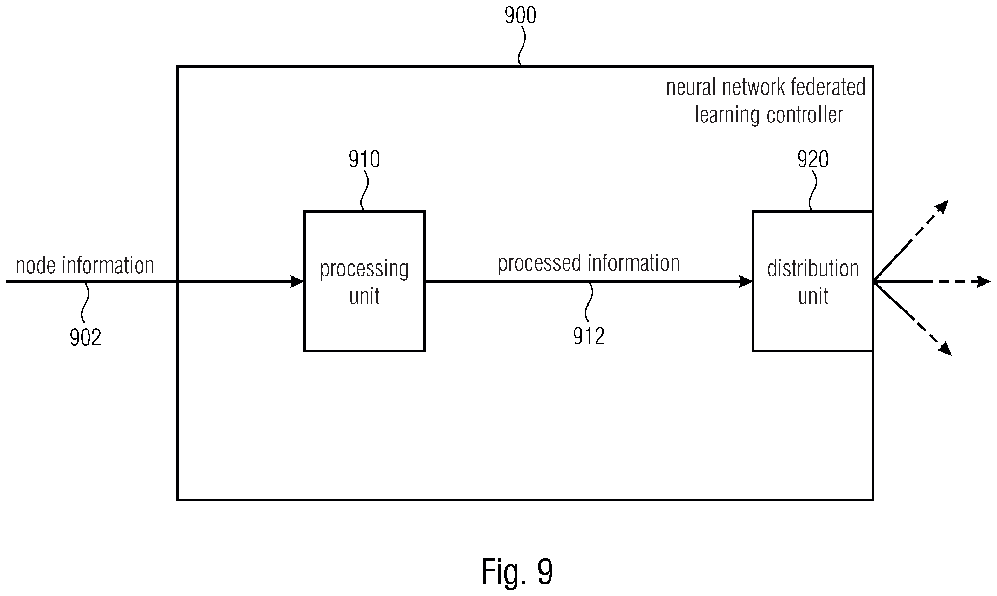

Fig. 9 shows a schematic view of a neural network federated learning controller according to embodiments of the invention. Fig. 9 shows neural network federated learning controller 900 comprising a processing unit 910 and a distribution unit 920.

The neural network federated learning controller 900 is configured to receive a node information 902 of a plurality of neural networks, wherein the node information comprises a parent node identifier (or for example a parent node identifier information comprising the parent node identifier) and a parameter update information.

Furthermore, processing unit 910 is configured to combine parameter update information of several corresponding nodes of different neural networks, to obtain a combined parameter update information. Processed information 912 may comprise or may be the combined parameter update information.

Moreover, distributing unit 920 is configured to distribute the processed information, e.g. the combined parameter update information.

Hence, the neural network federated learning controller 900 may operate as a coordination unit in order to combine several training results (e.g. the parameter update information) of several corresponding nodes of different neural networks. Therefore robust neural network parameters may be extracted and provided in the form of the processed information.

As an optional feature, the neural network federated learning controller 900, e.g. processing unit 910, may be configured to combine parameter update information of several corresponding nodes having equal parent node identifiers of different neural networks, to obtain a combined parameter update information. Hence, processed information 912 may comprise or may be the combined parameter update information.

Therefore, as an example, NN training results based on equal starting parameters may be combined, in order to provide a robust set of NN parameters.

As an optional feature, the neural network federated learning controller 900, e.g. distribution unit 920 may be configured to distribute parameter information of a parent node, to which the parent node identifier is associated, to a plurality of decoders and the neural network federated learning controller 900, e.g. processing unit 912, may be configured to receive from the decoders node information comprising the parent node identifier. Furthermore, the neural network federated learning controller 900, e.g. processing unit 910, is configured to combine parameter update information of several corresponding nodes having the parent node identifier.

As another optional feature, the neural network federated learning controller 900, e.g. distribution unit 920, may, for example, be configured to provide a node information, e.g. within or being the processed information 912, describing a combined node information of a parameter update tree, wherein the combined node information comprises the parent node identifier, and wherein the combined node information comprises the combined parameter update information.

As another optional feature, the neural network federated learning controller 900 may optionally comprise an encoder according to any embodiments disclosed herein or the neural network federated learning controller 900 may optionally comprise any functionality, or combination of functionalities, of an inventive encoder as disclosed herein.

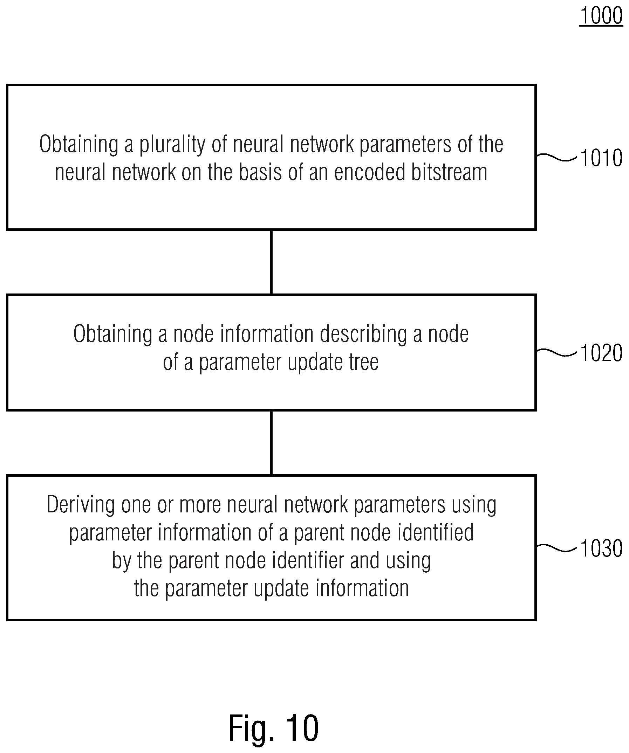

Fig. 10 shows a schematic block diagram of a method for decoding parameters of a neural network according to embodiments of the invention. Method 1000 comprises obtaining 1010 a plurality of neural network parameters of the neural network on the basis of an encoded bitstream, obtaining 1020 a node information describing a node of a parameter update tree, wherein the node information comprises a parent node identifier, and wherein the node information comprises a parameter update information, and deriving 1030 one or more neural network parameters using parameter information of a parent node identified by the parent node identifier and using the parameter update information.

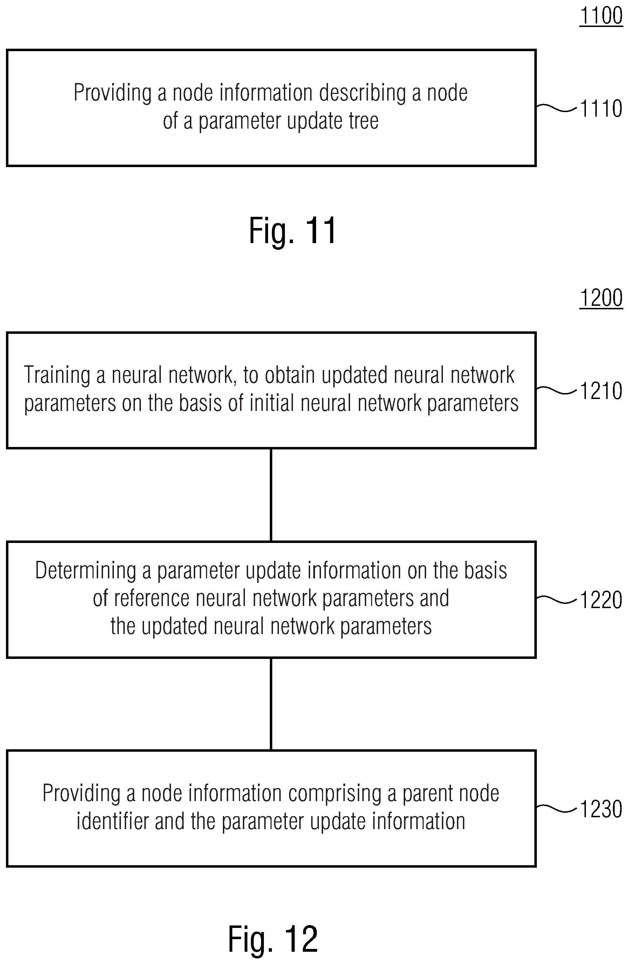

Fig. 11 shows a schematic block diagram of a method for encoding parameters of a neural network in order to obtain an encoded bitstream according to embodiments of the invention. Fig. 11 shows method 1100 comprising providing 1110 a node information describing a node of a parameter update tree, wherein the node information comprises a parent node identifier, and wherein the node information comprises a parameter update information; wherein the parameter update information describes differences between neural network parameters associated with a parent node defined by the parent node identifier and current neural network parameters.

Fig. 12 shows a schematic block diagram of a method for controlling a neural network according to embodiments of the invention. Fig. 12 shows method 1200 comprising training 1210 a neural network, to obtain updated neural network parameters on the basis of initial neural network parameters, and determining 1220 a parameter update information on the basis of reference neural network parameters and the updated neural network parameters, wherein the parameter update information comprises one or more update instructions describing how to derive the updated neural network parameters, at least approximately, from the initial neural network parameters, and providing 1230 a node information comprising a parent node identifier and the parameter update information, wherein the parent node identifier defines a parent note, parameter information of which serves as a starting point for the application of the parameter update information.

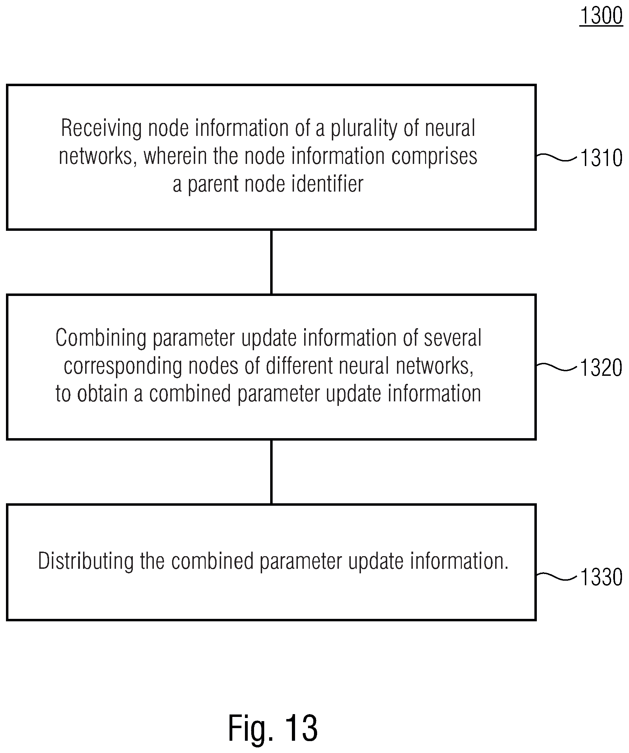

Fig. 13 shows a schematic block diagram of a method for controlling neural network federated learning according to embodiments of the invention. Fig. 13 shows method 1300 comprising receiving 1310 node information of a plurality of neural networks, wherein the node information comprises a parent node identifier, and wherein the node information comprises a parameter update information. The method further comprises combining 1320 parameter update information of several corresponding nodes of different neural networks, to obtain a combined parameter update information, and distributing 1330 the combined parameter update information.

Further embodiments according to the invention are related to, or may be used for, or may address HLS (e.g. HTTP (e.g. Hypertext Transfer Protocol) live streaming) update signaling.

Furthermore, it is to be noted that embodiments can be applied to the compression of entire neural networks, and some of them can also be applied to the compression of differential updates of neural networks with respect to a base network. Such differential updates are for example useful when models are redistributed after fine-tuning or transfer learning, or when providing versions of a neural network with different compression ratios.

Embodiments may further address usage, e.g. manipulation or modification of base neural network, e g. neural network serving as reference for a differential update.

Embodiments may further address or comprise or provide updated neural network, e.g. neural network resulting from modifying the base neural network. Note: The updated neural network may, for example, be reconstructed by applying a differential update to the base neural network.

Further embodiments according to the invention may comprise syntax elements in the form of NNR units. A NNR unit may, for example be a data structure for carrying neural network data and/or related metadata which may be compressed or represented, e.g. according to embodiments of the invention.

NNR units may carry at least one of a compressed information about neural network metadata, uncompressed information about neural network metadata, topology information, complete or partial layer data, filters, kernels, biases, quantized weights, tensors and alike.

An NNR unit may, for example comprise, or consist of the following data elements
- NNR unit size (optional): This data element may signal the total byte size of the NNR Unit, including the NNR unit size.
- NNR unit header: This data element may comprise or contain information about the NNR unit type and/or related metadata.
- NNR unit payload: This data element may comprise or contain compressed or uncompressed data related to the neural network.

As an example, embodiments may comprise (or use) the following bitstream syntax:

| | |
|---|---|
| nnr_unit( numBytesInNNRUnit ) { | **Descriptor** |
| nnr_unit_size( ) (optional) | |
| nnr_unit_header( ) | |
| nnr_unit_payload( ) | |
| } | |

| | |
|---|---|
| nnr_unit_header( ) { | **Descriptor** |
| **nnr_unit_type** | u(6) |
| **nnr_compressed_data_unit_payload_type** | u(5) |
| ⋮ | |
| further optional configuration information | |
| ⋮ | |
| if( nnr_unit_type == NNR_NDU ) | |
| nnr_compressed_data_unit_header( ) | |
| ⋮ | |
| further optional configuration information | |
| ⋮ | |
| } | |

| | |
|---|---|
| nnr_compressed_data_unit_header( ) { | **Descriptor** |
| **nnr_compressed_data_unit_payload_type** | u(5) |
| ⋮ | |
| Further optional configuration information | |
| ⋮ | |
| **node_id_present_flag** | u(1) |
| if( node_id_present_flag ) { | |
| **device_id** | ue(1) |
| **parameter_id** | ue(5) |
| **put_node_depth** | ue(4) |
| } | |
| **parent_node_id_present_flag** | u(1) |
| if( parent_node_id_present_flag ) { | |
| **parent_node_id_type** | u(2) |
| **temporal_context_modeling_flag** | u(1) |
| if( parent_node_id_type == ICNN_NDU_ID ) { | |
| **parent_device_id** | ue(1) |
| if( !node_id_present_flag ) { | |
| **parameter_id** | ue(5) |
| **put_node_depth** | ue(4) |
| } | |
| } else if( parent_node_id_type == ICNN_NDU_PL_SHA256 ) | |
| **parent_node_payload_sha256** | u(256) |
| else | |
| **parent_node_payload_sha512** | u(512) |
| } | |
| ⋮ | |
| further optional configuration information | |
| ⋮ | |
| } | |

The parent node identifier, may for example comprise one or more of the above syntax elements, to name some, e.g. device_id, parameter_id and/or put_node_depth.

| | |
|---|---|
| nnr_unit_payload( ) { | **Descriptor** |
| ⋮ | |
| further optional configuration information | |
| ⋮ | |
| if( nnr_unit_type == NNR_NDU ) | |
| nnr_compressed_data_unit_payload( ) | |
| ⋮ | |
| further optional configuration information | |
| ⋮ | |
| } | |

| | |
|---|---|
| nnr_compressed_data_unit_payload( ) { | **Descriptor** |
| if( nnr_compressed_data_unit_payload_type == NNR_PT_ RAW_FLOAT ) | |
| for( i = 0; i < Prod( TensorDimensions ); i++ ) | |
| **raw_float32_parameter**[ TensorIndex( TensorDimensions, i , 0 ) ] | flt(32) |
| decode_compressed_data_unit_payload( ) | |
| } | |

Using the decode_compressed_data_unit_payload( ) parameters of a base model of the neural network may be modified in order to obtain an updated model. Hence, using the above nnr_compressed_data_unit_payload() one or more neural network parameters using parameter information of a parent node identified by the parent node identifier and using the parameter update information may be derived.
**node_id_present_flag** equal to 1 may indicate that syntax elements device_id, parameter_id, and/or put_node_depth are present.
**device_id** may, for example, uniquely identify the device that generated the current NDU.
**parameter_id** may, for example, uniquely identify the parameter of the model to which the tensors stored in the NDU relate to. If parent_node_id_type is equal to ICNN_NDU_ID, parameter_id may, for example, or shall equal the parameter_id of the associated parent NDU.
**put_node_depth** may, for example, be the tree depth at which the current NDU is located. A depth of 0 may correspond to the root node. If parent_node_id_type is equal to ICNN_NDU_ID, put_node_depth - 1 may, for example, be or even must equal the put_node_depth of the associated parent NDU.
**parent_node_id_present_flag** equal to 1 may, for example, indicate that syntax element parent_node_id_type is present.
**parent_node_id_type** may, for example, specify the parent node id type. It may indicate which further syntax elements for uniquely identifying the parent node are present. Examples for the allowed values for parent_node_id_type are defined in Table 1

**Table 1: Parent node id type identifiers (example).**

| **parent_node_id_type** | **Identifier** | **Description** |
|---|---|---|
| 0 | ICNN_NDU_ID | Indicates that syntax elements parent_device_id, parameter_id, and put_node_depth are present |
| 1 | ICNN_NDU_PL_SHA256 | Indicates that syntax element parent_node_payload_sha256 is present |
| 2 | ICNN_NDU_PL_SHA512 | Indicates that syntax element parent_node_payload_sha512 is present |
| 3 | | Reserved |

**temporal_context_modeling_flag** may, for example, specify whether temporal context modeling is enabled. A temporal_context_modeling_flag equal to 1 may indicate that temporal context modeling is enabled. If temporal_context_modeling_flag is not present, it is inferred to be 0.

**parent_device_id** may, for example, be equal to syntax element device_id of the parent NDU.

**parent_node_payload_sha256** may, for example, be a SHA256 hash of the nnr_compressed_data_unit_payload of the parent NDU.

**parent_node_payload_sha512** may, for example, be a SHA512 hash of the nnr_compressed_data_unit_payload of the parent NDU.

Furthermore, embodiments according to the invention may comprise a row skipping feature. As an example, if enabled by flag row_skip_flag_enabled_flag, the row skipping technique signals one flag row_skip_list[ i ] for each value i along the first axis of the parameter tensor. If the flag row_skip_list[ i ] is 1, all elements of the parameter tensor for which the index for the first axis equals i are set to zero. If the flag row_skip_list[ i ] is 0, all elements of the parameter tensor for which the index for the first axis equals i are encoded individually.

Furthermore, embodiments according to the invention may comprise a context modelling. As an example, context modelling may correspond to associating the three type of flags sig_flag, sign_flag, and abs_level_greater_x/x2 with context models. In this way, flags with similar statistical behavior may be or should be associated with the same context model so that the probability estimator (inside of the context model) can, for example, adapt to the underlying statistics.

The context modelling of the presented approach may, for example, be as follows:
For example, twenty-four context models may be distinguished for the sig_flag, depending on the state value and whether the neighbouring quantized parameter level to the left is zero, smaller, or larger than zero.

If dq_flag is 0, only the first three context models may, for example, be used.

Three other context models may, for example, be distinguished for the sign_flag depending on whether the neighbouring quantized parameter level to the left is zero, smaller, or larger than zero.

For the abs_level_greater_x/x2 flags, each x may, for example, be use either one or two separate context models. If x <= maxNumNoRemMinus1, two context models are distinguished depending on the sign_flag. If x > maxNumNoRemMinus1, only one context model may, for example, be used.

Furthermore, embodiments according to the invention may comprise temporal context modelling. As an example, if enabled by flag temporal_context_modeling_flag, additional context model sets for flags sig_flag, sign_flag and abs_level_greater_x may be available. The derivation of ctxIdx may then be also based on the value of a quantized co-located parameter level in the previously encoded parameter update tensor, which can, for example, be uniquely identified by the parameter update tree. If the co-located parameter level is not available or equal to zero, the context modeling, e.g. as explained before, may be applied. Otherwise, if the co-located parameter level is not equal to zero, the temporal context modeling of the presented approach may be as follows:
Sixteen context models may, for example, be distinguished for the sig_flag, depending on the state value and whether the absolute value of the quantized co-located parameter level is greater than one or not.

If dq_flag is 0, only the first two additional context models may be used.

Two more context models may, for example, be distinguished for the sign_flag depending on whether the quantized co-located parameter level is smaller or greater than zero.

For the abs_level_greater_x flags, each x may use two separate context models. These two context models may, for example, be distinguished depending on whether the absolute value of the quantized co-located parameter level is greater or equal to x-1 or not.

Embodiments according to the invention may optionally comprise the following tensor syntax, e.g. a quantized tensor syntax.

| | |
|---|---|
| quant_tensor( dimensions, maxNumNoRemMinus1, entryPointOffset ) { | **Descriptor** |
| tensor2DHeight = dimensions[ 0 ] | |
| tensor2DWidth = Prod( dimensions ) / tensor2DHeight | |
| if( general_profile_idc == 1 && tensor2DWidth > 1 ) { | |
| **row_skip_enabled_flag** | uae(1) |
| if( row_skip_enabled_flag ) | |
| for( i = 0; i < tensor2DHeight; i++ ) | |
| **row_skip_list**[ i ] (optional) | ae(v) |
| } | |
| stateId = 0 (optional) | |
| bitPointer = get_bit_pointer( ) (optional) | |
| lastOffset = 0 (optional) | |
| for( i = 0; i < Prod( dimensions ); i++ ) { | |
| idx = TensorIndex( dimensions, i, scan_order ) (optional) | |
| if( entryPointOffset != -1 && | |
| GetEntryPointIdx( dimensions, i, scan_order ) != -1 && | |
| scan_order > 0 ) { (optional) | |
| IvlCurrRange = 256 (optional) | |
| j = entryPointOffset + | |
| GetEntryPointIdx( dimensions, i, scan_order ) (optional) | |
| IvlOffset = cabac_offset_list[ j ] (optional) | |
| if( dq_flag ) (optional) | |
| stateId = dq_state_list[ j ] (optional) | |
| set_bit_pointer( bitPointer + lastOffset + BitOffsetList[ j ] ) (optional) | |
| lastOffset = BitOffsetList[ j ] (optional) | |
| init_prob_est_param( ) (optional) | |
| } | |
| QuantParam[ idx ] = 0 | |
| if( general_profile_idc != 1 \|\| tensor2DWidth <= 1 \|\| | |
| !row_skip_enabled_flag \|\| | |
| !row_skip_list[ idx[ 0 ] ] ) | |
| int_param( idx, maxNumNoRemMinus1, stateId ) (optional) | e.g. as explained in the following |
| ⋮ | |
| further optional configuration information | |
| ⋮ | |
| } | |
| } | |

The skip information may, for example, comprise any or all of the above row skip information e.g. row_skip_enabled_flag and/or row_skip_list.

As an example, row_skip_enabled_flag may specify whether row skipping is enabled. A row_skip_enabled_flag equal to 1 may indicate that row skipping is enabled.

row_skip_list may specify a list of flags where the i-th flag row_skip_lsit[i] may indicate whether all tensor elements of QuantParam for which the index for the first dimension equals i are zero. If row_skip_list[i] is equal to 1, all tensor elements of QuantParam for which the index for the first dimension equals i may be zero.

Embodiments according to the invention may, for example, further comprise a quantized parameter syntax, as an example a syntax as defined in the following. All elements may be considered as optional.

| | |
|---|---|
| int_param( i, maxNumNoRemMinus1, stateId ) { | **Descriptor** |
| | |
| **sig_flag** | ae(v) |
| if( sig_flag ) { | |
| QuantParam[ i ]++ | |
| **sign_flag** | ae(v) |
| j = -1 | |
| do { | |
| j++ | |
| **abs_level_greater_x**[ j ] | ae(v) |
| QuantParam[ i ] += abs_level_greater_x[ j ] | |
| } while( abs_level_greater_x[ j ] == 1 && j < maxNumNoRemMinus1 ) | |
| if( abs_level_greater_x[ j ] == 1 ) { | |
| RemBits = 0 | |
| j = -1 | |
| do { | |
| j++ | |
| **abs_level_greater_x2**[ j ] | ae(v) |
| if( abs_level_greater_x2[ j ] ) { | |
| QuantParam[i] += 1 << RemBits | |
| RemBits++ | |
| } | |
| } while( abs_level_greater_x2[ j ] && j < 30 ) | |
| **abs_remainder** | uae(RemBits) |
| QuantParam[ i ] += abs_remainder | |
| } | |
| QuantParam[ i ] = sign_flag ? -QuantParam[ i ] : QuantParam[ i ] | |
| } | |
| } | |

sig_flag may, for example, specify whether the quantized weight QuantParam[i] is nonzero. A sig_flag equal to 0 may, for example, indicate that QuantParam[i] is zero. sign_flag may, for example, specify whether the quantized weight QuantParam[i] is positive or negative. A sign_flag equal to 1 may, for example, indicate that QuantParam[i] is negative. abs_level_greater_x[j] may, for example, indicate whether the absolute level of QuantParam[i] is greater j + 1.

abs_level_greater_x2[j] may, for example, comprise the unary part of the exponential Golomb remainder.

abs_remainder may, for example, indicate a fixed length remainder.

Further embodiments according to the invention may, for example, comprise the following shift parameter indices syntax. All elements may be considered as optional.

| | |
|---|---|
| shift_parameter_ids( maxNumNoRemMinus1 ) { | **Descriptor** |
| for( i = 0; i < (dq_flag ? 24 : 3; i++ ) { | |
| shift_idx( i, ShiftParameterIdsSigFlag ) | |
| } | |
| if(temporal_context_modeling_flag){ | |
| for( i = 24; i < (dq_flag ? 40 : 26); i++ ) { | |
| shift_idx( i, ShiftParameterIdsSignFlag ) | |
| } | |
| } | |
| for( i = 0; i < ( temporal_context_modeling_flag ? 5:3 ); i++ ) { | |
| shift_idx( i, ShiftParameterIdsSignFlag ) | |
| } | |
| for( i = 0; i < (temporal_context_modeling_flag ? 4 : 2)*(maxNumNoRemMinus1+1); i++ ) { | |
| shift_idx( i, ShiftParameterIdsAbsGrX ) | |
| } | |
| for( i = 0; i < 31; i++ ) { | |
| shift_idx( i, ShiftParameterIdsAbsGrX2 ) | |
| } | |
| } | |

Further embodiments according to the invention comprise entropy decoding processes, as explained in the following.

In general inputs to this process may, for example, be a request for a value of a syntax element and values of prior parsed syntax elements.

Output of this process may, for example be the value of the syntax element.

The parsing of syntax elements may, for example, proceed as follows:
For each requested value of a syntax element a binarization may, for example, bederived.

The binarization for the syntax element and the sequence of parsed bins may, for example, determine the decoding process flow.

Example for Initialization process:
In general, outputs of this process may, for example, be initialized DeepCABAC internal variables.

The context variables of the arithmetic decoding engine may, for example, be initialized as follows:

The decoding engine may, for example, register IvlCurrRange and IvlOffset both in 16 bit register precision may, for example, be initialized by invoking the initialization process for the arithmetic decoding engine.

Embodiments according to the invention may comprise an initialization process for probability estimation parameters, e.g. as explained in the following.

Outputs of this process may, for example, be the initialized probability estimation parameters shift0, shift1, pStateIdx0, and pStateIdx1 for each context model of syntax elements sig_flag, sign_flag, abs_level_greater_x, and abs_level_greater_x2.

The 2D array CtxParameterList [][] may, for example, beinitialized as follows: 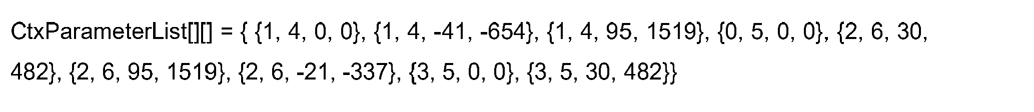 CtxParameterList[][] = { {1, 4, 0, 0}, {1, 4, -41, -654}, {1, 4, 95, 1519}, {0, 5, 0, 0}, {2, 6, 30, 482}, {2, 6, 95, 1519}, {2, 6, -21, -337}, {3, 5, 0, 0}, {3, 5, 30, 482}}

If dq_flag is equal to 1 and temporal_context_modeling_flag is equal to 1, for each of the e.g. 40 context models of syntax element sig_flag, the associated context parameter shift0 may, for example, beset to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsSigFlag[i].

If dq_flag == is equal to 1 and temporal_context_modeling_flag is equal to 0, e.g. for each of the first e.g. 24 context models of syntax element sig_flag, the associated context parameter shift0 may, for example, be set to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsSigFlag[i].

If dq_flag is equal to 0 and temporal_context_modeling_flag is equal to 1, e.g. for each of the e.g. first 3 context models and e.g. context models 24 to 25 of syntax element sig_flag, the associated context parameter shift0 may, for example, be set to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsSigFlag [i].

If temporal_context_modeling_flag is equal to 1, e.g. for each of the for example 5 context models of syntax element sign_flag, the associated context parameter shift0 may, for example, be set to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsSignFlag[i].

Otherwise, (temporal_context_modeling_flag == 0), e.g. for each of the first e.g. 3 context models of syntax element sign_flag, the associated context parameter shift0 may, for example, be set to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsSignFlag[i].

If temporal_context_modeling_flag is equal to 1, e.g. for each of the 4 * (cabac_unary_length_minus1 + 1) context models of syntax element abs_level_greater_x, the associated context parameter shift0 may, for example, be set to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsAbsGrX[i].

Otherwise, (temporal_context_modeling_flag == 0), e.g. for each of the first e.g. 2 * (cabac_unary_length_minus1 + 1) context models of syntax element abs_level_greater_x, the associated context parameter shift0 may, for example, be set to CtxParameterList[setId][0], shift1 may, for example, be set to CtxParameterList[setId][1], pStateIdx0 may, for example, be set to CtxParameterList[setId][2], and pStateIdx1 may, for example, be set to CtxParameterList[setId][3], where i may, for example, be the index of the context model and where setId may, for example, be equal to ShiftParameterIdsAbsGrX[i].

Further embodiments according to the invention may comprise a decoding process flow, e.g. as explained in the following.

In general, inputs to this process may, for example, be all bin strings of the binarization of the requested syntax element.

Output of this process may, for example, be the value of the syntax element.

This process may specify how e.g. each bin of a bin string is parsed e.g. for each syntax element. After parsing e.g. each bin, the resulting bin string may, for example, be compared to e.g. all bin strings of the binarization of the syntax element and the following may apply:
- If the bin string is equal to one of the bin strings, the corresponding value of the syntax element may, for example, be the output.
- Otherwise (the bin string is not equal to one of the bin strings), the next bit may, for example, be parsed.

While parsing each bin, the variable binIdx may, for example, be incremented by 1 starting with binIdx being set equal to 0 for the first bin.

The parsing of each bin may, for example, be specified by the following two ordered steps:
1. A derivation process for ctxIdx and bypassFlag as may, for example, be invoked e.g. with binIdx as input and ctxIdx and bypassFlag as outputs.
2. An arithmetic decoding process may, for example, be invoked with ctxIdx and bypassFlag as inputs and the value of the bin as output.

Further embodiments according to the invention may comprise a derivation process of ctxInc for the syntax element sig_flag.

Inputs to this process may, for example, be the sig_flag decoded before the current sig_flag, the state value stateId, the associated sign_flag, if present, and, if present, the co-located parameter level (coLocParam) from the incremental update decoded before the current incremental update. If no sig_flag was decoded before the current sig_flag, it may, for example, be inferred to be 0. If no sign_flag associated with the previously decoded sig_flag was decoded, it may, for example, be inferred to be 0. If no co-located parameter level from an incremental update decoded before the current incremental update is avaiable, it is inferred to be 0. A co-located parameter level means the parameter level in the same tensor at the same position in previously decoded incremental update.

Output of this process is the variable ctxInc.

The variable ctxInc is derived as follows:
- If coLocParam is equal to 0 the following applies:
- If sig_flag is equal to 0, ctxInc is set to stateId*3.
- Otherwise, if sign_flag is equal to 0, ctxInc is set to stateId*3+1.
- Otherwise, ctxInc is set to stateId*3+2.
- If coLocParam is not equal to 0 the following applies:
- If coLocParam is greater than 1 or less than -1, ctxInc is set to stateId*2+24.
- Otherwise, ctxInc is set to stateId*2+25.
-

Further embodiments according to the invention may comprise a derivation process of ctxInc for the syntax element sign_flag.

Inputs to this process may, for example, be the sig_flag decoded before the current sig_flag, the associated sign_flag, if present, and, if present, the co-located parameter level (coLocParam) from the incremental update decoded before the current incremental update. If no sig_flag was decoded before the current sig_flag, it may, for example, be inferred to be 0. If no sign_flag associated with the previously decoded sig_flag was decoded, it may, for example, be inferred to be 0. If no co-located parameter level from an incremental update decoded before the current incremental update is avaiable, it may, for example, be inferred to be 0. A co-located parameter level means the parameter level in the same tensor at the same position in previously decoded incremental update.

Output of this process may, for example, be the variable ctxInc.

The variable ctxInc may, for example, be derived as follows:
- If coLocParam is equal to 0 the following may apply:
- If sig_flag is equal to 0, ctxInc may, for example, be set to 0.
- Otherwise, if sign_flag is equal to 0, ctxInc may, for example, be set to 1.
- Otherwise, ctxInc may, for example, be set to 2.
- If coLocParam is not equal to 0 the following may apply:
- If coLocParam is less than 0, ctxInc may, for example, be set to 3.
- Otherwise, ctxInc may, for example, be set to 4.

Further embodiments may comprise a derivation process of ctxInc for the syntax element abs_level_greater_x[j]
Inputs to this process may, for example, be the sign_flag decoded before the current syntax element abs_level_greater_x[j] and, if present, the co-located parameter level (coLocParam) from the incremental update decoded before the current incremental update. If no co-located parameter level from an incremental update decoded before the current incremental update is available, it may, for example, be inferred to be 0. A co-located parameter level means the parameter level in the same tensor at the same position in previously decoded incremental update.

Output of this process may, for example, be the variable ctxInc.

The variable ctxInc may, for example, be derived as follows:
- If coLocParam is equal to zero the following may apply:
- If sign_flag is equal to 0, ctxInc may, for example, be set to 2*j.
- Otherwise, ctxInc may, for example, be set to 2*j+1.
- If coLocParam is not equal to zero the following may apply:
- If coLocParam is greater or equal to j or is lower or equal to -j, ctxInc may, for example, be set to 2*j+2* maxNumNoRemMinus1
- Otherwise, ctxInc may, for example, be set to 2*j + 2* macNumNoRemMinus1 +1.

Further remarks:
In the following, different inventive embodiments and aspects will be described in a chapter "Introduction", and in a chapter "Parameter update tree (PUT) (example)" and their respective subchapters.

Also, further embodiments will be defined by the enclosed claims.

It should be noted that any embodiments as defined by the claims can be supplemented by any of the details (features and functionalities) described in the above mentioned chapters and/or subchapters respectively and/or by any of the details (features and functionalities) described in the above disclosure.

Also, the embodiments described in the above mentioned chapters and/or subchapters can be used individually, and can also be supplemented by any of the features in another chapter, or by any feature included in the claims.

Also, it should be noted that individual aspects described herein can be used individually or in combination. Thus, details can be added to each of said individual aspects without adding details to another one of said aspects.

It should also be noted that the present disclosure describes, explicitly or implicitly, features usable in a neural network encoder (apparatus for providing an encoded representation of neural network parameters) and in a neural network decoder (apparatus for providing a decoded representation of neural network parameters on the basis of an encoded representation). Thus, any of the features described herein can be used in the context of a neural network encoder and in the context of a neural network decoder.

Moreover, features and functionalities disclosed herein relating to a method can also be used in an apparatus (configured to perform such functionality). Furthermore, any features and functionalities disclosed herein with respect to an apparatus can also be used in a corresponding method. In other words, the methods disclosed herein can be supplemented by any of the features and functionalities described with respect to the apparatuses.

Also, any of the features and functionalities described herein can be implemented in hardware or in software, or using a combination of hardware and software, as will be described in the section "implementation alternatives".

The following section (comprising for example subsections or chapters 1 to 2) may be titled efficient signaling of neural network updates in distributed scenarios

### 1. Introduction

In the following, background information of embodiments according to the invention is provided. However, features and/or functionalities and/or details and/or aspects explained in this chapter may optionally be incorporated in a plurality of embodiments of the invention, both individually and taken in combination. Embodiments according to the invention may comprise or may be used with said aspects and/or features.

As Neural Networks (NN) have led to break-throughs in many application areas, also efficient transmission mechanisms are developing. This may allow e.g. for carrying out the, for example possible complex, NN training process, for example, in central server devices and optionally may allow to transmit a trained NN e.g. to client devices. Here, neural network compression and representation has been standardized recently. A newer field of applications are federated learning (FL) and training scenarios, where NNs may be trained, for example, on many devices, for example at the same time. In FL scenarios, e.g. frequent communication between client devices and central server devices may be beneficial or even required. Initially, a first version of a pre-trained NN may be sent to all clients, for example, for further training, using e.g. neural network compression. Then, all clients may further train the NN, and may send an updated NN version to one (or more) servers, for example as shown in Figure 14.

Fig. 14 shows a schematic view of an example of federated learning scenario according to embodiments of the invention. Fig. 14 shows a plurality of clients 1410, 1420, 1430, that may be configured to train neural networks. A server 1430 may receive training results, e.g. updates, of respective clients and may, based on the training results, e.g. neural network parameters, provide aggregated updated neural network parameters to the clients.

An update may e.g. be a difference signal between the initial NN and the newer NN version, for example, at the client. Accordingly, one or more, or for example all arrows between server and clients (e.g. in Figure 14) may represent sending an NN update. The server may then collect some or, for example, all local client versions and may aggregate a new server version of the NN. The aggregation process can, for example, be a simple averaging of a plurality or for example all available network version, or a more advanced process, such as, for example, only averaging output labels. This latter method is known as federated distillation and may allow for, for example, much more flexibility, for example, at local clients. This can, for example, even include different networks and/or topologies, for example, at each client, for example, as long as the output labels of all client versions can still be aggregated at a server. The process up to here is also called a communication round (CR). Then, for example, the new server version may be sent again to a plurality or for example all clients, e.g. also as difference signal to a previous NN version, for example, for further training and the process may repeat. The FL scenario may continue for many CRs, e.g. until a certain precision (for inference) is reached. In general, FL scenarios may allow communication flexibility. In a synchronous communication scenario, a plurality or for example all N clients may send updates in each communication round, the server may aggregate the versions or for example the N versions into a new version and may then send this version to the plurality or for example all N clients, for example, for the next CR. In an asynchronous FL scenario, clients may only send updates after a certain number of CRs. Or may send updates for a successive number of CRs and may then pause for a certain time. This may mean that a server may only have a subset K < N client versions at a certain CR, for example, for aggregating a new server version, for example, to be sent to the clients.

Many or for example all these conditions in federated scenarios may require specific signaling, for example, in order to handle the different FL variations, but optionally also, for example, to increase coding efficiency of NN update and/or difference data to be sent between server(s) and clients (e.g. in both directions). Accordingly, the following subsections describe related aspects of the invention.

### 2. Parameter update tree (PUT) (example)

As an example, considering a, for example distributed, scenario according to embodiments with several devices (e.g. including server and client devices) and, for example, a so-called base model, which may be a neural network for which updates shall be or may be transmitted between devices. Embodiments according to this invention comprise and/or describe a scheme for representing such updates, for example, using a tree structure. A plurality or for example each individual parameter (or a group of parameters) of the base model may be associated with the root node of a tree, e.g. the tree having the beforementioned tree structure. An update for such a parameter may correspond to a child node attached to the root node. The child node may contain instructions, for example, on how to update the parameter associated with the parent node. Any node of the tree may further be updated, for example, by attaching child nodes in the same manner. An example is given in Fig. 15 where R is the root node representing one parameter of the base model.

Fig. 15 shows a schematic view of an example of parameter update tree, for example exemplary parameter update tree, according to embodiments of the invention.

Nodes U1 and U2 may describe updates to node R and node U3 may describe an update of node U2. Each node of the tree may represent a version of the parameter of the base model R and one could, for example, decide to execute the model using a particular updated version U1, U2, or U3 instead of R. In other words, according to embodiments a decoder may, for example, be configured to decide to execute the model using a particular updated version U1, U2, or U3 instead of R, for example corresponding to a specific version of neural network parameters.

In order to represent such a tree, a unique node identifier may be associated with a plurality of nodes or for example each node. For example, this could be or may be an integer number, a string, and/or a cryptographic hash (like e.g. SHA-512) associated with the node. However, within such a tree, each node identifier may be unique or for example must even be unique.

In a distributed scenario, a plurality of devices or for example each device (e.g. server or client) may maintain update trees, for example, for the parameters of the model. For example, in order to transmit a particular update from one device to another, for example only, the corresponding update along with the associated node identifier (e.g. a pointer to the parent node of the update) may be transmitted or may need to be transmitted.

In the following an example according to embodiments is disclosed in order to provide a better understanding of aspects of the invention. For example, consider a client and a server that both have node R (e.g. as in Figure 15) available. Assume, the client creates update U2 and wants to make it available to the server. For this it may send U2 along with the node identifier of R to the server. The server may search for the node identifier of R in its version of the tree and may append U2 as a child node of R. Now, server and client may both have a tree available with R as root node and U2 as a child node of R.

### 2.1 Parameter update procedure (example)

This section describes several different types of update instructions, for example, associated with nodes of a PUT according to embodiments of the invention. The parameter of the base model that may be associated with a PUT may be or shall be denoted tree parameter. For example, a so-called node parameter may be or shall be associated with each node of the PUT. However, in other example, a so-called node parameter may or shall be associated with, for example, a set of nodes, e.g. a reachable (e.g. reachable from the root node to a specific current node) set of nodes, or, for example, a set of consecutive nodes, starting from the root node, of the PUT, or, for example, associated with each node of the PUT. This node parameter may be derived by traversing the PUT, for example, from the root node to the desired node and applying the update instructions, for example, of each visited node to the tree parameter. For example (e.g. as in Figure 15), the node parameter of R may equal the tree parameter and the node parameter of U1 may equal the tree parameter, for example, after applying update instructions of U1.

In the case where a node parameter (and, for example, consequently also the tree parameter) is a tensor (i.e., for example, a multi-dimensional arrays of values), it may be or shall be denoted node tensor.

In a preferred embodiment, update instructions, for example, associated with a node may contain a so-called product tensor, for example, of the same shape as the node tensor. Updating the parameter may correspond to an element-wise product, for example, of the node tensor elements and the product tensor elements.

In a preferred embodiment, update instructions, for example, associated with a node may contain at least one of a so-called sum tensor, for example, of the same shape as the node tensor, a scalar node tensor weight value, and/or a scalar sum tensor weight value. Updating the parameter may correspond to an element-wise weighted sum, for example, of the node tensor elements and the sum tensor elements. As an example, or for example more precisely, each element of the node tensor may be multiplied with the node tensor weight value, each element of the sum tensor may be multiplied with the sum tensor weight value, and then, the element-wise sum of both scaled tensors may be calculated. Note that both weights may also be set to 1, which may correspond to a non-weighted sum, for example, as a special case.

In another preferred embodiment, update instructions, for example, associated with a node may contain a so-called replace tensor, for example, of the same shape as the node tensor. Updating the parameter may correspond to replacing the values of the node tensor, for example, with the values of the replace tensor.

In another preferred embodiment, update instructions that employ an update tensor (as for example a replace tensor, a sum tensor, and/or a product tensor) may involve an, for example implicit, tensor shape conversion, for example, as follows.

In the following an example according to embodiments is disclosed in order to provide a better understanding of aspects of the invention.

Assume, the update tensor shape is identical to the node tensor shape except for one or more individual dimensions, which may equal 1. For example, for dimensions of the update tensor that are 1, it may be or shall be assumed that tensor elements along this axis are the same. For example, assume, the node tensor is given as 2D tensor [[a, b, c], [d, e, f]] (dimensions are [2, 3]). An update tensor given as [[x],[y]] (dimensions are [2, 1]) may or would implicitly be extended to [[x, x, x], [y, y, y]]. An update tensor given as [[z]] (dimensions are [1, 1]) may or would implicitly be extended to [[z, z, z], [z, z, z]]. An update tensor given as [[r, s, t]] (dimensions are [1, 3]) may or would implicitly be extended to [[r, s, t], [r, s, t]]. In other words, a decoder according to embodiments may, for example, be configured to update a tensor shape according to the example explained above.
- TBD: quantized-domain updates (check effects of different qps) (optional)

Optionally, quantized domain updates may, for example, be used (e.g. alternatively, or in combination with the above concepts).

### 2.2 Server-side update aggregation example

In a distributed scenario, according to embodiments of the invention, where a server may maintain a base model and, for example, may receive updates from, for example, different clients, the PUT at the server side may collect several update nodes, for example, for the same model. The server may decide to combine several update nodes and may, for example, create a new update node, for example, from this combination and may for example distribute it to the clients, for example, as a collectively updated model. A plurality or for example each node may then decide to continue federated learning, for example, based on this collectively updated model.

### 2.3 Parameter update tree signaling (example)

This section presents methods for representing elements of a PUT, for example, as data units (e.g. byte sequences) e.g. optimized for transmission between devices (e.g. including servers and clients) according to embodiments of the invention. It, for example the methods, may be combined with existing techniques for representing neural networks like, e.g., the emerging standard "ISO/IEC 15938 Part 17: Compression of neural networks for multimedia content description and analysis", which is referred to as NNR throughout this document. NNR may represent individual parameters of a neural network as so-called compressed data units (NDU). Implementing the PUT concept, for example, by using the efficient compression techniques available in NNR can, for example, be carried out as follows. In accord with embodiments of the invention, consider the case where a node contains an update tensor (for example or like a replace tensor, a sum tensor, and/or a product tensor, for example, as described above). Such an update tensor can be, for example efficiently, represented as an NDU. In order to extend an NDU with, for example all necessary, information, for example, so that it can be used as a PUT node, further syntax elements can, for example, be added.

In a preferred embodiment, a new syntax element "parent_node_id_present_flag" may be introduced, for example, into the nnr_compressed_data_unit_header of an NDU, for example indicating whether a parent node identifier is present in the NDU. Depending on the value of parent_node_id_present_flag, a further new syntax element "parent_node_id" may be transmitted that, for example, uniquely identifies another NDU that may contain the parent node of the current PUT node.

In another preferred embodiment, the parent_node_id may be a cryptographic hash (like, e.g., SHA-512) of the parent NDU.

In another preferred embodiment, the parent_node_id may be a cryptographic hash (like, e.g., SHA-512) of the nnr_compressed_data_unit_payload of the parent NDU.

In another preferred embodiment, the parent_node_id may be a combined value representing a device identifier and/or a serial number of which both may, for example, be associated with the parent NDU.

In another preferred embodiment, a new syntax element "node_id" may be encoded in the parent node, to be used as parent_node_id of child nodes of the parent node. node_id may, for example, be a unique identifier.

In another preferred embodiment, syntax element "node_id" (which may, for example, uniquely identify a node) may be composed of a device identifier and/or a parameter update tree depth information (i.e., for example an, information about the number of nodes visited when walking the tree from the current node to the root node) and/or a parameter update tree identifier.

In another preferred embodiment, a flag may be signaled for a node, indicating whether a node_id is present. Depending on the value of this flag, a syntax element node_id may be present or not.

In another preferred embodiment, a new syntax element "parent_node_id_type" may indicate of which type the syntax element parent_node_id is. For example, possible different types of parent_node_id may be as described in the previous preferred embodiments.

In another preferred embodiment, it may depend on the value of syntax element parent_node_id_present_flag whether syntax element parent_node_id_type is signaled or not.

### 2.3.1 Topology change signaling (example)

In a distributed scenario, it may sometimes be of interest to change the topology of a neural network. For example, the number of output neurons of a particular layer may or could be increased or decreased.

In a preferred embodiment, a syntax element "shape_update" may be signaled within an NDU, for example, indicating whether the shape of the tensor associated with the parent node is modified or not. In the case where the parent tensor shape is updated, new tensor dimensions may be transmitted (e.g. using syntax element tensor_dimensions).

In the following, additional embodiments and aspects of the invention will be described which can be used individually or in combination with any of the features and functionalities and details described herein.

A first embodiment relates to a decoder 100, 100b for decoding parameters of a neural network, wherein the decoder is configured to obtain a plurality of neural network parameters 104, 104b, 204, 304, 512, 522, 532, 542, 552, 562, 572, 582, 592, 602 ,612, 622, 652, 720, 740, 812 of the neural network on the basis of an encoded bitstream; wherein the decoder is configured to obtain a node information 112, 112b describing a node of a parameter update tree, wherein the node information comprises a parent node identifier 114, 524, 534, 544, 554, 564, 574, 584, 594, 604, 614, 624, and wherein the node information comprises a parameter update information 116, 526, 536, 546, 556, 566, 576, 586, 596, 606, 616, 626; wherein the decoder is configured to derive one or more neural network parameters 104, 104b, 204, 304, 512, 522, 532, 542, 552, 562, 572, 582, 592, 602 ,612, 622, 652, 720, 740, 812 using parameter information of a parent node identified by the parent node identifier and using the parameter update information.

According to a second embodiment when referring back to the first embodiment, the decoder is configured to modify one or more neural network parameters defined by the parent node, which is identified by the parent node identifier 114, 524, 534, 544, 554, 564, 574, 584, 594, 604, 614, 624, using the parameter update information 116, 526, 536, 546, 556, 566, 576, 586, 596, 606, 616, 626.

According to a third embodiment when referring back to the first or second embodiment, the decoder is configured to set up a parameter update tree 500, wherein a plurality of child nodes comprising different parameter update information 116, 526, 536, 546, 556, 566, 576, 586, 596, 606, 616, 626 are associated with a common parent node 510.

According to a fourth embodiment when referring back to the third embodiment, the decoder is configured to obtain one or more neural network parameters associated with a currently considered node using the parameter update information 116, 526, 536, 546, 556, 566, 576, 586, 596, 606, 616, 626 associated with the currently considered node, using a parameter information 512 associated with a root node 510 and using parameter update information associated with one or more intermediate nodes which are between the root node and the currently considered node in the update tree.

According to a fifth embodiment when referring back to the third or fourth embodiment, the decoder is configured to traverse the parameter update tree 500 from a root node 510 to a currently considered node, and wherein the decoder is configured to apply update instructions of visited nodes to one or more initial neural network parameters, in order to obtain one or more neural network parameters associated with the currently considered node.

According to a sixth embodiment when referring back to any of the third to fifth embodiments, the decoder is configured to aggregate a plurality of consecutive nodes 520, 550 of the parameter update tree and/or one or more consecutive nodes 520, 550 of the parameter update tree and the parameter update information.

According to a seventh embodiment when referring back to any of the third to sixth embodiments, the decoder is configured to update the parameter update tree 500 based on the node information 112, 112b.

According to an eighth embodiment when referring back to any of the first to seventh embodiments, the decoder is configured to decide to choose neural network parameters 512 associated with a root node 510 or to choose neural network parameters associated with one of the descendent nodes of the root node.

According to a ninth embodiment when referring back to any of the first to eighth embodiments, the parameter update information 116, 526, 536, 546, 556, 566, 576, 586, 596, 606, 616, 626 comprises an update instruction 576 defining a scaling of one or more parameter values 532 associated with a parent node 530 of a currently considered node 570; and wherein the decoder is configured to apply a scaling defined by the update instruction 576, in order to obtain one or more neural network parameters 572 associated with the currently considered node.

According to a tenth embodiment when referring back to any of the first to ninth embodiments, a plurality of neural network parameters associated with a currently considered node are represented by a parameter tensor, and the decoder is configured to apply a product tensor 596 to a parameter tensor 542, in order to obtain the parameter tensor 592 associated with the currently considered node.

According to an eleventh embodiment when referring back to any of the first to tenth embodiments, a plurality of neural network parameters associated with a parent node are represented by a parameter tensor, and the parameter update information 116, 526, 536, 546, 556, 566, 576, 586, 596, 606, 616, 626 comprises a product tensor and the decoder is configured to apply the product tensor to the parameter tensor of the parent node, in order to obtain a parameter tensor associated with the currently considered node.

According to a twelfth embodiment when referring back to any of the first to eleventh embodiments, the parameter update information 116, 526, 536, 546, 556, 566, 576, 586, 596, 606, 616, 626 comprises an update instruction 526, 536, 546, 556, 566, 586 defining an addition of one or more change values to one or more parameter values associated with a parent node of a currently considered node and/or a subtraction of one or more change values from one or more parameter values associated with a parent node of a currently considered node; and wherein the decoder is configured to apply an addition or subtraction of the change values defined by the update instruction, in order to obtain one or more neural network parameters 522, 532, 542, 552, 562, 582 associated with the currently considered node.

According to a thirteenth embodiment when referring back to any of the first to twelfth embodiments, the parameter update information 116, 526, 536, 546, 556, 566, 576, 586, 596, 606, 616, 626 comprises an update instruction defining a weighted combination 606 of one or more parameter values 582 associated with a parent node of the currently considered node with one or more change values; and wherein the decoder is configured to apply a weighted combination of one or more parameter values associated with a parent node of the currently considered node with one or more change values, in order to obtain one or more neural network parameters 602 associated with the currently considered node.

According to a fourteenth embodiment when referring back to any of the first to thirteenth embodiments, a plurality of neural network parameters associated with a parent node of the currently considered node are represented by a parameter tensor; and a plurality of neural network parameters associated with a currently considered node are represented by a parameter tensor; and a plurality of change values are represented by a sum tensor; and the decoder is configured to multiply elements of the parameter tensor associated with the parent node of the currently considered node with a node tensor weight value, to obtain a scaled parameter tensor, to multiply elements of the sum tensor with a sum tensor weight value, to obtain a scaled sum tensor, and form an element-wise sum of the scaled parameter tensor and of the scaled sum tensor, in order to obtain the parameter tensor associated with the currently considered node.

According to a fifteenth embodiment when referring back to any of the first to fourteenth embodiments, the parameter update information 116, 526, 536, 546, 556, 566, 576, 586, 596, 606, 616, 626 comprises an update instruction 616 defining a replacement of one or more parameter values associated with a parent node of the currently considered node with one or more change values; and the decoder is configured to replace one or more parameter values associated with a parent node 530 of the currently considered node 610 with one or more replacement values, in order to obtain one or more neural network parameters 612 associated with the currently considered node.

According to a sixteenth embodiment when referring back to any of the first to fifteenth embodiments, a plurality of neural network parameters associated with a parent node of the currently considered node are represented by a parameter tensor; and the parameter update information 116, 526, 536, 546, 556, 566, 576, 586, 596, 606, 616, 626 comprises an update instruction 660 in the form of an update tensor; and the decoder is configured to convert the shape of the update tensor according to the shape of the parameter tensor of the parent node.

According to a seventeenth embodiment when referring back to the sixteenth embodiment, tensor elements of the parameter tensor arranged along a first direction 652 are associated with contributions of output signals of a plurality of neurons 632, 634, 636 of a previous layer 630 of the neural network to an input signal of a given neuron 642 of a currently considered layer 640 of the neural network, and tensor elements of the parameter tensor arranged along a second direction 654 are associated with contributions of an output signal of a given neuron 634 of a previous layer 630 of the neural network to input signals of a plurality of neurons 642, 644, 646 of a currently considered layer 640 of the neural network, and the decoder is configured to extend a dimension of the update tensor in the first direction, if the extension of the update tensor in the first direction is smaller than a dimension of the parameter tensor in the first direction; and/or the decoder is configured to extend a dimension of the update tensor in the second direction, if the extension of the update tensor in the second direction is smaller than a dimension of the parameter tensor in the second direction.

According to an eighteenth embodiment when referring back to the sixteenth or seventeenth embodiment, the decoder is configured to copy entries of a row of the update tensor 660, to obtain entries of one or more extension rows of a shape-converted update tensor 670, if a number or rows of the update tensor is smaller than a number of rows of the parameter tensor; and/or the decoder is configured to copy entries of a column of the update tensor 660, to obtain entries of one or more extension columns of a shape-converted update tensor 670, if a number or columns of the update tensor is smaller than a number of columns of the parameter tensor.

According to a nineteenth embodiment when referring back to any of the sixteenth to eighteenth embodiments, the decoder is configured to copy one or more entries of an update tensor 660 in a row direction and in a column direction, to obtain entries of a shape-converted update tensor 670.

According to a twentieth embodiment when referring back to any of the sixteenth to nineteenth embodiments, the decoder is configured to determine a need to convert the shape of the update tensor, and/or an extent of a conversion of the shape of the update tensor, in dependence on an information about an extension of the update tensor.

According to a twenty-first embodiment when referring back to any of the first to twentieth embodiments, the decoder is configured to determine whether a parent node identifier 114, 524, 534, 544, 554, 564, 574, 584, 594, 604, 614, 624 is present; and the decoder is configured to derive one or more neural network parameters according to any of the preceding claims if the parent node identifier 114, 524, 534, 544, 554, 564, 574, 584, 594, 604, 614, 624 is present, and the decoder is configured to make the currently considered node the root node 510 if the parent node identifier is not present.

According to a twenty-second embodiment when referring back to any of the first to twenty-first embodiments, the decoder is configured to compare the parent node identifier 114, 524, 534, 544, 554, 564, 574, 584, 594, 604, 614, 624 with hash values associated with one or more nodes, to identify the parent node of the currently considered node.

According to a twenty-third embodiment when referring back to the twenty-second embodiment, the hash values are hash values of a full compressed data unit NDU associated with one or more previously decoded nodes.

According to a twenty-fourth embodiment when referring back to the twenty-second or twenty-third embodiment, the hash values are hash values of a payload portion of a compressed data unit NDU associated with one or more previously decoded nodes, while leaving a data size information and a header information unconsidered.

According to a twenty-fifth embodiment when referring back to any of the first to twenty-second to twenty-fourth embodiments, the parent node identifier 114, 524, 534, 544, 554, 564, 574, 584, 594, 604, 614, 624 is a combined value representing a device identifier and a serial number of which both are associated with the parent node.

According to a twenty-sixth embodiment when referring back to any of the first to twenty-fifth embodiments, the parent node identifier 114, 524, 534, 544, 554, 564, 574, 584, 594, 604, 614, 624 identifies an update tree 500 and/or a layer of the neural net.

According to a twenty-seventh embodiment when referring back to any of the first to twenty-sixth embodiments, the node information 112,112b comprises a node identifier.

According to a twenty-eighth embodiment when referring back to any of the first to twenty-seventh embodiments, the decoder is configured to store the node identifier.

According to a twenty-ninth embodiment when referring back to any of the first to twenty-eighth embodiments, the decoder is configured to compare one or more stored node identifiers with a parent node identifier 114, 524, 534, 544, 554, 564, 574, 584, 594, 604, 614, 624 in a node information 112, 112b of a new node when adding the new node, in order to identify a parent node of the new node.

According to a thirtieth embodiment when referring back to any of the first to twenty-ninth embodiments, the node identifier identifies an update tree 500 to which the node information is associated; and/or the node identifier identifies a layer of the neural net to which the node information relates.

According to a thirty-first embodiment when referring back to any of the first to thirtieth embodiments, the node identifier comprises a device identifier and/or a parameter update tree depth information and/or a parameter update tree identifier.

According to a thirty-second embodiment when referring back to any of the first to thirty-first embodiments, the node information 112, 112b comprises a signaling indicating whether a node identifier is present or not.

According to a thirty-third embodiment when referring back to any of the twenty-first to thirty-second embodiments, the decoder is configured to obtain a signaling 202, 302, 302b, comprising an information about the type of the parent node identifier 114, 524, 534, 544, 554, 564, 574, 584, 594, 604, 614, 624, and wherein the decoder is configured to evaluate the signaling in order to consider the respective type of the parent node identifier.

According to a thirty-fourth embodiment when referring back to any of the first to thirty-third embodiments, the decoder is configured to selectively evaluate a syntax element which indicates a type of the parent node identifier, in dependence on a syntax element indicating the presence of the parent node identifier 114, 524, 534, 544, 554, 564, 574, 584, 594, 604, 614, 624.

According to a thirty-fifth embodiment when referring back to any of the first to thirty-fourth embodiments, the decoder is configured, to obtain a topology change signaling within the node information, comprising an information about a topology change of the neural network, and the decoder is configured to modify the parameter information of the parent node according to the topology change in order to derive one or more neural network parameters of the neural network with modified topology.

According to a thirty-sixth embodiment when referring back to any of the first to thirty-fifth embodiments, the decoder is configured to change a shape of one or two tensors in response to a topology change information.

According to a thirty-seventh embodiment when referring back to the thirty-sixth embodiment, the decoder is configured to change a number of neurons of the given layer in response to the topology change information.

According to a thirty-eighth embodiment when referring back to the thirty-sixth or thirty-seventh embodiment, the decoder is configured to replace one or more tensor values of one or more tensors, a shape of which is to be changed, associated with a parent node of the currently considered node with one or more replacement values, in order to obtain one or more tensors having a modified size, or the decoder is configured to replace one or more tensors, a shape of which is to be changed, associated with a parent node of the currently considered node with one or more replacement tensors, in order to obtain one or more tensors having a modified size.

According to a thirty-ninth embodiment when referring back to any of the thirty-sixth to thirty-eighth embodiments, the decoder is configured to change shapes of two tensors in two update trees associated with neighboring layers of the neural net in a synchronized manner, in response to the topology change signaling.

A fortieth embodiment relates to an encoder 200, 300, 300b, 400 for encoding parameters of a neural network in order to obtain an encoded bitstream, wherein the encoder is configured to provide a node information 212, 312, 312b, 412 describing a node of a parameter update tree 500, wherein the node information comprises a parent node identifier 214, 314, 524, 534, 544, 554, 564, 574, 584, 594, 604, 614, 624, and wherein the node information comprises a parameter update information 216, 316, 416, 526, 536, 546, 556, 566, 576, 586, 596, 606, 616, 626; wherein the parameter update information describes differences between neural network parameters associated with a parent node defined by the parent node identifier and current neural network parameters.

According to a forty-first embodiment when referring back to the fortieth embodiment, the encoder is configured determine differences between one more neural network parameters defined by the parent node, which is identified by the parent node identifier 214, 314, 524, 534, 544, 554, 564, 574, 584, 594, 604, 614, 624, and one or more current neural network parameters, in order to obtain the parameter update information 216, 316, 416, 526, 536, 546, 556, 566, 576, 586, 596, 606, 616, 626.

According to a forty-second embodiment when referring back to the fortieth or forty-first embodiment, the encoder is configured to set up a parameter update tree 500, wherein a plurality of child nodes comprising different parameter update information 216, 316, 416, 526, 536, 546, 556, 566, 576, 586, 596, 606, 616, 626 are associated with a common parent node 510.

According to a forty-third embodiment when referring back to any of the fortieth to forty-second embodiments, the encoder is configured to provide the node information 212, 312, 312b, 412 such that it is possible to obtain one or more neural network parameters associated with a currently considered node using the parameter update information 216, 316, 416, 526, 536, 546, 556, 566, 576, 586, 596, 606, 616, 626 associated with the currently considered node, using a parameter information associated with a root node 510 and using parameter update information associated with one or more intermediate nodes which are between the root node and the currently considered node in the update tree.

According to a forty-fourth embodiment when referring back to any of the fortieth to forty-third embodiments, the encoder is configured to provide a plurality of node information blocks 418, wherein a parent node identifier 524, 534, 544, 554, 564, 574, 584, 594, 604, 614, 624 of a first node information block refers to a root node and wherein a parameter update information 526, 536, 546, 556, 566, 576, 586, 596, 606, 616, 626 of the first node describes differences between neural network parameters 512 associated with the root node 510 defined by the parent node identifier of the first node information block, and neural network parameters of the first node, and wherein a parent node identifier of a N-th node information block refers to a N-1-th node and wherein a parameter update information of the N-th node describes differences between neural network parameters associated with the N-1-th node defined by the parent node identifier of the N-th node information block, and neural network parameters of the N-th node.

According to a forty-fifth embodiment when referring back to any of the fortieth to forty-fourth embodiments, the encoder is configured to provide a signaling 202, 302, 302b to a decoder, to selectively choose neural network parameters 512 associated with a root node 510 or neural network parameters associated with one of the descendent nodes of the root node.

According to a forty-sixth embodiment when referring back to any of the fortieth to forty-fifth embodiments, the parameter update information 216, 316, 416, 526, 536, 546, 556, 566, 576, 586, 596, 606, 616, 626 comprises an update instruction 576 defining a scaling of one or more parameter values 532 associated with a parent node 530 of a currently considered node 570; and the encoder is configured to determine the scaling on the basis of one or more parameter values 532 associated with a parent node of the currently considered node and parameter values 572 of a currently considered node.

According to a forty-seventh embodiment when referring back to any of the fortieth to forty-sixth embodiments, a plurality of neural network parameters associated with a currently considered node are represented by a parameter tensor, and the encoder is configured to provide a product tensor 596 for application to a parameter tensor 542, in order to obtain a parameter tensor 592 associated with the currently considered node.

According to a forty-eighth embodiment when referring back to any of the fortieth to forty-seventh embodiments, a plurality of neural network parameters associated with a parent node are represented by a parameter tensor, and the parameter update information 216, 316, 416, 526, 536, 546, 556, 566, 576, 586, 596, 606, 616, 626 comprises a product tensor, wherein the encoder is configured to provide the product tensor in such a manner, that an application of the product tensor to the parameter tensor of the parent node, results in a parameter tensor associated with the currently considered node.

According to a forty-ninth embodiment when referring back to any of the fortieth to forty-eighth embodiments, the parameter update information 216, 316, 416, 526, 536, 546, 556, 566, 576, 586, 596, 606, 616, 626 comprises an update instruction 526, 536, 546, 556, 566, 586 defining an addition of one or more change values to one or more parameter values associated with a parent node of a currently considered node and/or a subtraction of one or more change values from one or more parameter values associated with a parent node of a currently considered node.

According to a fiftieth embodiment when referring back to any of the fortieth to forty-ninth embodiments, the parameter update information 216, 316, 416, 526, 536, 546, 556, 566, 576, 586, 596, 606, 616, 626 comprises an update instruction defining a weighted combination 606 of one or more parameter values 582 associated with a parent node 580 of the currently considered node 602 with one or more change values.

According to a fifty-first embodiment when referring back to any of the fortieth to fiftieth embodiments, a plurality of neural network parameters associated with a parent node of the currently considered node are represented by a parameter tensor; and a plurality of neural network parameters associated with a currently considered node are represented by a parameter tensor; and a plurality of change values are represented by a sum tensor.

According to a fifty-second embodiment when referring back to any of the fortieth to fifty-first embodiments, the parameter update information 216, 316, 416, 526, 536, 546, 556, 566, 576, 586, 596, 606, 616, 626 comprises an update instruction 616 defining a replacement of one or more parameter values associated with a parent node 530 of the currently considered node 610 with one or more change values.

According to a fifty-third embodiment when referring back to any of the fortieth to fifty-second embodiments, a plurality of neural network parameters associated with a parent node of the currently considered node are represented by a parameter tensor; and the parameter update information 216, 316, 416, 526, 536, 546, 556, 566, 576, 586, 596, 606, 616, 626 comprises an update instruction in the form of an update tensor; and the encoder is configured to provide the update tensor 660 such that a shape of the update tensor is different from a shape of the parameter tensor of the parent node.

According to a fifty-fourth embodiment when referring back to the fifty-third embodiment, tensor elements of the parameter tensor arranged along a first direction 652 are associated with contributions of output signals of a plurality of neurons 632, 634, 636 of a previous layer 630 of the neural network to an input signal of a given neuron 642 of a currently considered layer of the neural network 640, and tensor elements of the parameter tensor arranged along a second direction 654 are associated with contributions of an output signal of a given neuron 634 of a previous layer 630 of the neural network to input signals of a plurality of neurons 642, 644, 646 of a currently considered layer 640 of the neural network, and the encoder is configured to provide the update tensor such that the extension of the update tensor in the first direction (e.g. a row direction) is smaller than a dimension of the parameter tensor in the first direction, and/or the encoder is configured to provide the update tensor such that the extension of the update tensor in the second direction (e.g. a column direction) is smaller than a dimension of the parameter tensor in the second direction.

According to a fifty-fifth embodiment when referring back to the fifty-third or fifty-fourth embodiment, the encoder is configured to provide the update tensor 660 such that a number of rows of the update tensor is smaller than a number of rows of the parameter tensor; and/or the encoder is configured to provide the update tensor such that a number of columns of the update tensor is smaller than a number of columns of the parameter tensor.

According to a fifty-sixth embodiment when referring back to any of the fifty-third to fifty-fifth embodiments, the encoder is configured to provide an information about an extension of the update tensor 660.

According to a fifty-seventh embodiment when referring back to any of the fortieth to fifty-sixth embodiments, the encoder is configured to provide a signaling 202, 302, 302b, comprising an information whether a parent node identifier 214, 314, 524, 534, 544, 554, 564, 574, 584, 594, 604, 614, 624 is present or not.

According to a fifty-eighth embodiment when referring back to any of the fortieth to fifty-seventh embodiments, the encoder is configured provide a hash value associated with a node as the parent node identifier 214, 314, 524, 534, 544, 554, 564, 574, 584, 594, 604, 614, 624, to identify the parent node of the currently considered node.

According to a fifty-ninth embodiment when referring back to the fifty-eighth embodiment, the hash value is a hash values of a full compressed data unit associated with one or more previously encoded nodes.

According to a sixtieth embodiment when referring back to the fifty-eighth or fifty-ninth embodiment, the hash value is a hash value of a payload portion of a compressed data unit associated with one or more previously encoded nodes, while leaving a data size information and a header information unconsidered.

According to a sixty-first embodiment when referring back to any of the fifty-eighth to sixtieth embodiments, the parent node identifier 214, 314, 524, 534, 544, 554, 564, 574, 584, 594, 604, 614, 624 is a combined value representing a device identifier and a serial number of which both are associated with the parent node.

According to a sixty-second embodiment when referring back to any of the fortieth to sixty-first embodiments, parent node identifier 214, 314, 524, 534, 544, 554, 564, 574, 584, 594, 604, 614, 624 identifies an update tree 500 and/or a layer of the neural net.

According to a sixty-third embodiment when referring back to any of the fortieth to sixty-second embodiments, the node information 212, 312, 312b, 412 comprises a node identifier.

According to a sixty-fourth embodiment when referring back to any of the fortieth to sixty-third embodiments, the encoder is configured to store the node identifier.

According to a sixty-fifth embodiment when referring back to any of the fortieth to sixty-fourth embodiments, the encoder is configured to compare one or more stored node identifiers with a parent node identifier 214, 314, 524, 534, 544, 554, 564, 574, 584, 594, 604, 614, 624 in a node information 212, 312, 312b, 412 of a new node when adding the new node, in order to identify a parent node of the new node.

According to a sixty-sixth embodiment when referring back to any of the fortieth to sixty-fifth embodiments, node identifier identifies an update tree 500 to which the node information 212, 312, 312b, 412 is associated; and/or the node identifier identifies a layer of the neural net to which the node information relates.

According to a sixty-seventh embodiment when referring back to any of the fortieth to sixty-sixth embodiments, the node identifier comprises a device identifier and/or a parameter update tree depth information and/or a parameter update tree identifier.

According to a sixty-eighth embodiment when referring back to any of the fortieth to sixty-seventh embodiments, the node information 212, 312, 312b, 412 comprises a signaling indicating whether a node identifier is present or not.

According to a sixty-ninth embodiment when referring back to any of the fortieth to sixty-seventh embodiments, the parent node identifier 214, 314, 524, 534, 544, 554, 564, 574, 584, 594, 604, 614, 624 is a combined value representing a device identifier and a serial number which both are associated with the parent node.

According to a seventieth embodiment when referring back to any of the fortieth to sixty-first embodiments, the encoder is configured to provide a signaling 202, 302, 302b, comprising an information about the type of the parent node identifier 214, 314, 524, 534, 544, 554, 564, 574, 584, 594, 604, 614, 624.

According to a seventy-first embodiment when referring back to any of the fortieth to seventieth embodiments, the encoder is configured to selectively provide a syntax element which indicates a type of the parent node identifier 214, 314, 524, 534, 544, 554, 564, 574, 584, 594, 604, 614, 624, if a syntax element describing the parent node identifier is present.

According to a seventy-second embodiment when referring back to any of the fortieth to seventieth embodiments, the encoder is configured, to provide a topology change signaling within the node information 212, 312, 312b, 412, comprising an information about a topology change of the neural network.

According to a seventy-third embodiment when referring back to any of the fortieth to seventy-second embodiments, the encoder is configured to signal a change a shape of one or two tensors, together with a signaling of a topology change.

According to a seventy-fourth embodiment when referring back to the seventy-third embodiments, the encoder is configured to signal a change of a number of neurons of the given layer using the topology change information.

According to a seventy-fifth embodiment when referring back to the seventy-third or seventy-fourth embodiment, the encoder is configured to signal a replacement of one or more tensor values of one or more tensors, a shape of which is to be changed, associated with a parent node of the currently considered node with one or more replacement values, or the encoder is configured to signal a replacement of one or more tensors, a shape of which is to be changed, associated with a parent node of the currently considered node with one or more replacement tensors.

According to a seventy-sixth embodiment when referring back to any of the seventy-third to seventy-fifth embodiments, the encoder is configured to signal a change of shapes of two tensors in two update trees associated with neighboring layers of the neural net in a synchronized manner, using the topology change signaling.

A seventy-seventh embodiment relates to a neural network controller 800, wherein the neural network controller is configured to train a neural network, to obtain updated neural network parameters 812 on the basis of initial neural network parameters, and wherein the neural network controller is configured to determine a parameter update information 832 on the basis of reference neural network parameters 822 and the updated neural network parameters, wherein the parameter update information comprises one or more update instructions describing how to derive the updated neural network parameters, at least approximately, from the initial neural network parameters, and wherein the neural network controller is configured to provide a node information 112, 112b, 212, 312, 312b, 412, 802 comprising a parent node identifier and the parameter update information, wherein the parent node identifier defines a parent note, parameter information of which serves as a starting point for the application of the parameter update information.

According to a seventy-eighth embodiment when referring back to the seventy-seventh embodiment, the neural network controller comprises an encoder 200, 300, 300b, 400 according to any of the fortieth to seventy-sixth embodiments; or wherein the neural network controller comprises any functionality, or combination of functionalities, of the encoder according to any of the fortieth to seventy-sixth embodiments.

A seventy-ninth embodiment relates to a neural network federated learning controller 900, wherein the neural network federated learning controller is configured to receive node information 112, 112b, 212, 312, 312b, 412, 802, 902 of a plurality of neural networks, wherein the node information comprises a parent node identifier, and wherein the node information comprises a parameter update information; and wherein the neural network federated learning controller is configured to combine parameter update information of several corresponding nodes of different neural networks, to obtain a combined parameter update information 912, and wherein the neural network federated learning controller is configured to distribute the combined parameter update information.

According to an eightieth embodiment when referring back to the seventy-ninth embodiment, the neural network federated learning controller is configured to combine parameter update information of several corresponding nodes having equal parent node identifiers of different neural networks, to obtain a combined parameter update information.

According to an eighty-first embodiment when referring back to the seventy-ninth or eightieth embodiment, the neural network federated learning controller is configured to distribute parameter information of a parent node, to which the parent node identifier is associated, to a plurality of decoders; and wherein the neural network federated learning controller is configured to receive from the decoders node information comprising the parent node identifier, and wherein the neural network federated learning controller is configured to combine parameter update information of several corresponding nodes having the parent node identifier.

According to an eighty-second embodiment when referring back to the eighty-first embodiment, the neural network federated learning controller is configured to provide a node information describing a combined node information of a parameter update tree, the combined node information comprises the parent node identifier, and the combined node information comprises the combined parameter update information.

According to an eighty-third embodiment when referring back to any of the seventy-ninth to eighty-second embodiments, the neural network federated learning controller comprises an encoder 200, 300, 300b, 400 according to any of the fortieth to seventy-second embodiments; or wherein the neural network federated learning controller comprises any functionality, or combination of functionalities, of the encoder according to any of the fortieth to seventy-second embodiments.

An eighty-fourth embodiment relates to a method 1000 for decoding parameters of a neural network, the method comprising obtaining 1010 a plurality of neural network parameters of the neural network on the basis of an encoded bitstream; obtaining 1020 a node information describing a node of a parameter update tree, wherein the node information comprises a parent node identifier, and wherein the node information comprises a parameter update information; and deriving 1030 one or more neural network parameters using parameter information of a parent node identified by the parent node identifier and using the parameter update information.

An eighty-fifth embodiment relates to a method 1100 for encoding parameters of a neural network in order to obtain an encoded bitstream, the method comprising providing 1110 a node information describing a node of a parameter update tree, wherein the node information comprises a parent node identifier, and wherein the node information comprises a parameter update information; wherein the parameter update information describes differences between neural network parameters associated with a parent node defined by the parent node identifier and current neural network parameters.

An eighty-sixth embodiment relates to a method 1200 for controlling a neural network, the method comprising training 1210 a neural network, to obtain updated neural network parameters on the basis of initial neural network parameters, and determining 1220 a parameter update information on the basis of reference neural network parameters and the updated neural network parameters, wherein the parameter update information comprises one or more update instructions describing how to derive the updated neural network parameters, at least approximately, from the initial neural network parameters, and providing 1230 a node information comprising a parent node identifier and the parameter update information, wherein the parent node identifier defines a parent note, parameter information of which serves as a starting point for the application of the parameter update information.

An eighty-seventh embodiment relates to a method 1300 for controlling neural network federated learning, the method comprising receiving 1310 node information of a plurality of neural networks, wherein the node information comprises a parent node identifier, and wherein the node information comprises a parameter update information; and combining 1320 parameter update information of several corresponding nodes of different neural networks, to obtain a combined parameter update information, and distributing 1330 the combined parameter update information.

An eighty-eighth embodiment relates to a computer program for performing the method according to any of the eighty-fourth to eighty-seventh embodiments, when the computer program runs on a computer.

An eighty-ninth embodiment relates to an encoded representation of neural network parameters, wherein the encoded representation comprises a node information describing a node of a parameter update tree, wherein the node information comprises a parent node identifier and a parameter update information.

### Implementation alternatives:

Although some aspects are described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitionary.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

## Claims

1. A decoder (100, 100b) for decoding parameters of a neural network,
wherein the decoder is configured to obtain a plurality of neural network parameters (104, 104b, 204, 304, 512, 522, 532, 542, 552, 562, 572, 582, 592, 602 ,612, 622, 652, 720, 740, 812) of the neural network on the basis of an encoded bitstream;
wherein the decoder is configured to obtain a node information (112, 112b) describing a currently considered node of a parameter update tree, the parameter update tree comprising nodes that are in a hierarchical order, wherein neural network parameters associated with a node of the parameter update tree are associated with a specific version of the neural network,
wherein the node information comprises a parent node identifier (114, 524, 534, 544, 554, 564, 574, 584, 594, 604, 614, 624), and
wherein the node information comprises a parameter update information (116, 526, 536, 546, 556, 566, 576, 586, 596, 606, 616, 626);
wherein the decoder is configured to select a node of the parameter update tree as a selected parent node, using the parent node identifier;
wherein the decoder is configured to derive one or more updated neural network parameters (104, 104b, 204, 304, 512, 522, 532, 542, 552, 562, 572, 582, 592, 602 ,612, 622, 652, 720, 740, 812)
using neural network parameters of the selected parent node, identified by, and selected using, the parent node identifier and
using the parameter update information,
in order to determine an updated version of the neural network represented by the selected parent node;
wherein the decoder is configured to compare the parent node identifier (114, 524, 534, 544, 554, 564, 574, 584, 594, 604, 614, 624) with hash values associated with one or more nodes, to identify the parent node of the currently considered node.

2. The decoder according to claim 1,
wherein a parent node comprises an own parent node identifier and an own parameter update information.

3. Decoder (100, 100b) according to any of claims 1 to 2,
wherein the node information (112,112b) comprises a node identifier;
wherein the node identifier comprises a device identifier and/or a parameter update tree depth information and/or a parameter update tree identifier;
wherein the node information (112, 112b) comprises a signaling indicating whether a node identifier is present or not.

4. Decoder (100, 100b) according to claim 3, wherein the parameter update information (116, 526, 536, 546, 556, 566, 576, 586, 596, 606, 616, 626) comprises an update instruction (526, 536, 546, 556, 566, 586) defining an addition of one or more change values to one or more parameter values associated with the parent node of the currently considered node and/or a subtraction of one or more change values from one or more parameter values associated with the parent node of the currently considered node; and
wherein the decoder is configured to apply an addition or subtraction of the change values defined by the update instruction, in order to obtain one or more neural network parameters (522, 532, 542, 552, 562, 582) associated with the currently considered node;
wherein the parent node identifier (114, 524, 534, 544, 554, 564, 574, 584, 594, 604, 614, 624) is a combined value representing a device identifier and a serial number of which both are associated with the parent node;
wherein the decoder is configured to obtain a signaling (202, 302, 302b), comprising an information about the type of the parent node identifier (114, 524, 534, 544, 554, 564, 574, 584, 594, 604, 614, 624), and wherein the decoder is configured to evaluate the signaling in order to consider the respective type of the parent node identifier;
wherein the decoder is configured to selectively evaluate a syntax element which indicates a type of the parent node identifier, in dependence on a syntax element indicating the presence of the parent node identifier (114, 524, 534, 544, 554, 564, 574, 584, 594, 604, 614, 624).

5. An encoder (200, 300, 300b, 400) for encoding parameters of a neural network in order to obtain an encoded bitstream,
wherein the encoder is configured to provide a node information (212, 312, 312b, 412) describing a currently considered node of a parameter update tree (500), the parameter update tree comprising nodes that are in a hierarchical order, wherein neural network parameters associated with a node of the parameter update tree are associated with a specific version of the neural network,
wherein the node information comprises a parent node identifier (214, 314, 524, 534, 544, 554, 564, 574, 584, 594, 604, 614, 624) and
wherein the node information comprises a parameter update information (216, 316, 416, 526, 536, 546, 556, 566, 576, 586, 596, 606, 616, 626);
wherein the parameter update information describes differences between neural network parameters associated with a parent node defined by the parent node identifier and updated neural network parameters associated with the currently considered node, so that the node information represents an updated version of the neural network represented by the parent node;
wherein the encoder is configured provide a hash value associated with a node as the parent node identifier (214, 314, 524, 534, 544, 554, 564, 574, 584, 594, 604, 614, 624), to identify the parent node of the currently considered node.

6. Encoder according to claim 5,
wherein a parent node comprises an own parent node identifier and an own parameter update information.

7. Encoder (200, 300, 300b, 400) according to any of claims 5 to 6,
wherein the node information (212, 312, 312b, 412) comprises a node identifier;
wherein the node identifier comprises a device identifier and/or a parameter update tree depth information and/or a parameter update tree identifier;
wherein the node information (212, 312, 312b, 412) comprises a signaling indicating whether a node identifier is present or not.

8. Encoder (200, 300, 300b, 400) according to claim 7,
wherein the parameter update information (216, 316, 416, 526, 536, 546, 556, 566, 576, 586, 596, 606, 616, 626) comprises an update instruction (526, 536, 546, 556, 566, 586) defining an addition of one or more change values to one or more parameter values associated with the parent node of the currently considered node and/or a subtraction of one or more change values from one or more parameter values associated with the parent node of the currently considered node.
wherein the parent node identifier (214, 314, 524, 534, 544, 554, 564, 574, 584, 594, 604, 614, 624) is a combined value representing a device identifier and a serial number of which both are associated with the parent node;
wherein the encoder is configured to provide a signaling (202, 302, 302b), comprising an information about the type of the parent node identifier (214, 314, 524, 534, 544, 554, 564, 574, 584, 594, 604, 614, 624);
wherein the encoder is configured to selectively provide a syntax element which indicates a type of the parent node identifier (214, 314, 524, 534, 544, 554, 564, 574, 584, 594, 604, 614, 624), if a syntax element describing the parent node identifier is present.

9. Method (1000) for decoding parameters of a neural network, the method comprising
obtaining (1010) a plurality of neural network parameters of the neural network on the basis of an encoded bitstream;
obtaining (1020) a node information describing a currently considered node of a parameter update tree, the parameter update tree comprising nodes that are in a hierarchical order, wherein neural network parameters associated with a node of the parameter update tree are associated with a specific version of the neural network,
wherein the node information comprises a parent node identifier, and
wherein the node information comprises a parameter update information; and
selecting a specific node of the parameter update tree as a selected parent node, using the parent node identifier;
deriving (1030) one or more updated neural network parameters
using neural network parameters of the selected parent node, identified by and selected using, the parent node identifier and
using the parameter update information
in order to determine an updated version of the neural network represented by the selected parent node;
wherein the method comprises comparing the parent node identifier (114, 524, 534, 544, 554, 564, 574, 584, 594, 604, 614, 624) with hash values associated with one or more nodes, to identify the parent node of the currently considered node.

10. Method according to claim 9,
wherein the node information (112,112b) comprises a node identifier;
wherein the node identifier comprises a device identifier and/or a parameter update tree depth information and/or a parameter update tree identifier;
wherein the node information (112, 112b) comprises a signaling indicating whether a node identifier is present or not.

11. Method according to claim 10, wherein the parameter update information (116, 526, 536, 546, 556, 566, 576, 586, 596, 606, 616, 626) comprises an update instruction (526, 536, 546, 556, 566, 586) defining an addition of one or more change values to one or more parameter values associated with the parent node of the currently considered node and/or a subtraction of one or more change values from one or more parameter values associated with the parent node of the currently considered node; and
wherein the method comprises applying an addition or subtraction of the change values defined by the update instruction, in order to obtain one or more neural network parameters (522, 532, 542, 552, 562, 582) associated with the currently considered node;
wherein the parent node identifier (114, 524, 534, 544, 554, 564, 574, 584, 594, 604, 614, 624) is a combined value representing a device identifier and a serial number of which both are associated with the parent node;
wherein the method comprises obtaining a signaling (202, 302, 302b), comprising an information about the type of the parent node identifier (114, 524, 534, 544, 554, 564, 574, 584, 594, 604, 614, 624), and wherein the method comprises evaluating the signaling in order to consider the respective type of the parent node identifier;
wherein the method comprises selectively evaluating a syntax element which indicates a type of the parent node identifier, in dependence on a syntax element indicating the presence of the parent node identifier (114, 524, 534, 544, 554, 564, 574, 584, 594, 604, 614, 624).

12. Method (1100) for encoding parameters of a neural network in order to obtain an encoded bitstream, the method comprising
providing (1110) a node information describing a currently considered node of a parameter update tree, the parameter update tree comprising nodes that are in a hierarchical order, wherein neural network parameters associated with a node of the parameter update tree are associated with a specific version of the neural network,
wherein the node information comprises a parent node identifier, and
wherein the node information comprises a parameter update information;
wherein the parameter update information describes differences between neural network parameters associated with a parent node defined by the parent node identifier and updated neural network parameters associated with the currently considered node, so that the node information represents an updated version of the neural network represented by the parent node;
wherein the method comprises providing a hash value associated with a node as the parent node identifier (214, 314, 524, 534, 544, 554, 564, 574, 584, 594, 604, 614, 624), to identify the parent node of the currently considered node.

13. Method according to claim 12,
wherein the node information (212, 312, 312b, 412) comprises a node identifier;
wherein the node identifier comprises a device identifier and/or a parameter update tree depth information and/or a parameter update tree identifier;
wherein the node information (212, 312, 312b, 412) comprises a signaling indicating whether a node identifier is present or not.

14. Method according to claim 13,
wherein the parameter update information (216, 316, 416, 526, 536, 546, 556, 566, 576, 586, 596, 606, 616, 626) comprises an update instruction (526, 536, 546, 556, 566, 586) defining an addition of one or more change values to one or more parameter values associated with the parent node of the currently considered node and/or a subtraction of one or more change values from one or more parameter values associated with the parent node of the currently considered node.
wherein the parent node identifier (214, 314, 524, 534, 544, 554, 564, 574, 584, 594, 604, 614, 624) is a combined value representing a device identifier and a serial number of which both are associated with the parent node;
wherein the method comprises providing a signaling (202, 302, 302b), comprising an information about the type of the parent node identifier (214, 314, 524, 534, 544, 554, 564, 574, 584, 594, 604, 614, 624);
wherein the method comprises selectively providing a syntax element which indicates a type of the parent node identifier (214, 314, 524, 534, 544, 554, 564, 574, 584, 594, 604, 614, 624), if a syntax element describing the parent node identifier is present.

15. A computer program for performing the method according to one of claims 9 to 14, when the computer program runs on a computer.
